Europäisches Patentamt

European Patent Office

Office européen des brevets

(19)

(11) **EP 1 450 481 A1**

(12) **EUROPEAN PATENT APPLICATION**
published in accordance with Art. 158(3) EPC

(43) Date of publication:
**25.08.2004 Bulletin 2004/35**

(51) Int Cl.⁷: **H03D 9/00**, H03D 5/00,
H04B 1/30

(21) Application number: **01274895.0**

(22) Date of filing: **30.11.2001**

(86) International application number:
**PCT/JP2001/010471**

(87) International publication number:
**WO 2003/049276 (12.06.2003 Gazette 2003/24)**

(84) Designated Contracting States:
**AT BE CH CY DE DK ES FI FR GB GR IE IT LI LU
MC NL PT SE TR**
Designated Extension States:
**AL LT LV MK RO SI**

(71) Applicants:
• **Sony Corporation
Tokyo 141-0001 (JP)**
• **Sony International (Europe) GmbH
10785 Berlin (DE)**

(72) Inventors:
• **ABE, Masayoshi, c/o SONY CORPORATION
Tokyo 141-0001 (JP)**

• **SASHO, Noboru, c/o SONY CORPORATION
Tokyo 141-0001 (JP)**
• **KRUPEZEVIC, Dragan,
c/o SONY INT. (EUROPE) GMBH
10785 Berlin (DE)**
• **BRANKOVIC, Veselin,
c/o SONY INT. (EUROPE) GMBH
10785 Berlin (DE)**
• **RATNI, Mohamed,
c/o SONY INT. (EUROPE) GMBH
10785 Berlin (DE)**

(74) Representative: **Thévenet, Jean-Bruno et al
Cabinet Beau de Loménie
158, rue de l'Université
75340 Paris Cédex 07 (FR)**

(54) **DEMODULATOR AND RECEIVER USING IT**

(57)     A high performance demodulator able to realize a further wide band property, low distortion characteristics, and low power consumption in comparison with a conventional multi-port demodulator and having a small fluctuation in characteristics with respect to temperature fluctuations and aging and comprising a five-port junction circuit 101 receiving a received signal Sr and a local signal Slo generated at a local signal generation circuit 102, generating three signals having a phase difference, detecting signal levels (amplitude components) of these signals to obtain three power detection signals (baseband signals) P1, P2, and P3; a first multiplier 103 for multiplying the power detection signal P1 output from a first power detector of the five-port junction circuit 101 by a coefficient A1 (= $(k_{21}/k_{11})^2$) for canceling square components of an interference signal and a local signal; a second multiplier 104 for multiplying the power detection signal P1 output from the first power detector by a coefficient A2 (=$(k_{31}/k_{11})^2$) for canceling square components of an interference signal and a local signal; a first subtractor 105 for subtracting a multiplication result of the first multiplier 103 from the power detection signal P2 output from a second power detector of the five-port junction circuit 101; a second subtractor 106 for subtracting the multiplication result of the second multiplier 104 from the power detection signal P3 output from a third power detector of the five-port junction circuit 101; and a multi-port signal-to-IQ signal conversion circuit 109 for converting the result to an In-phase signal I and a quadrature signal Q as demodulated signals based on the output signals of the first subtractor 105 and the second subtractor 106.

FIG.3

EP 1 450 481 A1

**Description**

TECHNICAL FIELD

The present invention relates to a demodulator of the direct conversion system used in for example a communication apparatus for transmitting and receiving high frequency signals and effective also for impedance measurement at a high frequency band such as the GHz band and to a receiver using the same.

BACKGROUND ART

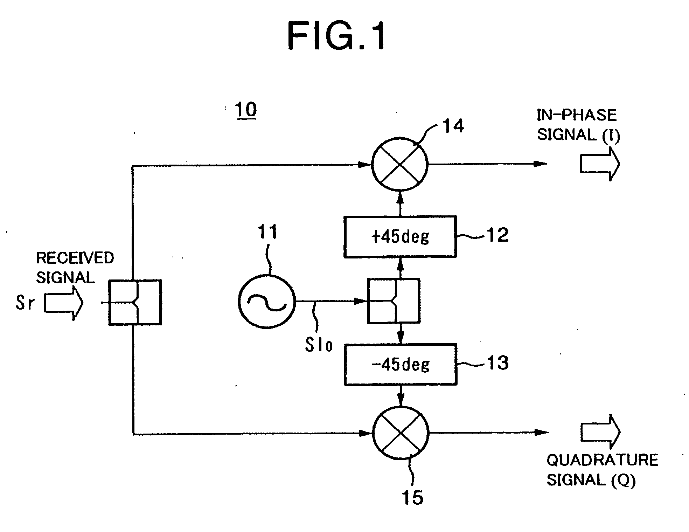

FIG. 1 is a circuit diagram of the configuration of principal parts of a general demodulator.

As shown in FIG. 1, this demodulator 10 has a local signal generation circuit 11, a +45 degree phase shifter 12, a -45 degree phase shifter 13, and RF mixers 14 and 15 as main components.

In this demodulator 10, a local signal Slo having a predetermined frequency generated by the local signal generation circuit 11 is shifted in phase by 45 degrees by the +45-degree phase shifter 12 and supplied to the RF mixer 14 or shifted in phase by -45 degrees by the -45 degree phase shifter 13 and supplied to the RF mixer 15.

Then, a signal Sr received via for example a not illustrated antenna element or a low noise amplifier is supplied to the RF mixers 14 and 15, the received signal Sr and the local signal shifted in phase by exactly +45 degrees are multiplied at the RF mixer 14 to obtain an In-phase signal (I), and the received signal Sr and the local signal shifted in phase by exactly -45 degrees are multiplied at the RF mixer 15 to obtain a quadrature signal (Q).

In the demodulator 10 using mixers as shown in FIG. 1, however, it is difficult to broaden the band, so a high local level must be supplied to the mixer. Further, the mixers are in a nonlinear operating state due to the high local power, so there is the disadvantage that demodulation with a low distortion is difficult.

Therefore, in recent years, a demodulator of an n-port system (n being an integer of 3 or more) based on a principle different from FIG. 1 using a power detection circuit (power detector) is proposed.

In this multi-port system demodulator, the power detector easily broadens the band in comparison with the mixer used in the above demodulation system. Due to this, a multi-port demodulator can be tell to have a good compatability with a software wireless system in which a multi-band or a wide band characteristic is demanded. Further, recent wireless communication tends to use a higher frequency as the carrier frequency and can even meet the demand for higher frequency.

Further, in a demodulation system using mixers, a high local level must be applied to the mixer. Contrary to this, in the multi-port system, the power detector operates in a linear region. Accordingly, with the multi-port system, demodulation is possible even with a low local signal power.

Further, in a demodulation system using mixers, the mixers are in a nonlinear operating state due to the high local power. Contrary to this, in the multi-port system, the power detector operates in the linear region. Accordingly, with a multi-port system, demodulation with a low distortion is possible.

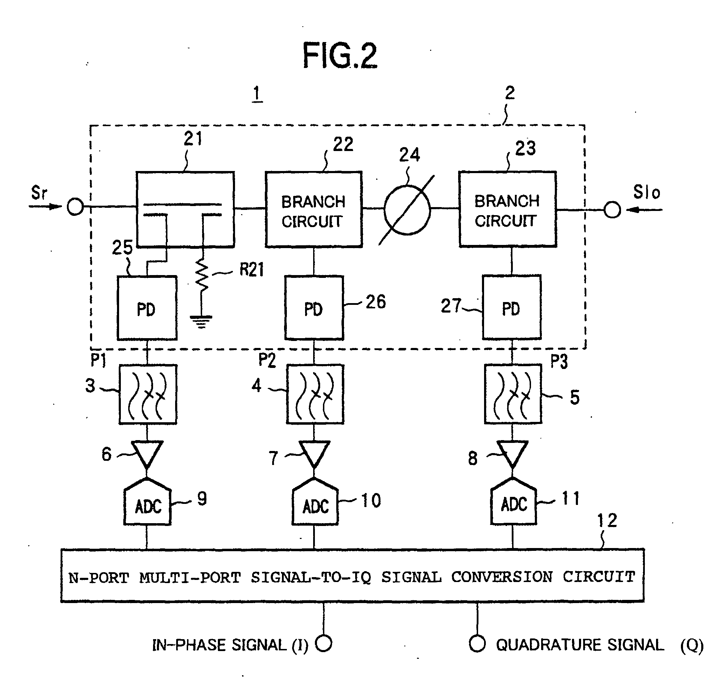

FIG. 2 is a block diagram of an example of the configuration of an n-port demodulator (see for example WO99/33166 (PCT/EP98/08329)). Here, for simplification, an explanation will be given based on an ideal five-(n=5) port model shown in FIG. 2.

This five-port demodulator 1 has, as shown in FIG. 2, a five-port junction circuit 2, low-pass filters 3 to 5, amplifiers 6 to 8, analog/digital converters (ADCs) 9 to 11, and a multi (n) port signal-to-IQ signal conversion circuit 12.

The five-port junction circuit 2 has a coupler 21, branch circuits 22 and 23, a phase shifter 24, power detectors 25 to 27, and a resistance element R21.

In this five-port demodulator 1, a received signal Sr is input to the branch circuit 22 by the coupler 21. One part thereof is input to the power detector 25. The received signal input to the branch circuit 22 is branched to two signals. One branched signal is input to the power detector 26, and the other signal is input to the phase shifter 24. The phase shifter 24 gives a phase shift θ to the received signal from the branch circuit 22, then inputs the signal receiving the phase shift action to the branch circuit 23 where it is branched into two signals. The branch circuit 23 inputs one branched signal to the power detector 27.

Further, a local signal Slo is input to the branch circuit 23. The local signal input to the branch circuit 23 is branched into two signals. One branched signal is input to the power detector 27, while the other signal is input to the phase shifter 24. The phase shifter 24 gives a phase shift θ to the local signal from the branch circuit 23, then inputs the signal receiving the phase shift action to the branch circuit 22 where it is branched into two signals. The branch circuit 22 inputs one branched signal to the power detector 26 and supplies the other signal to the coupler 21.

The power detector 25 is supplied with the received signal. The power detector 25 detects an amplitude component of the supplied signal and outputs it as a signal P1 to the low-pass filter 3. The low-pass filter 3 removes for example a high frequency component, the amplifier 6 amplifies the result, then the ADC 9 converts the result from an analog signal to a digital signal and supplies the result to the conversion circuit 12.

The power detector 26 is supplied with the received signal and the local signal given the phase shift θ. The power detector 26 detects the amplitude component of the supplied signal and outputs it as a signal P2 to the low-pass filter 4. The low-pass filter 4 removes for example a high frequency component, the amplifier 7 amplifies the result, then the ADC 10 converts the result from an analog signal to a digital signal and supplies the result to the conversion circuit 12.

Further, the power detector 27 is supplied with the local signal and the received signal given the phase shift θ. The power detector 27 detects the amplitude component of the supplied signal and outputs it as a signal P3 to the low-pass filter 5. The low-pass filter 5 removes for example a high frequency component, the amplifier 8 amplifies the result, then the ADC 11 converts the result from an analog signal to a digital signal and supplies the result to the conversion circuit 12.

Then, the conversion circuit 12 performs the calculation indicated by the following equations based on the input digital signals P1, P2, and P3, converts the input signal to an In-phase signal (I) and a quadrature signal (Q) as demodulated signals and outputs the same.

$$I(t) = -\frac{\kappa_{21}\kappa_{32} + \kappa_{22}\kappa_{31}}{4\kappa_{21}\kappa_{31}\cos\theta} - \frac{\kappa_{21}\kappa_{32} + \kappa_{22}\kappa_{21}}{4\kappa_{11}^2\kappa_{22}\kappa_{32}\cos\theta}\frac{P_1}{R_0 P_{lo}}$$

$$+\frac{1}{4\kappa_{21}\kappa_{22}\cos\theta}\frac{P_2}{R_0 P_{lo}} + \frac{1}{4\kappa_{31}\kappa_{32}\cos\theta}\frac{P_3}{R_0 P_{lo}} \tag{1}$$

$$Q(t) = -\frac{\kappa_{21}\kappa_{32} + \kappa_{22}\kappa_{31}}{4\kappa_{21}\kappa_{31}\sin\theta} + \frac{\kappa_{21}\kappa_{32} + \kappa_{22}\kappa_{21}}{4\kappa_{11}^2\kappa_{22}\kappa_{32}\sin\theta}\frac{P_1}{R_0 P_{lo}}$$

$$-\frac{1}{4\kappa_{21}\kappa_{22}\sin\theta}\frac{P_2}{R_0 P_{lo}} + \frac{1}{4\kappa_{31}\kappa_{32}\sin\theta}\frac{P_3}{R_0 P_{lo}} \tag{2}$$

Here, $k_{ij}$ indicates a voltage transfer coefficient (i is an output terminal number, and j is a received signal input port when 1 and is a local signal input port when 2), $P_{lo}$ indicates a local signal power, $R_0$ indicates an impedance of a local signal source, and θ indicates the phase of the phase shifter.

The low-pass filters 3 to 5 in the above five-port

The low-pass filters 3 to 5 in the above five-port demodulator 1 are provided for the following two objects.

The first object is to avoid aliasing at the following ADCs 9 to 11 and is for the case of a relatively high cut-off frequency (a cut-off frequency which is ½ of a sampling frequency or less and higher compared with the desired wave signal band).

The second object is a desired frequency channel signal and is for the case where channel filtering is carried out.

In the former case, in order to secure the reception performance when there is a strong interference signal in an adjacent channel of the desired received signal, the resolution of the ADCs must be made large. Increasing the resolution of the ADCs becomes disadvantageous in the point of increasing the speed of the ADCs or reducing the power consumption. As one means for alleviating this problem, the latter method may be mentioned. Namely, by removing the interference signal of the adjacent channel, the dynamic range of the ADCs can be reduced. However, the present method has room for improvement in the following point.

The output signals P1, P2, and P3 of the three power detectors are represented by the following equations: Here, an explanation will be given based on the ideal five-port model shown in FIG. 2. Assume that the power detectors have ideal square characteristics and that the circuit constants are all 1.

$$P_1 = LPF[|S_0 + X_u|^2] \tag{3}$$

$$P_2 = LPF[|S_0 + X_u + S_{LO+}|^2]$$

$$= LPF[|S_0 + X_u|^2 + |S_{LO+}|^2 + 2(S_0 + X_u)\cdot S_{LO+}] \tag{4}$$

$$P_3 = LPF[|S_0+X_u+S_{LO-}|^2]$$

$$= LPF[|S_0+X_u|^2+|S_{LO-}|^2+2(S_0+X_u)\cdot S_{LO-}] \tag{5}$$

Here, So indicates a received desired signal, $X_u$ indicates an interference signal, $S_{LO+}$ indicates a phase shifted local signal, and $S_{LO-}$ indicates a phase shifted local signal. Further, LPF[] means that only the low frequency component is extracted.

As will be understood from equation (4) or (5), the third term is a term including the demodulated signals. The first term indicates the power level of the received signal including the interference signal, and the second term indicates the power level of the local signal. Further, these signals include the components of the desired received signal band. These unnecessary signals cannot be removed by the channel filtering. This causes the following problems.

When the characteristics of the three power detectors do not completely match, the reception performance is deteriorated due to incompleteness of the circuit, for example, reflection of a local leakage signal.

Further, it becomes necessary to obtain a large dynamic range of the ADCs for these unnecessary signals. Further, the number of bits of the variables in the digital signal processor after the ADCs becomes large.

Further, the circuit of FIG. 2 requires three ADCs. This means there is room for improvement in the points of power consumption of the receiver, circuit size, and costs.

DISCLOSURE OF THE INVENTION

A first object of the present invention is to provide a demodulator achieving a low power consumption, a low distortion, a wide band characteristic, and an improvement of demodulation performance and a receiver using the same.

A second object of the present invention is to provide a demodulator not requiring a large dynamic range of the ADCs when performing conversion processing etc. in the digital signal processing and enabling the ADCs to operate in an optimum range and a receiver using the same.

A third object of the present invention is to provide a demodulator achieving simplification of the circuit and able to prevent an increase of the circuit size and a receiver using the same.

A demodulator according to a first aspect of the present invention comprises a multi-port junction circuit including a generating means receiving as input a received signal and a local signal and based on at least one signal, generating at least two signals having a phase difference and a plurality of power detectors for detecting signal levels of signals generated by the generating means; at least one multiplier for multiplying an output signal of one power detector among the plurality of power detectors by a coefficient for canceling an unnecessary component included in the output signal of other power detector; at least one subtractor for subtracting the output signal of the one power detector multiplied by a coefficient at the multiplier from the output signal of the other power detector; and a conversion circuit for converting the result to a plurality of signal components included in the received signal based on the output signal of the subtractor.

In the first aspect of the present invention, preferably the demodulator has a removing means for removing a DC offset from the output of the subtractor.

Preferably, the removing means includes an offset removal subtractor connected to the latter stage of the subtractor and a circuit for measuring a DC offset amount from the output of the offset removal subtractor and feeding back a signal for canceling the DC offset amount to the offset removal subtractor.

Further, preferably, the removing means includes an offset removal subtractor connected to the latter stage of the subtractor and a circuit for taking an average of outputs of the offset removal subtractor and feeding back the average result as a signal for canceling the DC offset amount to the offset removal subtractor.

Further, in the first aspect of the present invention, the demodulator has a channel selecting means for selecting a desired channel from the output signal of the subtractor and inputting the same to the conversion circuit, and the conversion circuit demodulates an In-phase component signal I and a quadrature component signal Q based on the output signal of the channel selecting means and predetermined circuit constants.

Further, in the first aspect of the present invention, the demodulator has a channel selecting means for selecting a desired channel from the output signal of the offset removal subtractor and inputting the same to the conversion circuit, and the conversion circuit demodulates an In-phase component signal I and a quadrature component signal Q based on the output signal of the channel selecting means and predetermined circuit constants.

Preferably, the channel selecting means includes a low-pass filter.

A demodulator according to a second aspect of the present invention comprises a multi-port junction circuit including a generating means receiving as input a received signal and a local signal and based on at least one signal, generating at least two signals having a phase difference, and a plurality of power detectors for detecting signal levels of signals generated by the generating means; at least one multiplier for multiplying an output signal of one power detector among the plurality of power detectors by a coefficient for canceling an unnecessary component included in the output signal of other power detector; at least one subtractor for subtracting the output signal of the one power detector multiplied by a coefficient at the multiplier from the output signal of the other power detector; at least one variable gain amplifier for adjusting the level of the output signal of the subtractor with a gain in accordance with a control signal; an analog/digital converter for converting the output signal of the variable gain amplifier from an analog signal to a digital signal; and a conversion circuit for converting the result to a plurality of signal components included in the received signal based on the digital signal from the analog/digital converter, then outputting the control signal to the variable gain amplifier so as to adjust the level of the output signal of the subtractor to a level suitable for a dynamic range of the analog/digital converter.

In the second aspect of the present invention, preferably, preferably the demodulator has a removing means for removing a DC offset from the output of the subtractor.

Preferably, the removing means includes an offset removal subtractor connected to the latter stage of the subtractor and a circuit for measuring a DC offset amount from the output of the offset removal subtractor and feeding back a signal for canceling the DC offset amount to the offset removal subtractor.

Further, preferably, the removing means includes an offset removal subtractor connected to the latter stage of the subtractor and a circuit for taking an average of outputs of the offset removal subtractor and feeding back the average result as a signal for canceling the DC offset amount to the offset removal subtractor.

Preferably, the demodulator has a channel selecting means for selecting a desired channel from the output signal of the subtractor and inputting the same to the variable gain amplifier, and the conversion circuit demodulates an In-phase component signal I and a quadrature component signal Q based on the digital signal from the analog/digital converter and predetermined circuit constants.

Further, preferably, the demodulator has a channel selecting means for selecting a desired channel from the output signal of the offset removal subtractor and inputting the same to the variable gain amplifier, and the conversion circuit demodulates an In-phase component signal I and a quadrature component signal Q based on the digital signal from the analog/digital converter and predetermined circuit constants.

Further, preferably, the channel selecting means includes a low-pass filter.

Further, in the second aspect of the present invention, the conversion circuit outputs a control signal to the variable gain amplifier and calibrates the gain of the variable gain amplifier so that the digital signal from the analog/digital converter becomes a desired level at the time of no reception of a signal.

A demodulator according to a third aspect of the present invention comprises a multi-port junction circuit including a generating means receiving as input a received signal and a local signal and generating at least one signal and a plurality of power detectors for detecting signal levels of signals generated by the generating means; a plurality of variable gain amplifiers for adjusting levels of the output signals of the plurality of power detectors with a gain in accordance with a control signal; a plurality of analog/digital converters for converting the output signals of the plurality of variable gain amplifiers from analog signals to digital signals; at least one multiplier for multiplying the output signal of one power detector among the plurality of power detectors converted to a digital signal by the analog/digital converter by a coefficient for canceling an unnecessary component included in the output signal of the other power detector; at least one subtractor for subtracting the output signal of the one power detector multiplied by a coefficient at the multiplier from the output signal of the other power detector converted to a digital signal by the analog/digital converter; and a conversion circuit for converting the result to a plurality of signal components included in the received signal based on the digital signal from the subtractor, then outputting the control signal to the variable gain amplifier so as to adjust the level of the output signal of the power detector to a level suitable for a dynamic range of the analog/digital level suitable for a dynamic range of the analog/digital converter.

In the third aspect of the present invention, preferably the demodulator has a removing means for removing a DC offset from the output of the subtractor.

Preferably, the removing means includes an offset removal subtractor connected to the latter stage of the subtractor and a circuit for measuring a DC offset amount from the output of the offset removal subtractor and feeding back a signal for canceling the DC offset amount to the offset removal subtractor.

Further, preferably, the removing means includes an offset removal subtractor connected to the latter stage of the subtractor and a circuit for taking an average of outputs of the offset removal subtractor and feeding back the average result as a signal for canceling the DC offset amount to the offset removal subtractor.

Preferably, the demodulator has a channel selecting means for selecting a desired channel from the output signal of the subtractor and inputting the same to the variable gain amplifier, and the conversion circuit demodulates an In-phase component signal I and a quadrature component signal Q based on the digital signal from the channel selecting means and predetermined circuit constants.

Further, in the third aspect of the present invention, the demodulator has a channel selecting means for selecting a desired channel from the output signal of the offset removal subtractor and inputting the same to the conversion circuit, and the conversion circuit demodulates an In-phase component signal I and a quadrature component signal Q based on the digital signal from the channel selecting means and predetermined circuit constants.

Preferably, the channel selecting means includes a low-pass filter.

Further, in the third aspect of the present invention, the conversion circuit outputs a control signal to the variable gain amplifier and calibrates the gain of the variable gain amplifier so that the digital signal from the channel selecting means becomes a desired level at the time of no reception of signal.

A demodulator according to a fourth aspect of the present invention comprises a multi-port junction circuit including a generating means receiving as input a received signal and a local signal and based on at least one signal, generating a first signal, a second signal, and a third signal having a phase difference, and a first power detector for detecting a signal level of the first signal generated by the generating means and outputting a first power detection signal, a second power detector for detecting the signal level of the second signal and outputting a second power detection signal, and a third power detector for detecting the signal level of the third signal and outputting a third power detection signal; a first multiplier for multiplying the first power detection signal from the first power detector by a coefficient for canceling an unnecessary component included in the second power detection signal from the second power detector; a second multiplier for multiplying the first power detection signal from the first power detector by a coefficient for canceling an unnecessary component included in the third power detection signal from the third power detector; a first subtractor for subtracting the first power detection signal from the first power detector multiplied by a coefficient at the first multiplier from the second power detection signal from the second power detector; a second subtractor for subtracting the first power detection signal from the first power detector multiplied by a coefficient at the second multiplier from the third power detection signal from the third power detector; and a conversion circuit for converting the result to a plurality of signal components included in the received signal based on the output signals of the first and

In the fourth aspect of the present invention, preferably the demodulator has a removing means for removing a DC offset from the output of the subtractor.

Preferably, the removing means includes offset removal subtractors connected to the latter stage of the subtractors and a circuit for measuring the DC offset amount from the output of the offset removal subtractor and feeding back a signal for canceling the DC offset amount to the offset removal subtractors.

Further, preferably, the removing means includes offset removal subtractors connected to the latter stage of the subtractors and a circuit for taking an average of outputs of the offset removal subtractor and feeding back the average result as a signal for canceling the DC offset amount to the offset removal subtractors.

Preferably, the demodulator has a first channel selecting means for selecting a desired channel from the output signal of the first subtractor and inputting the same to the conversion circuit and a second channel selecting means for selecting a desired channel from the output signal of the second subtractor and inputting the same to the conversion circuit, and the conversion circuit demodulates an In-phase component signal I and a quadrature component signal Q based on the output signals of the first and second channel selecting means and of the first and second channel selecting means and predetermined circuit constants.

Further, the conversion circuit obtains an In-phase component signal I and a quadrature component signal Q by computations based on the following equations:

$$I = \alpha_1 x_1 + \beta_1 x_2 + \gamma_1$$

$$Q = \alpha_2 x_1 + \beta_2 x_2 + \gamma_2$$

where, $x_1$ is the output signal of the first channel selecting means, $x_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

Further, in the fourth aspect of the present invention, the demodulator has a first channel selecting means for selecting a desired channel from the output signal of the first offset removal subtractor and inputting the same to the conversion circuit and a second channel selecting means for selecting a desired channel from the output signal of the second offset removal subtractor and inputting the same to the conversion circuit, and the conversion circuit demodulates an In-phase component signal I and a quadrature component signal Q based on the output signals of the first and second channel selecting means and predetermined circuit constants.

Preferably, at least one of the first and second channel selecting means includes a low-pass filter.

A demodulator according to a fifth aspect of the present invention comprises a multi-port junction circuit including a generating means receiving as input a received signal and a local signal and based on at least one signal, generating a first signal, a second signal, and a third signal having a phase difference, a first power detector for detecting a signal level of the first signal generated by the generating means and outputting a first power detection signal, a second power detector for detecting the signal level of the second signal and outputting a second power detection signal, and a third power detector for detecting the signal level of the third signal and outputting a third power detection signal; a first multiplier for multiplying the first power detection signal from the first power detector by a coefficient for canceling an unnecessary component included in the second power detection signal from the second power detector; a second multiplier for multiplying the first power detection signal from the first power detector by a coefficient for canceling an unnecessary component included in the third power detection signal from the third power detector; a first subtractor for subtracting the first power detection signal from the first power detector multiplied by a coefficient at the first multiplier from the second power detection signal from the second power detector; a second subtractor for subtracting the first power detection signal from the first power detector multiplied by a coefficient at the second multiplier from the third power detection signal from the third power detector; a first variable gain amplifier for adjusting the level of the output signal of the first subtractor with a gain in accordance with a control signal; a second variable gain amplifier for adjusting the level of the output signal of the second subtractor with a gain in accordance with a control signal; a first analog/digital converter for converting the output signal of the first variable gain amplifier from an analog signal to a digital signal; a second analog/digital converter for converting the output signal of the second variable gain amplifier from an analog signal to a digital signal; and a conversion circuit for converting the result to a plurality of signal components included in the received signal based on the digital signals from the first and second analog/digital converters, then outputting the control signal to the first and second variable gain amplifiers so as to adjust the levels of the output signals of the first and second subtractors to levels suitable for the converters.

In the fifth aspect of the present invention, preferably the demodulator has a removing means for removing a DC offset from the output of the subtractor.

Preferably, the removing means includes offset removal subtractors connected to the latter stage of the subtractors and a circuit for measuring the DC offset amount from the outputs of the offset removal subtractors and feeding back a signal for canceling the DC offset amount to the offset removal subtractors.

Further, preferably the removing means includes offset removal subtractors connected to the latter stage of the subtractors and a circuit for taking an average of outputs of the offset removal subtractors and feeding back the average result as a signal for canceling the DC offset amount to the offset removal subtractors.

In the fifth aspect of the present invention, the demodulator has a first channel selecting means for selecting a desired channel from the output signal of the first subtractor and inputting the same to the first variable gain amplifier and a second channel selecting means for selecting a desired channel from the output signal of the second subtractor and inputting the same to the second variable gain amplifier, and the conversion circuit demodulates an In-phase component signal I and a circuit demodulates an In-phase component signal I and a quadrature component signal Q based on the output signals of the first and second analog/digital converters and predetermined circuit constants.

Further, the conversion circuit acquires an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

Further, in the present invention, the demodulator has a first channel selecting means for selecting a desired channel from the output signal of the first offset removal subtractor and inputting the same to the first variable gain amplifier and a second channel selecting means for selecting a desired channel from the output signal of the second offset removal subtractor and inputting the same to the second variable gain amplifier, and the conversion circuit demodulates an In-phase component signal I and a quadrature component signal Q based on the output signals of the first and second analog/digital converters and predetermined circuit constants.

Preferably, at least one of the first and second channel selecting means includes a low-pass filter.

Further, the conversion circuit outputs the control signal to the variable gain amplifiers and calibrates the gains of the variable gain amplifiers so that the digital signals from the first and second analog/digital converters become levels obtained from the following equations at the time of no reception of signal.

$$X_1 = (-\gamma_1\beta_1 + \beta_2\gamma_2) / (\alpha_1\beta_2 - \alpha_2\beta_1)$$

$$X_2 = (\gamma_1\alpha_2 - \alpha_1\gamma_2) / (\alpha_1\beta_2 - \alpha_2\beta_1)$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

A demodulator according to a sixth aspect of the present invention comprises a multi-port junction circuit including a generating means receiving as input a received signal and a local signal and based on at least one signal, generating a first signal, a second signal, and a third signal having a phase difference a first power detector for detecting a signal level of the first signal generated by the generating means and outputting a first power detection signal, a second power detector for detecting the signal level of the second signal and outputting a second power detection signal, and a third power detector for detecting the signal level of the third signal and outputting a third power detection signal; a first variable gain amplifier for adjusting the level of the first power detection signal from the first power detector with a gain in accordance with a control signal; a second variable gain amplifier for adjusting the level of the second power detection signal from the second power detector with a gain in accordance with a control signal; a third variable gain amplifier for adjusting the level of the third power detection signal from the third power detector with a gain in accordance with a control signal; a first analog/digital converter for converting the output signal of the first variable gain amplifier from an analog signal to a digital signal; a second analog/digital converter for converting the output signal of the second variable gain amplifier from an analog signal to a digital signal; a third analog/digital converter for converting the output signal of the third variable gain amplifier from an analog signal to a digital signal; a first multiplier for multiplying the first power detection signal from the first power detector converted to a digital signal at the first analog/digital converter by a coefficient for canceling an unnecessary component included in the second power detection signal from the second power detector; a second multiplier for multiplying the first power detection signal from the first power detector converted to a digital signal at the first analog/digital converter by a coefficient for canceling an unnecessary component included in the third power detection signal from the third power detector; a first subtractor for subtracting the first power detection signal from the first power detector multiplied by a coefficient at the first multiplier from the second power detection signal from the second power detector converted to a digital signal at the second analog/digital converter; a second subtractor for subtracting the first power detection signal from the first power detector multiplied by a coefficient at the second multiplier from the third power detection signal from the third power detector converted to a digital signal at the third analog/digital converter; and a conversion circuit for converting the result to a plurality of signal components included in the received signal based on the digital signals from the first and second subtractors, and then outputting the control signal to the second and third variable gain amplifiers so as to adjust the levels of the output suitable for the dynamic range of at least the second and third analog/digital converters.

In the sixth aspect of the present invention, preferably, the demodulator has a removing means for removing a DC offset from the output of the subtractor.

Preferably, the removing means includes offset removal subtractors connected to the latter stage of the subtractors and a circuit for measuring the DC offset amount from the output of the offset removal subtractors and feeding back a signal for canceling the DC offset amount to the offset removal subtractors.

Further, preferably, the removing means includes an offset removal subtractors connected to the latter stage of the subtractors and a circuit for taking an average of outputs of the offset removal subtractors and feeding back the average results as a signal for canceling the DC offset amount to the offset removal subtractors.

In the sixth aspect of the present invention, the demodulator has a first channel selecting means for selecting a desired channel from the output signal of the first subtractor and inputting the same to the conversion circuit and a second channel selecting means for selecting a desired channel from the output signal of the second subtractor and inputting the same to the conversion circuit, and the conversion circuit conversion circuit, and the conversion circuit demodulates an In-phase component signal I and a quadrature component signal Q based on the output signals of the first and second channel selecting means and predetermined circuit constants.

Further, the conversion circuit acquires an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

Further, in the sixth aspect of the present invention, the demodulator has a first channel selecting means for selecting a desired channel from the output signal of the first offset removal subtractor and inputting the same to the first conversion circuit and a second channel selecting means for selecting a desired channel from the output signal of the second offset removal subtractor and inputting the same to the conversion circuit, and the conversion circuit demodulates an In-phase component signal I and a quadrature component signal Q based on the output signals of the first and second channel selecting means and predetermined circuit constants.

Preferably, at least one of the first and second channel selecting means includes a low-pass filter.

Further, the conversion circuit outputs the control signal to the variable gain amplifiers and calibrates the gains of the variable gain amplifiers so that the digital signals from the first and second channel selecting means become levels obtained from the following equations at the time of no reception of signal.

$$X_1 = (-\gamma_1\beta_1 + \beta_2\gamma_2) / (\alpha_1\beta_2 - \alpha_2\beta_1)$$

$$X_2 = (\gamma_1\alpha_2 - \alpha_1\gamma_2) / (\alpha_1\beta_2 - \alpha_2\beta_1)$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

A receiver according to a seventh aspect of the present invention comprises a demodulator having a multi-port junction circuit including a generating means receiving as input a received signal and a local signal and based on at least one signal, generating at least two signals having a phase difference, and a plurality of power detectors for detecting signal levels of signals generated by the generating means, at least one multiplier for multiplying an output signal of one power detector among the plurality of power detectors by a coefficient for canceling an unnecessary component included in the output signal of the other power detector, at least one subtractor for subtracting the output signal of the one power detector multiplied by a coefficient at the multiplier from the output signal of the other power detector, and a conversion circuit for converting the result to a plurality of signal components included in the received signal based on the output signal of the subtractor; a gain control circuit for adjusting the level of the received signal to a desired level and supplying the result to the generating means of the multi-port junction circuit; and a local signal generation circuit for generating a local signal of a desired level at a desired oscillation frequency and supplying the same to the generating means of the multi-port junction circuit.

In the seventh aspect of the present invention, the gain control circuit receives a gain control signal to be controlled in gain and includes a gain control signal generation circuit for outputting the gain control signal to the gain control circuit so that the received signal level becomes constant based on the output signal of one power detector among the plurality of power detectors.

Further, preferably, it includes a carrier reproduction circuit for reproducing a carrier based on a plurality of signal components obtained at the conversion circuit and outputting a reproduced signal, and the local signal generation circuit receives the reproduced signal and sets the oscillation frequency of the local signal so as to become a frequency substantially equal to the carrier frequency of the received signal.

In the seventh aspect of the present invention, the receiver has a channel selecting means for selecting a desired channel from the output signal of the subtractor and inputting the same to the conversion circuit, and the conversion circuit demodulates an In-phase component signal I and a quadrature component signal Q based on the output signal of the channel selecting means and predetermined circuit constants.

Further, in the seventh aspect of the present invention, the receiver includes a variable circuit for adjusting the level of the local signal by the local signal generation circuit to a level in accordance with a level control signal and a level control circuit for outputting the level control signal to the variable circuit so that the multi-port junction circuit becomes a level enabling operation at an optimum level in accordance with the received signal level obtained at the conversion circuit.

Further, the receiver has a channel selecting means for selecting a desired channel from the output signal of the subtractor and inputting the same to the conversion circuit, and the conversion circuit is given the local signal level and demodulates an In-phase component signal I and a quadrature component signal Q based on the given local signal level, the output signal of the channel selecting means, and predetermined circuit constants.

Further, the receiver has a channel selecting means for selecting a desired channel from the output signal of the subtractor and inputting the same to the conversion circuit and a level measurement circuit for measuring and calculating the local signal level from the output signal of one power detector among the plurality of power detectors at the time of no reception of signal and holding the calculated local signal level, and the conversion circuit demodulates an In-phase component signal I and a quadrature component signal Q based on the held local signal level, the output signal of the channel selecting means, and predetermined circuit constants.

Further, in the seventh aspect of the present invention, the receiver has a removing means for removing the DC offset from the output of the subtractor.

Further, preferably, the removing means includes an offset removal subtractor connected to the latter stage of the subtractor and a circuit for measuring the DC offset amount from the output of the offset removal subtractor and feeding back a signal for canceling the DC offset amount to the offset removal subtractor.

Further, the removing means includes an offset removal subtractor connected to the latter stage of the subtractor and a circuit for taking an average of outputs of the offset removal subtractor and feeding back the average result to the offset removal subtractor as a signal for canceling the DC offset amount.

A receiver according to an eighth aspect of the present invention comprises a demodulator having a multi-port junction circuit including a generating means receiving as input a received signal and a local signal and based on at least one signal, generating at least two signals having a phase difference, and a plurality of power detectors for detecting signal levels of signals generated by the generating means, at least one multiplier for multiplying an output signal of one power detector among the plurality of power detectors by a coefficient for canceling an unnecessary component included in the output signal of the other power detector, at least one subtractor for subtracting the output signal of the one power detector multiplied by a coefficient at the multiplier from the output signal of the other power detector, at least one variable gain amplifier for adjusting the level of the output signal of the subtractor with a gain in accordance with a control signal, an analog/digital converter for converting the output signal of the variable gain amplifier from an analog signal to a digital signal, and a conversion circuit for converting the result to a plurality of signal components included in the received signal based on the digital signal from the analog/digital converter and then outputting the control signal to the variable gain amplifier so as to adjust the level of the output signal of the subtractor to a level suitable for a dynamic range of the analog/digital converter; a gain control circuit for adjusting the level of the received signal to a desired level and supplying the result to the generating means of the multi-port junction circuit; and a local signal generation circuit for generating a local signal of the desired level at a desired oscillation frequency and supplying the same to the generating means of the multi-port junction circuit.

In the eighth aspect of the present invention, the gain control circuit receives a gain control signal to be controlled in gain and includes a gain control signal generation circuit for outputting the gain control signal to the gain control circuit so that the received signal level becomes a constant level based on the output signal of one power detector among the plurality of power detectors.

Preferably, the receiver includes a carrier reproduction circuit for reproducing a carrier based on a plurality of signal components obtained at the conversion circuit and outputting a reproduced signal, and the local signal generation circuit receives the reproduced signal and sets the oscillation frequency of the local signal so as to become a frequency substantially equal to the carrier frequency of the received signal.

Further, in the eighth aspect of the present invention, the receiver has a channel selecting means for selecting a desired channel from the output signal of the subtractor and inputting the same to the variable gain amplifier, and the conversion circuit demodulates an In-phase component signal I and a quadrature component signal Q based on the output signal of the analog/digital converter and predetermined circuit constants.

Further, in the eighth aspect of the present invention, the receiver includes a variable circuit for adjusting the level of the local signal from the local signal generation circuit to a level in accordance with a level control signal and a level control circuit for outputting the level control signal to the variable circuit so that the multi-port junction circuit becomes a level enabling operation at the optimum level in accordance with the received signal level obtained at the conversion circuit.

Preferably, the receiver has a channel selecting means for selecting a desired channel from the output signal of the subtractor and inputting the same to the variable gain amplifier, and the conversion circuit is given the local signal level and demodulates an In-phase component signal I and a quadrature component signal Q based on the given local signal level, the output signal of the analog/digital converter, and predetermined circuit constants.

Further, in the eighth aspect of the present invention, the receiver has a removing means for removing the DC offset from the output of the subtractor.

Further, preferably, the removing means includes an offset removal subtractor connected to the latter stage of the subtractor and a circuit for measuring a DC offset amount from the output of the offset removal subtracter and feeding back a signal for canceling the DC offset amount to the offset removal subtractor.

Further, the removing means includes an offset removal subtractor connected to the latter stage of the subtractor and a circuit for taking an average of outputs of the offset removal subtractor and feeding back the average result to the offset removal subtractor as a signal for canceling the DC offset amount.

Further, in the eighth aspect of the present invention, the conversion circuit outputs the control signal to the variable gain amplifier and calibrates the gain of the variable gain amplifier so that the digital signal from the analog/digital converter becomes the desired level at the time of not receiving a signal.

A receiver according to a ninth aspect of the present invention comprises a demodulator having a multi-port junction circuit including a generating means receiving as input a received signal and a local signal and based on at least one signal, generating at least two signals having a phase difference, and a plurality of power detectors for detecting signal levels of signals generated by the generating means, a plurality of variable gain amplifiers for adjusting levels of the output signals of the plurality of power detectors with a gain in accordance with a control signal, a plurality of analog/digital converters for converting the output signals of the plurality of variable gain amplifiers from analog signals to digital signals, at least one multiplier for multiplying the output signal of one power detector among the plurality of power detectors converted to a digital signal by the analog/digital converter by a coefficient for canceling an unnecessary component included in the output signal of the other power detector, at least one subtracter for subtracting the output signal of the one power detector multiplied by a coefficient at the multiplier from the output signal of the other power detector converted to a digital signal by the analog/digital converter, and a conversion circuit for converting the result to a plurality of signal components included in the received signal based on the digital signal from the subtractor and then outputting the control signal to the variable gain amplifier so as to adjust the level of the output signal of the power detector to a level suitable for the dynamic range of the analog/digital converter; a gain control circuit for adjusting the level of the received signal to a desired level and supplying the same to the generating means of the multi-port junction circuit; and a local signal generation circuit for generating a local signal of a desired level at a desired oscillation frequency and supplying the same to the generating means of the multi-port junction circuit. In the ninth aspect of the present invention, the gain control circuit receives a gain control signal to be controlled in gain and includes a gain control signal generation circuit for outputting the gain control signal to the gain control circuit so that the received signal level becomes constant based on the output signal of one power detector among the plurality of power detectors.

Preferably, the receiver includes a carrier reproduction circuit for reproducing a carrier based on a plurality of signal components obtained at the conversion circuit and outputting a reproduced signal, and the local signal generation circuit receives the reproduced signal and sets the oscillation frequency of the local signal so as to become a frequency substantially equal to the carrier frequency of the received signal.

Further, preferably, the receiver has a channel selecting means for selecting a desired channel from the output signal of the subtractor and inputting the same to the conversion circuit, and the conversion circuit demodulates an In-phase component signal I and a quadrature component signal Q based on the output signal of the channel selecting means and predetermined circuit constants.

Further, in the ninth aspect of the present invention, the receiver includes a variable circuit for adjusting the level of the local signal by the local signal generation circuit to a level in accordance with a level control signal and a level control circuit for outputting the level control signal to the variable circuit so that the multi-port junction circuit becomes a level enabling operation at the optimum level in accordance with the received signal level obtained at the conversion circuit.

Further, in the ninth aspect of the present invention, the receiver has a channel selecting means for selecting a desired channel from the output signal of the subtractor and inputting the same to the conversion circuit, and the conversion circuit is given the local signal level and demodulates an In-phase component signal I and a quadrature component signal Q based on the given local signal level, the output signal of the channel selecting means, and predetermined circuit constants.

Further, in the ninth aspect of the present invention, the receiver has a removing means for removing the DC offset from the output of the subtractor.

Further, preferably, the removing means includes an offset removal subtractor connected to the latter stage of the subtractor and a circuit for measuring the DC offset amount from the output of the offset removal subtractor and feeding back a signal for canceling the DC offset amount to the offset removal subtractor.

Further, the removing means includes an offset removal subtractor connected to the latter stage of the subtractor and a circuit for taking an average of outputs of the offset removal subtractor and feeding back the average result to the offset removal subtractor as a signal for canceling the DC offset amount.

Further, in the ninth aspect of the present invention, the conversion circuit outputs the control signal to the variable gain amplifiers and calibrates the gain of the variable gain amplifiers so that the digital signal from the analog/digital converter become a desired level at the time of not receiving a signal.

A receiver according to a 10th aspect of the present invention comprises a demodulator having a multi-port junction circuit including a generating means receiving as input a received signal and a local signal and based on at least one signal, generating a first signal, a second signal, and a third signal having a phase difference, a first power detector for detecting a signal level of the first signal generated by the generating means and outputting a first power detection signal, a second power detector for detecting the signal level of the second signal and outputting a second power detection signal, and a third power detector for detecting the signal level of the third signal and outputting a third power detection signal, a first multiplier for multiplying the first power detection signal from the first power detector by a coefficient for canceling an unnecessary component included in the second power detection signal from the second power detector, a second multiplier for multiplying the first power detection signal from the first power detector by a coefficient for canceling an unnecessary component included in the third power detection signal from the third power detector, a first subtractor for subtracting the first power detection signal from the first power detector multiplied by a coefficient at the first multiplier from the second power detection signal from the second power detector, a second subtractor for subtracting the first power detection signal from the first power detector multiplied by a coefficient at the second multiplier from the third power detection signal from the third power detector, and a conversion circuit for converting the result to a plurality of signal components included in the received signal based on the output signals of the first and second subtractors; a gain control circuit for adjusting the level of the received signal to a desired level and supplying the same to the generating means of the multi-port junction circuit; and a local signal generation circuit for generating a local signal of a desired level at a desired oscillation frequency and supplying the same to the generating means of the multi-port junction circuit.

In the 10th aspect of the present invention, the gain control circuit receives a gain control signal to be controlled in gain and includes a gain control signal generation circuit for outputting the gain control signal to the gain control circuit so that the received signal level becomes constant based on the output signal of one power detector among the plurality of power detectors.

Preferably, the receiver includes a carrier reproduction circuit for reproducing a carrier based on a plurality of signal components obtained at the conversion circuit and outputting a reproduced signal, and the local signal generation circuit receives the reproduced signal and sets the oscillation frequency of the local signal so as to become a frequency substantially equal to the carrier frequency of the received signal.

In the 10th aspect of the present invention, the receiver has a first channel selecting means for selecting a desired channel from the output signal of the first subtractor and inputting the same to the conversion circuit and a second channel selecting means for selecting a desired channel from the output signal of the second subtractor and inputting the same to the conversion circuit, and the conversion circuit demodulates an In-phase component signal I and a quadrature component signal Q based on the output signals of the first and second channel selecting means and predetermined circuit constants.

Further, the conversion circuit obtains an In-phase component signal I and a quadrature component signal Q by computations based on the following equations:

$$I = \alpha_1 x_1 + \beta_1 x_2 + \gamma_1$$

$$Q = \alpha_2 x_1 + \beta_2 x_2 + \gamma_2$$

where, $x_1$ is the output signal of the first channel selecting means, $x_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

Further, in the 10th aspect of the present invention, the receiver includes a variable circuit for adjusting the level of the local signal by the local signal generation circuit to a level in accordance with a level control signal and a level control circuit for outputting the level control signal to the variable circuit so that the multi-port junction circuit becomes a level enabling operation at the optimum level in accordance with the received signal level obtained at the conversion circuit.

Further, in the 10th aspect of the present invention, the receiver has a first channel selecting means for selecting the desired channel from the output signal of the first subtractor and inputting the same to the conversion circuit and a second channel selecting means for selecting the desired channel from the output signal of the second subtractor and inputting the same to the conversion circuit, and the conversion circuit is given the local signal level and demodulates an In-phase component signal I and a quadrature component signal Q based on the given local signal level, the output signals of the first and second channel selecting means, and predetermined circuit constants.

Further, the conversion circuit obtains an In -phase component signal I and a quadrature component signal Q by computations based on the following equations:

$$I = a_1 x_1 / P_{LO} + b_1 x_2 / P_{LO} + \gamma_1$$

$$Q = a_2 x_1 / P_{LO} + b_2 x_2 / P_{LO} + \gamma_2$$

where, $x_1$ is the output signal of the first channel selecting means, $x_2$ is the output signal of the second channel selecting means, $P_{LO}$ is the local signal level, and $a_1$, $a_2$, $b_1$, $b_2$, $\gamma_1$, and $\gamma_2$ are circuit constants found from circuit elements of the demodulator.

Further, in the 10th aspect of the present invention, the receiver has a first channel selecting means for selecting the desired channel from the output signal of the first subtractor and inputting the same to the conversion circuit, a second channel selecting means for selecting the desired channel from the output signal of the second subtractor and inputting the same to the conversion circuit, and a level measurement circuit for measuring and calculating the local signal level from the output signal of one power detector among the plurality of power detectors at the time of no reception of signal and holding the calculated local signal level, and the conversion circuit demodulates an In-phase component signal I 'and a quadrature component signal Q based on the held local signal level, the output signals of the first and second channel selecting means, and predetermined circuit constants.

Further, the conversion circuit obtains an In-phase component signal I and a quadrature component signal Q by computations based on the following equations:

$$I = a_1 x_1/P_{LO} + b_1 x_2/P_{LO} + \gamma_1$$

$$Q = a_2 x_1/P_{LO} + b_2 x_2/P_{LO} + \gamma_2$$

where, $x_1$ is the output signal of the first channel selecting means, $x_2$ is the output signal of the second channel selecting means, $P_{LO}$ is the local signal level, and $a_1$, $a_2$, $b_1$, $b_2$, $\gamma_1$, and $\gamma_2$ are circuit constants found from circuit elements of the demodulator.

Further, in the 10th aspect of the present invention, the receiver has a removing means for removing the DC offset from the output of the subtractor.

Further, preferably, the removing means includes offset removal subtractors connected to the latter stage of the subtractors and a circuit for measuring the DC offset amount from the output of the offset removal subtractors and feeding back a signal for canceling the DC offset amount to the offset removal subtractors.

Further, the removing means includes offset removal subtractors connected to the latter stage of the subtractors and a circuit for taking an averages of outputs of the offset removal subtractors and feeding back the average results to the offset removal subtractor as signals for canceling the DC offset amount.

A receiver according to an 11th aspect of the present invention comprises a demodulator having a multi-port junction circuit including a generating means receiving as input a received signal and a local signal and based on at least one signal, generating a first signal, a second signal, and a third signal having a phase difference, a first power detector for detecting a signal level of the first signal generated by the generating means and outputting a first power detection signal, a second power detector for detecting the signal level of the second signal and outputting a second power detection signal, and a third power detector for detecting the signal level of the third signal and outputting a third power detection signal, a first multiplier for multiplying the first power detection signal from the first power detector by a coefficient for canceling an unnecessary component included in the second power detection signal from the second power detector, a second multiplier for multiplying the first power detection signal from the first power detector by a coefficient for canceling an unnecessary component included in the third power detection signal from the third power detector, a first subtractor for subtracting the first power detection signal from the first power detector multiplied by a coefficient at the first multiplier from the second power detection signal from the second power detector, a second subtractor for subtracting the first power detection signal from the first power detector multiplied by a coefficient at the second multiplier from the third power detection signal from the third power detector, a first variable gain amplifier for adjusting the level of the output signal of the first subtractor with a gain in accordance with a control signal, a second variable gain amplifier for adjusting the level of the output signal of the second subtractor with a gain in accordance with a control signal, a first analog/digital converter for converting the output signal of the first variable gain amplifier from an analog signal to a digital signal, a second analog/digital converter for converting the output signal of the second variable gain amplifier from an analog signal to a digital signal, and a conversion circuit for converting the result to a plurality of signal components included in the received signal based on the digital signals from the first and second analog/digital converters and then outputting the control signal to the first and second variable gain amplifiers so as to adjust the levels of the output signals of the first and second subtractors to levels suitable for the dynamic range of the first and second analog/digital converters; a gain control circuit for adjusting the level of the received signal to a desired level and supplying the result to the generating means of the multi-port junction circuit; and a local signal generation circuit for generating a local signal of a desired level at a desired oscillation frequency and supplying the same to the generating means of the multi-port junction circuit.

In the 11th aspect of the present invention, the gain control circuit receives a gain control signal to be controlled in gain and includes a gain control signal generation circuit for outputting the gain control signal to the gain control circuit so that the received signal level becomes constant based on the output signal of one power detector among the plurality of power detectors.

Preferably, the receiver includes a carrier reproduction circuit for reproducing a carrier based on a plurality of signal components obtained at the conversion circuit and outputting a reproduced signal, and the local signal generation circuit receives the reproduced signal and sets the oscillation frequency of the local signal so as to become a frequency substantially equal to the carrier frequency of the received signal.

Further, in the 11th aspect of the present invention, the receiver has a first channel selecting means for selecting a desired channel from the output signal of the first subtractor and inputting the same to the first variable gain amplifier and a second channel selecting means for selecting a desired channel from the output signal of the second subtractor and inputting the same to the second variable gain amplifier, and the conversion circuit demodulates an In-phase component signal I and a quadrature component signal Q based on the output signals of the first and second analog/digital converters and predetermined circuit constants.

Further, the conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

Further, in the 11th aspect of the present invention, the receiver includes a variable circuit for adjusting the level of the local signal by the local signal generation circuit to a level in accordance with a level control signal and a level control circuit for outputting the level control signal to the variable circuit so that the multi-port junction circuit becomes a level enabling operation at the optimum level in accordance with the received signal level obtained at the conversion circuit.

Further, in the 11th aspect of the present invention, the receiver has a first channel selecting means for selecting the desired channel from the output signal of the first subtractor and inputting the same to the first variable gain amplifier and a second channel selecting means for selecting the desired channel from the same to the second variable gain amplifier, and the conversion circuit is given the local signal level and demodulates an In-phase component signal I and a quadrature component signal Q based on the given local signal level, the output signals of the first and second analog/digital converters, and predetermined circuit constants.

Further, the conversion circuit obtains an In-phase component signal I and a quadrature component signal Q by computations based on the following equations:

$$I = a_1 X_1 / P_{LO} + b_1 X_2 / P_{LO} + \gamma_1$$

$$Q = a_2 X_1 / P_{LO} + b_2 X_2 / P_{LO} + \gamma_2$$

where, $X_1$ is the output signal of the first analog/digital converter, $X_2$ is the output signal of the second analog/digital converter, $P_{LO}$ is the local signal level, and $a_1$, $a_2$, $b_1$, $b_2$, $\gamma_1$, and $\gamma_2$ are circuit constants found from circuit elements of the demodulator.

Further, in the 11th aspect of the present invention, the receiver has a first channel selecting means for selecting the desired channel from the output signal of the first subtractor and inputting the same to the first variable gain amplifier, a second channel selecting means for selecting the desired channel from the output signal of the second subtractor and inputting the same to the second variable gain amplifier, and a level measurement circuit for measuring and calculating the local signal level from the output signal of one power detector among the plurality of power detectors at the time of no reception of signal and holding the calculated local signal level, and the conversion circuit demodulates an In-phase component signal I and a quadrature component signal Q based on the held local signal level, the output signals of the first and second analog/digital converters, and predetermined circuit constants.

Further, the conversion circuit obtains an In-phase component signal I and a quadrature component signal Q by computation based on the following equations:

$$I = a_1 X_1 / P_{LO} + b_1 X_2 / P_{LO} + \gamma_1$$

$$Q = a_2 X_1 / P_{LO} + b_2 X_2 / P_{LO} + \gamma_2$$

where, $X_1$ is the output signal of the first analog/digital converter, $X_2$ is the output signal of the second analog/digital converter, $P_{LO}$ is the local signal level, and $a_1$, $a_2$, $b_1$, $b_2$, $\gamma_1$, and $\gamma_2$ are circuit constants found from circuit elements of the demodulator.

Further, in the 11th aspect of the present invention, the receiver has a removing means for removing the DC offset from the output of the subtractor.

Further, preferably, the removing means includes offset removal subtractors connected to the latter stage offset removal subtractors connected to the latter stage of the subtractors and a circuit for measuring the DC offset amount from the outputs of the offset removal subtractors and feeding back a signal for canceling the DC offset amount to the offset removal subtractors.

Further, the removing means includes offset removal subtractors connected to the latter stage of the subtractors and a circuit for taking averages of outputs of the offset removal subtractors and feeding back the average results to the offset removal subtractors as a signal for canceling the DC offset amount.

Further, in the 11th aspect of the present invention, the conversion circuit outputs a control signal to the variable gain amplifiers and calibrates the gains of the variable gain amplifiers so that the digital signals from the first and second analog/digital converters become levels obtained from the following equations:

$$X_1 = (-\gamma_1\beta_1+\beta_2\gamma_2) / (\alpha_1\beta_2-\alpha_2\beta_1)$$

$$X_2 = (\gamma_1\alpha_2-\alpha_1\gamma_2) / (\alpha_1\beta_2-\alpha_2\beta_1)$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

A receiver according to a 12th aspect of the present invention comprises a demodulator having a multi-port junction circuit including a generating means receiving as input a received signal and a local signal and based on at least one signal, generating a first signal, a second signal, and a third signal having a phase difference, a first power detector for detecting a signal level of the first signal generated by the generating means and outputting a first power detection signal, a second power detector for detecting the signal level of the second signal and outputting a second power detection signal, and a third power detector for detecting the signal level of the third signal and outputting a third power detection signal, a first variable gain amplifier for adjusting the level of the first power detection signal from the first power detector with a gain in accordance with a control signal, a second variable gain amplifier for adjusting the level of the second power detection signal from the second power detector with a gain in accordance with a control signal, a third variable gain amplifier for adjusting the level of the third power detection signal from the third power detector with a gain in accordance with a control signal, a first analog/digital converter for converting the output signal of the first variable gain amplifier from an analog signal to a digital signal, a second analog/digital converter for converting the output signal of the second variable gain amplifier from an analog signal to a digital signal, a third analog/digital converter for converting the output signal of the third variable gain amplifier from an analog signal to a digital signal, a first multiplier for multiplying the first power detection signal from the first power detector converted to a digital signal at the first analog/digital converter by a coefficient for canceling an unnecessary component included in the second power detection signal from the second power detector, a second multiplier for multiplying the first power detection signal from the first power detector converted to a digital signal at the first analog/digital converter by a coefficient for canceling an unnecessary component included in the third power detection signal from the third power detector, a first subtractor for subtracting the first power detection signal from the first power detector multiplied by a coefficient at the first multiplier from the second power detection signal from the second power detector converted to a digital signal at the second analog/digital converter, a second subtractor for subtracting the first power detection signal from the first power detector multiplied by a coefficient at the second multiplier from the third power detection signal from the third power detector converted to a digital signal at the third analog/digital converter, and a conversion circuit for converting the result to a plurality of signal components included in the received signal based on the digital signals from said first and second subtractors and then outputting the control signal to the second and third variable gain amplifiers so as to adjust the levels of the output signals of the second and third power detectors to levels suitable for the dynamic range of at least the second and third analog/digital converters; a gain control circuit for adjusting the level of the received signal to a desired level and supplying the result to the generating means of the multi-port junction circuit; and a local signal generation circuit for generating a local signal of a desired level at a desired oscillation frequency and supplying the same to the generating means of the multi-port junction circuit.

In the 12th aspect of the present invention, the gain control circuit receives a gain control signal to be controlled in gain and includes a gain control signal generation circuit for outputting the gain control signal to the gain control circuit so that the received signal level becomes constant based on the output signal of one power detector among the plurality of power detectors.

Preferably, the receiver includes a carrier reproduction circuit for reproducing a carrier based on a plurality of signal components obtained at the conversion circuit and outputting a reproduced signal, and the local signal generation circuit receives the reproduced signal and sets the oscillation frequency of the local signal so as to become a frequency substantially equal to the carrier frequency of the received signal.

In the 12th aspect of the present invention, the receiver has a first channel selecting means for selecting a desired channel from the output signal of the first subtractor and inputting the same to the conversion circuit and a second channel selecting means for selecting a desired channel from the output signal of the second subtractor and inputting the same to the conversion circuit, and the conversion circuit demodulates an In-phase component signal I and a quadrature component signal Q based on the output signals of the first and second channel selecting means and predetermined circuit constants.

Further, the conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

Further, in the 12th aspect of the present invention, the receiver includes a variable circuit for adjusting the level of the local signal by the local signal generation circuit to a level in accordance with a level control signal and a level control circuit for outputting the level control signal to the variable circuit so that the multi-port junction circuit becomes a level enabling operation at the optimum level in accordance with the received signal level obtained at the conversion circuit.

In the 12th aspect of the present invention, the receiver has a first channel selecting means for selecting the desired channel from the output signal of the first subtractor and inputting the same to the conversion circuit and a second channel selecting means for selecting the desired channel from the output signal of the second subtractor and inputting the same to the conversion circuit, and the conversion circuit is given the local signal level and demodulates an In-phase component signal I and a quadrature component signal Q based on the given local signal level, the output signals of the first and second channel selecting means, and predetermined circuit constants.

Further, the conversion circuit obtains an In-phase component signal I and a quadrature component signal Q by computations based on the following equations:

$$I = a_1 X_1 / P_{LO} + b_1 X_2 / P_{LO} + \gamma_1$$

$$Q = a_2 X_1 / P_{LO} + b_2 X_2 / P_{LO} + \gamma_2$$

where, $X_1$ is the output signal of the first channel selecting means, $X_2$ is the output signal of the second channel selecting means, $P_{LO}$ is the local signal level, and $a_1$, $a_2$, $b_1$, $b_2$, $\gamma_1$, and $\gamma_2$ are circuit constants found from circuit elements of the demodulator.

Further, in the 12th aspect of the present invention, the receiver has a first channel selecting means for selecting the desired channel from the output signal of the first subtractor and inputting the same to the conversion circuit, a second channel selecting means for selecting the desired channel from the output signal of the second subtractor and inputting the same to the conversion circuit, and a level measurement circuit for measuring and calculating the local signal level from the output signal of one power detector among the plurality of power detectors at the time of no reception of signal and holding the calculated local signal level, and the conversion circuit demodulates an In-phase component signal I and a quadrature component signal Q based on the held local signal level, the output signals of the first and second channel selecting means, and predetermined circuit constants.

Further, the conversion circuit obtains an In-phase component signal I and a quadrature component signal Q by computations based on the following equations:

$$I = a_1 X_1 / P_{LO} + b_1 X_2 / P_{LO} + \gamma_1$$

$$Q = a_2 X_1/P_{LO} + b_2 X_2/P_{LO} + \gamma_2$$

where, $X_1$ is the output signal of the first channel selecting means, $X_2$ is the output signal of the second channel selecting means, $P_{LO}$ is the local signal level, and all $a_2$, $b_1$, $b_2$, $\gamma_1$, and $\gamma_2$ are circuit constants found from circuit elements of the demodulator.

Further, in the 12th aspect of the present invention, the receiver has a removing means for removing the DC offset from the output of the subtractor.

Further, preferably, the removing means includes an offset removal subtractors connected to the latter stage of the subtractors and a circuit for measuring the DC offset amount from the outputs of the offset removal subtractors and feeding back a signal for canceling the DC offset amount to the offset removal subtractors.

Further, the removing means includes offset removal subtractors connected to the latter stage of the subtractors and a circuit for taking averages of outputs of the offset removal subtractors and feeding back the average results to the offset removal subtractors as a signal for canceling the DC offset amount.

Further, in the 12th aspect of the present invention, the conversion circuit outputs the control signal to the variable gain amplifier and calibrates the gain of the variable gain amplifier so that the digital signals from the first and second channel selecting means become levels obtained from the following equations:

$$X_1 = (-\gamma_1\beta_1+\beta_2\gamma_2) / (\alpha_1\beta_2-\alpha_2\beta_1)$$

$$X_2 = (\gamma_1\alpha_2-\alpha_1\gamma_2) / (\alpha_1\beta_2-\alpha_2\beta_1)$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

BRIEF DESCRIPTION OF THE DRAWINGS

FIG. 1 is a circuit diagram of the configuration of a principal part of a general demodulator.
FIG. 2 is a block diagram of an example of the configuration of a five-port demodulator.
FIG. 3 is a block diagram of a demodulator of a direct conversion system according to a first embodiment of the present invention.
FIG. 4 is a block diagram of an example of a concrete configuration of a five-port junction circuit according to the present invention.
FIG. 5 is a circuit diagram of a concrete example of the configuration of a one-input three-output branch circuit according to the present invention.
FIG. 6 is a circuit diagram of another concrete example of the configuration of a one-input three-output branch circuit according to the present invention.
FIG. 7 is a circuit diagram of another concrete example of the configuration of a one-input three-output branch circuit according to the present invention.
FIG. 8 is a circuit diagram of another concrete example of the configuration of a one-input three-output branch circuit according to the present invention.
FIG. 9 is a circuit diagram of a concrete example of the configuration of a one-input two-output branch circuit according to the present invention.
FIG. 10 is a circuit diagram of another concrete example of the configuration of a one-input two-output branch circuit according to the present invention.
FIG. 11 is a circuit diagram of another concrete example of the configuration of a one-input two-output branch circuit according to the present invention.
FIG. 12 is a circuit diagram of another concrete example of the configuration of a one-input two-output branch circuit according to the present invention.
FIG. 13 is a circuit diagram of a concrete example of the configuration of a phase shifter according to the present invention.
FIG. 14 is a circuit diagram of another concrete example of the configuration of a phase shifter according to the present invention.
FIG. 15 is a circuit diagram of another concrete example of the configuration of a phase shifter according to the present invention.

FIG. 16 is a circuit diagram of a concrete example of the configuration of a coupler circuit according to the present invention.

FIG. 17 is a circuit diagram of an example of a power detector according to the present invention.

FIG. 18 is a view of an example of detection characteristics of the power detector of FIG. 17.

FIG. 19 is a view of a high frequency input power Pin versus output detection voltage Vout when using a gate bias voltage as a parameter in the circuit of FIG. 17.

FIG. 20 is a block diagram of a demodulator of the direct conversion system according to a second embodiment of the present invention.

FIG. 21 is a block diagram of a receiver employing a demodulator of the direct conversion system according to a third embodiment of the present invention.

FIG. 22 is a block diagram of another embodiment of a five-port junction circuit according to the present invention.

FIG. 23 is a block diagram of a receiver employing a demodulator of the direct conversion system according to a fourth embodiment of the present invention.

FIG. 24 is a block diagram of a receiver employing a demodulator of the direct conversion system according to a fifth embodiment of the present invention.

FIG. 25 is a block diagram of a receiver employing a demodulator of the direct conversion system according to a sixth embodiment of the present invention.

FIG. 26 is a block diagram of a receiver employing a demodulator of the direct conversion system according to a seventh embodiment of the present invention.


BEST MODE FOR WORKING THE INVENTION

Below, an explanation will be given of embodiments of the present invention with reference to the attached drawings. Note that, in the following explanation, for simplification, an explanation will be given taking an ideal five-port model as an example, but the present invention is not limited to the five ports and can be similarly applied to n number of ports (n is an integer of more than 4 (including 4)) and similar effects can be obtained.

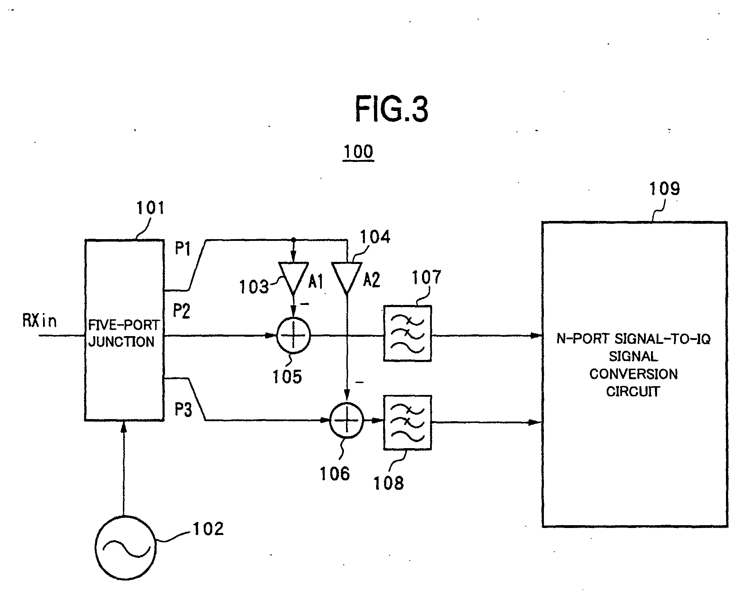

FIG. 3 is a block diagram of a five-port demodulator of the direct conversion system according to a first embodiment of the present invention.

The present five-port demodulator 100 has, as shown in FIG. 3, a five-port junction circuit 101, a local signal generation circuit 102, a first multiplier 103, a second multiplier 104, a first subtractor 105, a second subtractor 106, a first low-pass filter (LPF) 107 for channel selection, a second LPF 108 for channel selection, and a multi(n)-port-to-IQ signal conversion circuit 109.

The five-port junction circuit 101 receives a received signal Sr and a local signal Slo generated at the local signal generation circuit 102, generates three signals having a phase difference, detects the signal levels (amplitude components) of these signals to obtain three power detection signals (baseband signals) P1, P2, and P3, outputs the power detection signal P1 to the first multiplier 103 and the second multiplier 104, outputs the power detection signal P2 to the first subtractor 105, and outputs the power detection signal P3 to the second subtractor 106.

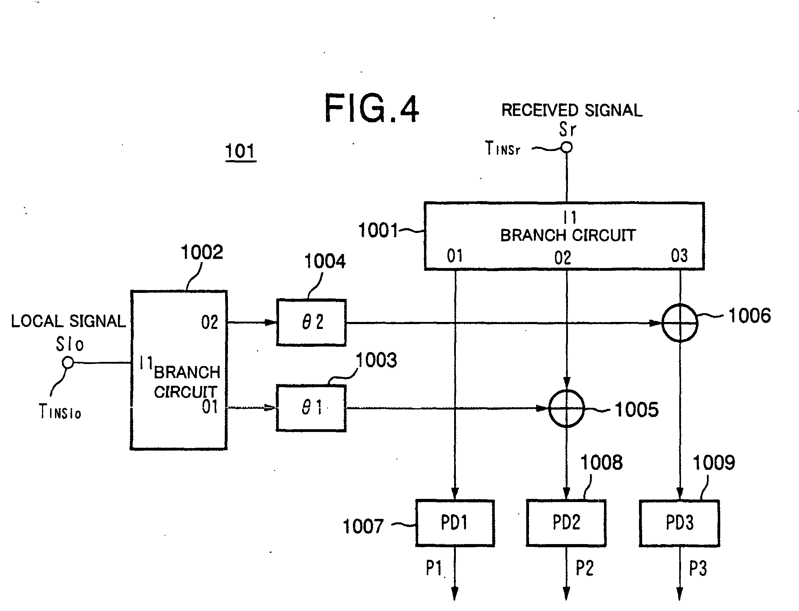

FIG. 4 is a block diagram of an example of the concrete configuration of the five-port junction circuit 101.

This five-port junction circuit 101 has, as shown in FIG. 4, a received signal use first signal input terminal $T_{INSr}$, a local signal use second signal input terminal $T_{INSlo}$, a first branch circuit 1001, a second branch circuit 1002, a first phase shifter 1003, a second phase shifter 1004, a first coupler circuit 1005, a second coupler circuit 1006, a first power detector 1007, a second power detector 1008, and a third power detector 1009.

The generating means according to the present invention is configured by the first branch circuit 1001, the second branch circuit 1002, the first phase shifter 1003, the second phase shifter 1004, the first coupler circuit 1005, and the second coupler circuit 1006.

The first branch circuit 1001 has an input terminal I1, a first output terminal O1, a second output terminal O2, and a third output terminal O3, in which the input terminal I1 is connected to the first signal input terminal $T_{INSr}$, branches the received signal Sr input to the input terminal I1 to three signals, outputs the branched first received signal from the first output terminal O1 to the first power detector 1007, outputs the second received signal from the second output terminal O2 to the first coupler circuit 1005, and outputs the third received signal from the third output terminal O3 to the second coupler circuit 1006.

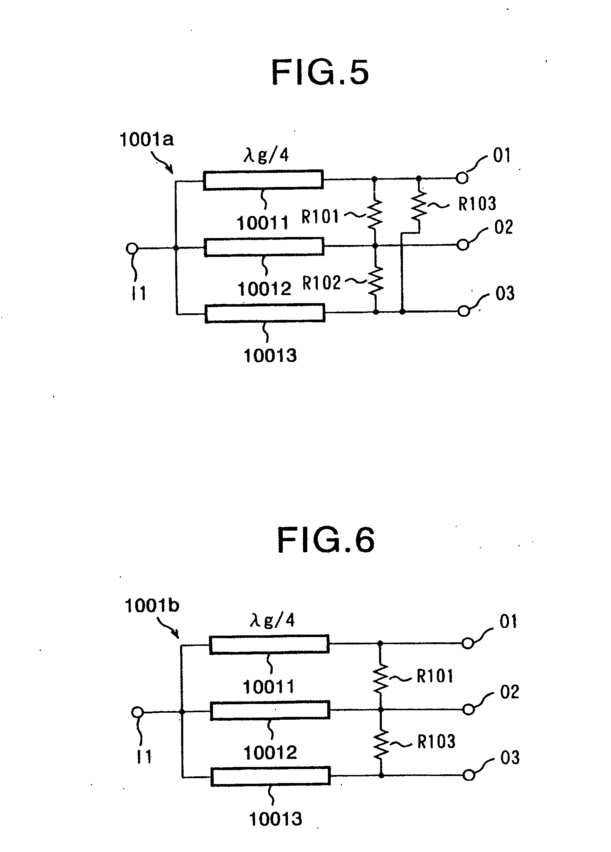

The one-input three-output first branch circuit 1001 is configured by for example the circuits shown in FIG. 5 to FIG. 8.

A branch circuit 1001a of FIG. 5 is configured by λg/4 transmission lines 10011, 10012, and 10013 having one end sides connected in parallel to the input terminal II and resistance elements R101, R102, and R103. Here, λg represents the effective wavelength.

The other end of the λg/4 transmission line 10011 is connected to the first output terminal O1, the other end of the λg/4 transmission line 10012 is connected to the second output terminal O2, and the other end of the λg/4 transmission line 10013 is connected to the third output terminal O3.

The resistance element R101 is connected between the first output terminal O1 and the second output terminal O2, the resistance element R102 is connected between the second output terminal O2 and the third output terminal O3, and the resistance element R103 is connected between the first output terminal O1 and the third output terminal O3.

In this branch circuit 1001a, the received signal Sr input to the input terminal I1 is substantially equally branched to three and output from the first output terminal O1, second output terminal O2, and the third' output terminal O3.

A branch circuit 1001b of FIG. 6 is a circuit in which the resistance element R103 is not connected between the first output terminal O1 and the third output terminal O3 of the circuit of FIG. 5. In this circuit as well, three branched signals of the received signal can be obtained well.

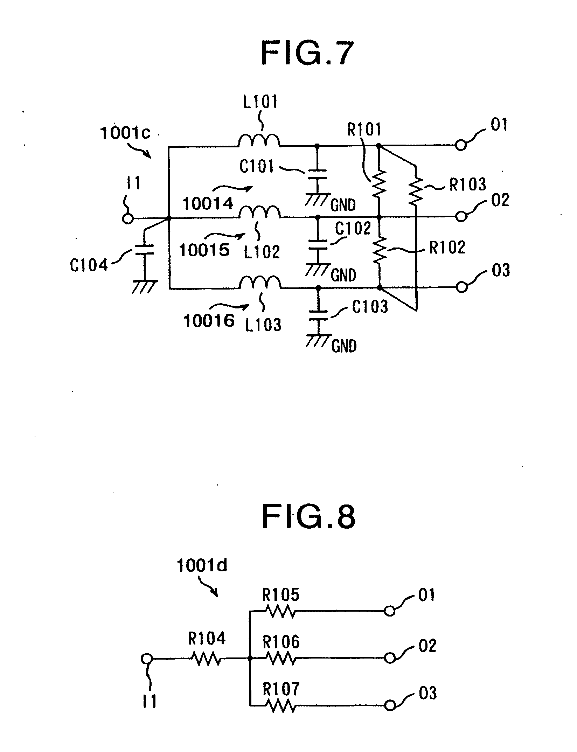

A branch circuit 1001c of FIG. 7 is configured by delay lines 10014, 10015, and 10016 comprised an inductor L101 and a capacitor C101, an inductor L102 and a capacitor C102, and an inductor L103 and a capacitor C103 in place of the λg/4 transmission lines 10011, 10012, and 10013. Further, connection points of one ends of the inductors L101 to L103 and the input terminal I1 are connected to a second electrode of the capacitor C104 having a first electrode grounded.

In this circuit as well, three branched signals of the received signal can be obtained well.

A branch circuit 1001d of FIG. 8 is configured by four resistance elements R104, R105, R106, and R107.

At the branch circuit 1001d, one end of the resistance element R104 is connected to the input terminal I1, and one ends of the resistance elements R105 to R107 are connected in parallel to the other end of the resistance element R104. The other end of the resistance element R105 is connected to the first output terminal O1, the other end of the resistance element R106 is connected to the second output terminal O2, and the other end of the resistance element R107 is connected to the third output terminal O3.

The second branch circuit 1002 has an input terminal I1, a first output terminal O1, and a second output terminal O2, in which the input terminal I1 is connected to the second signal input terminal $T_{INSlo}$, branches the local signal SO input to the input terminal I1 to two signals, outputs the branched first local signal from the first output terminal O1 to the first phase shifter 1003, and outputs the second local signal from the second output terminal O2 to the second phase shifter 1004.

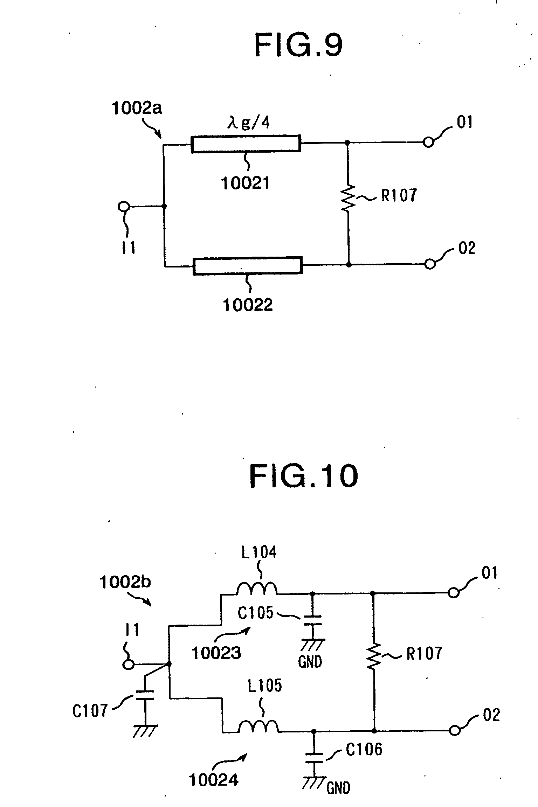

The one-input two-output second branch circuit 1002 is configured by for example circuits as shown in FIG. 9 to FIG. 12.

A branch circuit 1002a of FIG. 9 is configured by λg/4 transmission lines 10021 and 10022 having one end sides connected in parallel to the input terminal I1 and a resistance element R107. Here, λg represents the effective wavelength.

The other end of the λg/4 transmission line 10021 is connected to the first output terminal O1, and the other end of the λg/4 transmission line 10022 is connected to the second output terminal O2.

The resistance element R107 is connected between the first output terminal O1 and the second output terminal O2.

In this branch circuit 1002a, the local signal Slo input to the input terminal I1 is substantially equally branched to two and output from the first output terminal O1 and the second output terminal O2.

A branch circuit 1002b of FIG. 10 is configured by delay lines 10023 and 10024 comprised of an inductor L104 and a capacitor C105 and of an inductor L105 and a capacitor C106 in place of the λg/4 transmission lines 10021 and 10022. Further, connection points of one ends of the inductors L104 and L105 and the input terminal I1 are connected to the second electrode of the capacitor C107 having the first electrode grounded.

In this circuit as well, two branched signals of the received signal can be obtained well.

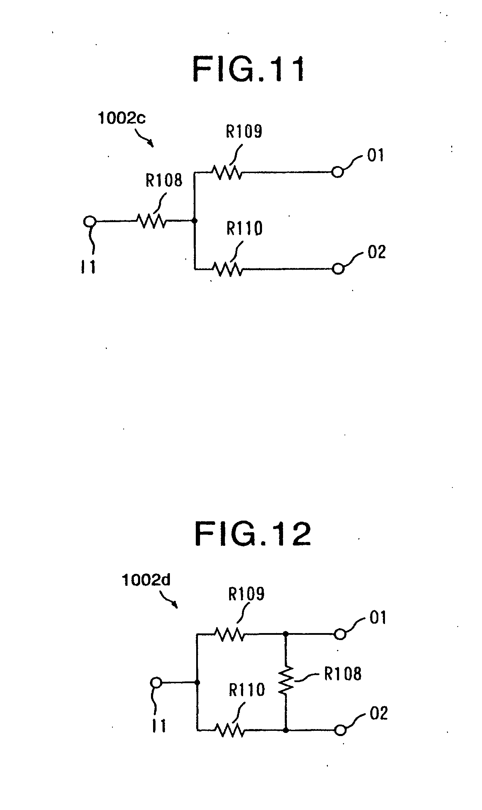

A branch circuit 1002c of FIG. 11 is configured by three resistance elements R108, R109, and R110.

At the branch circuit 1002c, one end of the resistance element R108 is connected to the input terminal 11, and one ends of the resistance elements R109 and R110 are connected in parallel to the other end of the resistance element R108. The other end of the resistance element R109 is connected to the first output terminal O1, and the other end of the resistance element R110 is connected to the first output terminal O2.

The branch circuit 1002d of FIG. 12 is configured by connecting the resistance element R108 between the first output terminal O1 and the second output terminal O2 in place of the connection between one ends of the resistance elements R109 and R110 and the input terminal I1.

The first phase shifter 1003 shifts the phase of the local signal output from the first output terminal O1 of the second coupler circuit 1002 by exactly θ1 degrees and outputs the result to the first coupler circuit 1005.

The second phase shifter 1004 shifts the phase of the local signal output from the second output terminal O2 of the second coupler circuit 1002 by exactly θ2 degrees and outputs the result to the second coupler circuit 1006.

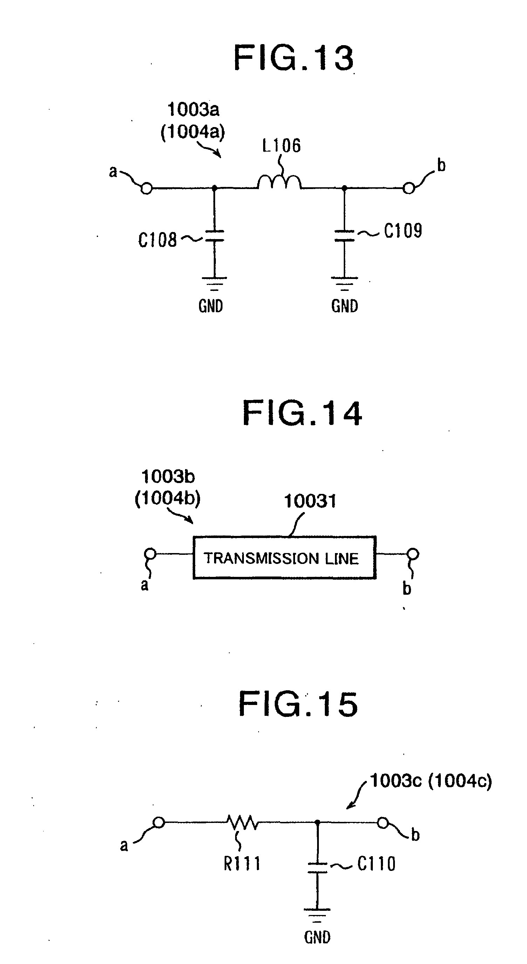

The first and second phase shifters 1003 and 1004 are configured by for example the circuits shown in FIG. 13 to FIG. 15.

The phase shifter 1003a (1004a) shown in FIG. 13 is configured by a n type LC phase shifter comprised of an inductor L106 and capacitors C108 and C109. In the phase shifter 1003a, the inductor L106 is connected between a first terminal $\underline{a}$ and a second terminal $\underline{b}$, the capacitor C108 is connected between the first terminal $\underline{a}$ and a ground potential GND, and the capacitor C109 is connected between the second terminal $\underline{b}$ and the ground potential GND.

The phase shifter 1003b (1004b) shown in FIG. 14 is configured by a transmission line 10031 connected between the first terminal $\underline{a}$ and the second terminal $\underline{b}$.

The phase shifter 1003c (1004c) shown in FIG. 15 is configured by a filter comprised of a resistance element R111 connected between the first terminal $\underline{a}$ and the second terminal $\underline{b}$ and a capacitor C110 connected between the second terminal $\underline{b}$ and the ground GND.

The first coupler circuit 1005 couples the received signal output from the second output terminal O2 of the first branch circuit 1001 and the local signal shifted in phase by exactly θ1 degrees by the first phase shifter 1003 and outputs the result to the second power detector 1008.

The second coupler circuit 1006 couples the received signal output from the third output terminal O3 of the first branch circuit 1001 and the local signal shifted in phase by exactly θ2 degrees by the second phase shifter 1004 and outputs the same to the third power detector 1009.

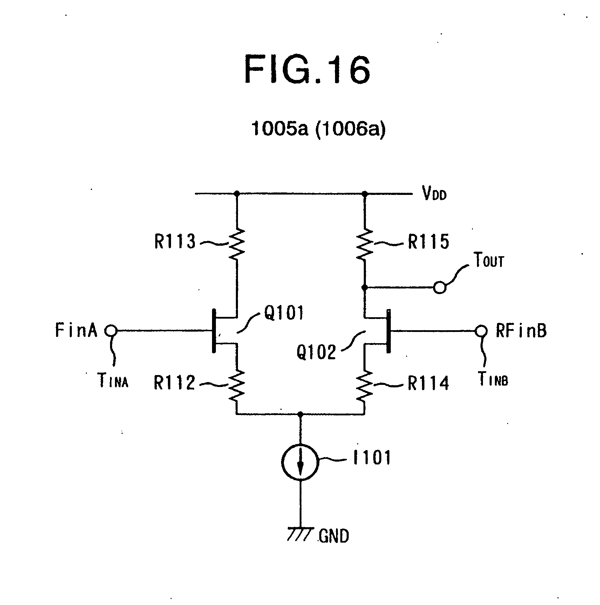

The first and second coupler circuits 1005 and 1006 are configured by for example the circuits shown in FIG. 16.

The coupler circuit 1005a (1006a) shown in FIG. 16 is configured by field effect transistors (hereinafter simply referred to as transistors) Q101 and Q102, a current source I101, and resistance elements R112, R113, R114, and R115.

The gate of the transistor Q101 is connected to an input terminal $T_{INA}$ of a signal FinA (output signal of the first phase shifter 1003 or the second phase shifter 1004), the source is connected to a current source I101 via the resistance element R112, and the drain is connected to a supply line of the power supply voltage $V_{DD}$ via the resistance element R113.

Further, the gate of the transistor Q102 is connected to an input terminal $T_{INB}$ of RFinB (received signal branched at the first branch circuit 1001), the source is connected to the current source I101 via the resistance element R114, and the drain is connected to the supply line of the power supply voltage $V_{DD}$ via the resistance element R115. The drain of the transistor Q102 is connected to an output $T_{OUT}$.

At this coupler circuit 1005a (1006a), the received signal is supplied via the input terminal $T_{INB}$ to the gate of the transistor Q102, the local signal receiving the phase shift action is supplied via the input terminal $T_{INA}$ to the gate of the transistor Q101, the two signal components are coupled, and the coupled signal is output from the drain of the transistor Q102.

In such a configuration, the received signal Sr(t) is input to the first signal input terminal $T_{INSr}$. Note that Sr(t) is the voltage of the input terminal $T_{INSr}$ at the time $\underline{t}$. The received signal Sr(t) is supplied to the input terminal I1 of the first branch circuit 1001 and branched to three signals. The branched first received signal is supplied from the first output terminal O1 to the first power detector 1007. The branched second received signal is output from the second output terminal O2 to the first coupler circuit 1005. The branched third received signal is output from the third output terminal O3 to the second coupler circuit 1006.

On the other hand, the local signal Slo(t) is input to the second signal input terminal $T_{INSlo}$. Slo(t) is the voltage of the input terminal $T_{INSlo}$ at the time $\underline{t}$. The local signal Slo(t) is supplied to the input terminal I1 of the second branch circuit 1002 and branched to two signals. The branched first local signal is output from the first output terminal O1 to the first phase shifter 1003. The branched second local signal is output from the second output terminal O2 to the second phase shifter 1004.

The first phase shifter 1003 shifts the phase of the local signal output from the first output terminal O1 of the second branch circuit 1002 by exactly θ1 degrees and outputs the result to the first coupler circuit 1005. The second phase shifter 1004 shifts the phase of the local signal output from the second output terminal O2 of the second branch circuit 1002 by exactly θ2 degrees and outputs the result to the second coupler circuit 1006.

The first coupler circuit 1005 couples the received signal output from the second output terminal O2 of the first branch circuit 1001 and the local signal shifted in phase by exactly θ1 degrees by the first phase shifter 1003 and outputs the result to the second power detector 1008. The second coupler circuit 1006 couples the received signal output from the third output terminal O3 of the first branch circuit 1001 and the local signal shifted in phase by exactly θ2 degrees by the second phase shifter 1004 and outputs the result to the third power detector 1009.

Accordingly, the input of the first power detector 1007 is supplied with the received signal Sr. The first power detector 1007 outputs the amplitude component of the input received signal Sr as the power detection signal P1 to the first multiplier 103 and the second multiplier 104.

Similarly, the input of the second power detector 1008 is supplied with a vector sum signal of the received signal Sr and the local signal Slo given the phase shift θ1. The second power detector 1008 outputs the amplitude component of the input vector sum signal of the received signal Sr and the local signal Slo given the phase shift θ1 as the power detection signal P2 to the first subtractor 105.

Similarly, the input of the third power detector 1009 is supplied with a vector sum signal of the received signal Sr and the local signal Slo given the phase shift θ2. The third power detector 1009 outputs the amplitude component of the input vector sum signal of the received signal Sr and the local signal Slo given the phase shift θ2 as the power detection signal P3 to the second subtractor 106.

Note that the five-port here means the five ports obtained by adding three ports of the output terminal to the first power detector 1007 of the first branch circuit 1001 (first output terminal O1), the output terminal to the second power detector 1008 of the second coupler circuit 1005, and the output terminal to the third power detector 1009 of the second coupler circuit 1006 to two ports of the received signal use input terminal $T_{INSr}$ and the local signal use input terminal $T_{INSlo}$.

Further, the power detection signals (baseband signals) P1, P2, and P3 output from the first to third power detectors 1007 to 1009 include IM2 components (square components of the received signals, interference signals, and local signals).

Here, an explanation will be given of the concrete configuration of a power detector able to be used in the multi-port demodulator.

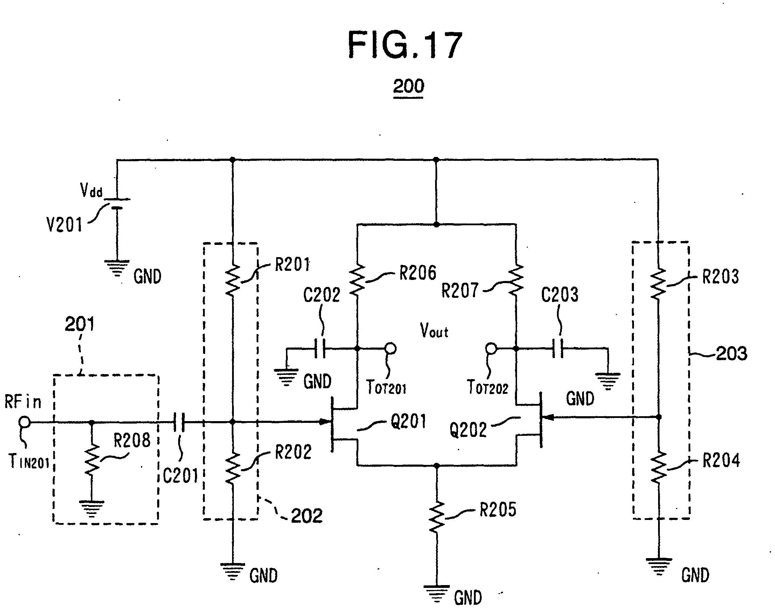

FIG. 17 is a circuit diagram of an example of a power detector according to the present invention.

A power detector 200 (PD1, PD2, PD3) is configured by two first and second transistors (field effect transistors) Q201 and Q202 as active elements, capacitors C201, C202, and C203, resistance elements R201, R202, R203, R204, R205, R206, R207, and R208, a voltage source V201, a matching circuit (MTR) 201, and gate bias supplying circuits 202 and 203.

The matching circuit 201 is configured by the resistance element R208. The resistance element R208 is connected between the connection point of the input terminal $T_{IN201}$ and one electrode of a direct current (DC) cut-off use capacitor C201 and the ground potential GND.

The gate bias supplying circuit 202 is configured by resistance elements R201 and R202 connected in series between the voltage source V201 and the ground potential GND. The connection point of the resistance elements R201 and R202 is connected to the other electrode of the capacitor C201 and the gate of the transistor Q201.

The gate bias supplying circuit 202 having such a configuration divides the resistance of the voltage Vdd of the voltage source V201 by the resistance elements R201 and R202 so as to generate the bias voltage of the transistor Q201.

The gate bias supplying circuit 203 is configured by resistance elements R203 and R204 connected in series between the voltage source V201 and the ground potential GND. The connection point of the resistance elements R203 and R204 is connected to the gate of the transistor Q202.

The gate bias supplying circuit 203 having such a configuration divides the resistance of the voltage Vdd of the voltage source V201 by the resistance elements R203 and R204 so as to generate the bias voltage of the transistor Q202.

Note that it is also possible to configure the gate bias supplying circuit by not resistance division, but for example a choke coil (inductor having a sufficient large inductance value) and a shunt coupling capacitance, or a distribution constant line.

The source of the transistor Q201 and the source of the transistor Q202 are connected. The connection point thereof is connected via the resistance element R205 serving as the current source to the ground potential GND.

The drain of the transistor Q201 is connected to one end of the resistance element R206, one electrode of the capacitor C202, and the first output terminal $T_{OT201}$. The other end of the resistance element R206 is connected to the voltage source V201 of a voltage Vdd, and the other electrode of the capacitor C202 is connected to the ground potential GND.

The drain of the transistor Q202 is connected to one end of the resistance element R207, one electrode of the capacitor C203, and the second output terminal $T_{OT202}$. The other end of the resistance element R207 is connected to the voltage source V201 of the voltage Vdd, and the other electrode of the capacitor C203 is connected to the ground potential GND.

The drain bias voltage is supplied to the drain of the transistor Q201 via the resistance element R206, and the drain bias voltage is supplied to the drain of the transistor Q202 via the resistance element R207.

In the power detector 200 configured with such a connection configuration, the transistors Q201 and Q202 serving as the active elements have the same device structures so as to have, for example, substantially the same characteristics.

Further, in the circuit according to the present embodiment, the resistance values Rga1 and Rgb1 of the resistance elements R201 and R202 and resistance values Rga2 and Rgb2 of the resistance elements R203 and R204 configuring the gate bias supplying circuits 202 and 203 must satisfy the conditions of Rga1=Rga2 and Rgb1=Rgb2 to make the gate bias voltages of the transistors Q201 and Q202 equal as much as possible.

Further, the resistance value Rda of the resistance element R206 and the resistance value Rdb of the resistance element R207 connected to the drains of the transistors Q201 and Q202 satisfy the condition of Rda=Rdb.

Similarly, a capacitance value Couta of the capacitor C202 and a capacitance value Coutb of the capacitor C203 desirably satisfy a condition of Couta=Coutb, the capacitance values Couta and Coutb are set at a sufficiently large value so that the impedance thereof becomes almost 0 ohm at a higher frequency including an input high frequency signal of the input frequency fin.

Alternatively, the power detector 200 is configured so as to satisfy the conditions of Rda/Rdb=1/N and Couta=Coutb when the ratio of the gate width Wga of the transistor Q201 and the gate width Wgb of the transistor Q202 (Wga/Wgb) is N.

Specifically, by setting the gate width Wgb of the transistor Q202 smaller than the gate width Wga of the transistor Q201, then setting the resistance value Rdb of the drain bias use resistance element R207 larger than the resistance value Rda of the resistance element R206, the current consumption can be improved.

For example, by setting the ratio Wga/Wgb between the gate width Wga of the transistor Q201 and the gate width Wgb of the transistor Q202 at N and further setting the resistance value Rdb of the resistance element R207 at N times the resistance value Rda of the resistance element R206, the current consumption can be reduced to (N+1) / (2N) times in comparison with the case where transistors having same characteristics are used as the transistors Q201 and 202.

Next, an explanation will be given of the operation of the power detector having the above configuration.

A high frequency signal RFin input to the input terminal $T_{IN201}$ is supplied via the matching circuit 201 and the DC cut-off use capacitor C201 to the gate of the transistor Q201.

At this time, the gate of the transistor Q201 is supplied with the gate bias voltage generated by the gate bias supplying circuit 202. Similarly, the gate of the transistor Q202 is supplied with the gate bias voltage generated by the gate bias supplying circuit 203.

Further, the drains of the transistors Q201 and Q202 are supplied with drain bias voltages via the resistance elements R206 and R207.

Coupling capacitors C202 and C203 having sufficiently large capacitance values are connected between the drains of the transistors Q201 and Q202 and the ground potential GND, so the drains of the transistors Q201 and Q202 become a stable state in terms of high frequency.

As a result, a voltage difference between the voltage of the drain of the transistor Q201, that is, the voltage of the first output terminal $T_{OT201}$, and the voltage of the drain of the transistor Q202, that is, the second output terminal $T_{OT202}$, is supplied as the detected output signal Vout to a not illustrated following processing circuit.

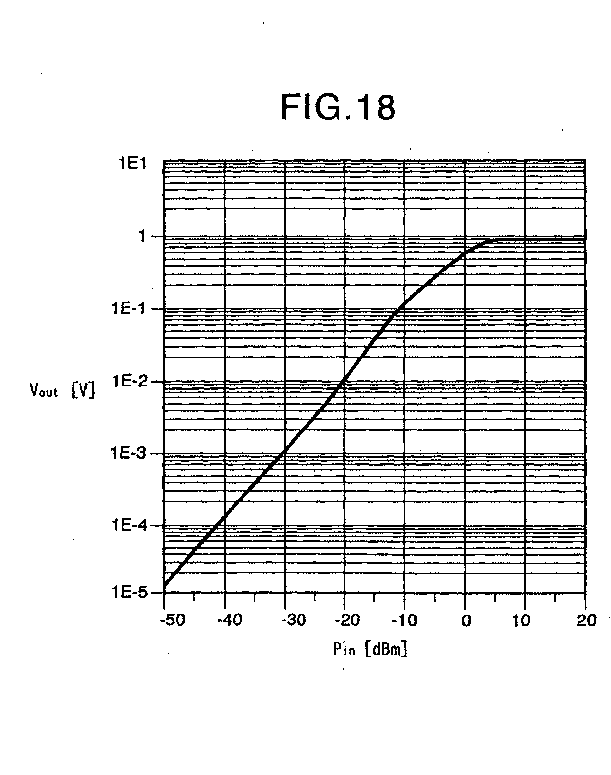

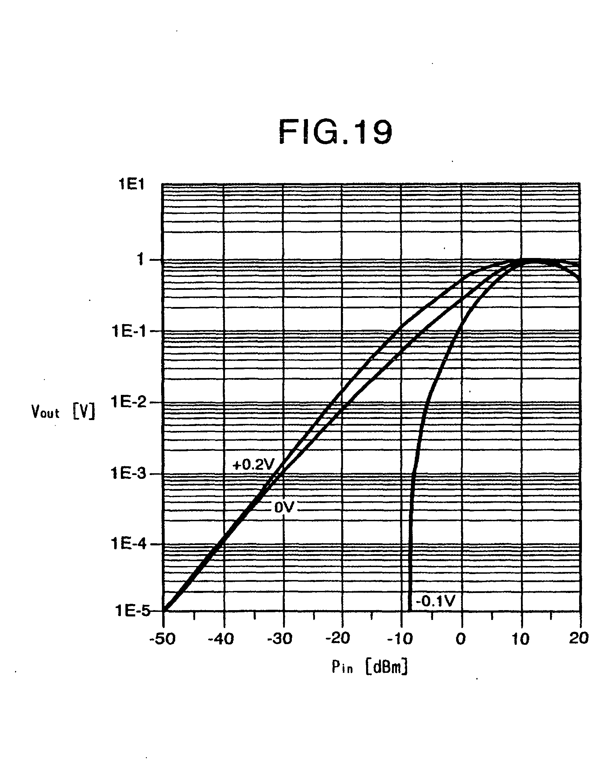

Below, detection characteristics of the power detector of FIG. 17 will be considered in relation to FIG. 18 and FIG. 19.

FIG. 18 is a view of an example of the detection characteristics of the power detector of FIG. 17.

In FIG. 18, the abscissa represents the input high frequency power Pin, and the ordinate represents the output detected voltage Vout. The frequency of the input high frequency signal is 5.5 GHz.

As seen from FIG. 18, the power detector of FIG. 17 has a good linearity.

FIG. 19 is a view of the detection characteristics of the power detector of FIG. 17 when using the gate bias voltage as a parameter.

In FIG. 19 as well, the abscissa represents the input high frequency power Pin, and the ordinate represents the output detected voltage Vout.

From FIG. 19, it will be understood that the fluctuation of the Pin versus Vout characteristic is small with respect to the gate bias fluctuation in the characteristics of the power detector of FIG. 17.

Namely, the power detector of FIG. 17 does not cause a DC offset.

The first multiplier 103 multiplies the power detection signal (baseband signal) P1 output from the first power detector 1007 of the five-port junction circuit 101 by a coefficient A1 $(=(k_{21}/k_{11})^2)$ for canceling the square components of the interference signal and the local signal and outputs the result A1 x P1 $[(k_{21}/k_{11})^2 \cdot P1]$ to the first subtractor 105.

The second multiplier 104 multiplies the power detection signal (baseband signal) P1 output from the first power detector 1007 of the five-port junction circuit 101 by a coefficient A2 $(=(k_{31}/k_{11})^2)$ for canceling the square components of the interference signal and the local signal and outputs the result A2 x P1 $[(k_{31}/k_{11})^2 \cdot P1]$ to the second subtractor 106.

The first subtractor 105 subtracts the multiplication result of the first multiplier 103 from the power detection signal (baseband signal) P2 output from the second power detector 1008 of the five-port junction circuit 101 and outputs the result $[P2-(k_{21}/k_{11})^{2 \cdot} P1]$ to the LPF 107.

The second subtractor 106 subtracts the multiplication result of the second multiplier 104 from the power detection signal (baseband signal) P3 output from the third power detector 1009 of the five-port junction circuit 101 and outputs the result $[P3-(k_{31}/k_{11})^{2 \cdot} P1]$ to the LPF 108.

Note that, here, $k_{ij}$ $(k_{11}, k_{21}, k_{31})$ are the circuit constants of the five-port junction circuit 101 and are defined by the following equation:

$$= \frac{\sqrt{V_{out,i}}}{V_{in,j}} \tag{6}$$

where, $V_{out}$ and $V_{in}$ indicate baseband output voltages of the five-port junction circuit, $i$ indicates an input port number, and $i$ indicates an output port number. The IM2 components included in the baseband signals P1, P2, and P3 are removed by the above analog computation.

The LPF 107 extracts only the desired channel signal from the output signal of the first subtractor 105 and outputs the same to the multi-port signal-to-IQ signal conversion circuit 109.

The LPF 108 extracts only the desired channel signal from the output signal of the second subtractor 106 and outputs the same to the multi-port signal-to-IQ signal conversion circuit 109.

The multi-port signal-to-IQ signal conversion circuit 109 receives the output signals $x_1$ and $x_2$ of the LPFs 107 and 108, performs computations based on the following equation (7) and equation (8) by the computation circuit, and converts the results to an In-phase signal I and a quadrature signal Q as demodulated signals:

$$I = \alpha_1 x_1 + \beta_1 x_2 + \gamma_1 \tag{7}$$

$$Q = \alpha_2 x_1 + \beta_2 x_2 + \gamma_2 \tag{8}$$

where, $\alpha_1$, $\beta_1$, $\gamma_1$, $\alpha_2$, $\beta_2$, and $\gamma_2$ are constants found from the circuit constants provided in the branch circuits 1001 and 1002, the phase shifters 1003 and 1004, the coupler circuits 1005 and 1006, and the power detectors 1007 to 1009 configuring the five-port junction circuit 101 and are given as follows:

$$\alpha_1 = 1/4 k_{21} k_{22} R_0 P_{LO} \cos\theta \tag{9}$$

$$\beta_1 = 1/4 k_{31} k_{32} R_0 P_{LO} \cos\theta \tag{10}$$

$$\gamma_1 = (-k_{22}/4 k_{21} \cos\theta) - (k_{32}/4 k_{31} \cos\theta) \tag{11}$$

$$\alpha_2 = -1/4 k_{21} k_{22} R_0 P_{LO} \sin\theta \tag{12}$$

$$\beta_2 = 1/4 k_{31} k_{32} R_0 P_{LO} \sin\theta \tag{13}$$

$$\gamma_2 = (k_{22}/4 k_{21} \sin\theta) + (k_{32}/4 k_{31} \sin\theta) \tag{14}$$

$R_0$ indicates the impedance of the local signal generation source, $P_{LO}$ indicates the local signal power, and $\theta$ indicates the phases of the phase shifters 1003 and 1004. Note that $\theta = \theta_1 = -\theta_2$ stands. Here, $\theta_1$ indicates the amount of phase shift of 1003, and $\theta_2$ indicates the amount of phase shift of 1004.

Further, the above equation (7) and equation (8) can be modified as follows:

$$I = \frac{1}{4 R_0 P_{LO} \cos\theta}$$

$$[\frac{1}{\kappa_{21} \kappa_{22}} (P_2 - (\frac{\kappa_{21}}{\kappa_{11}})^2 P_1 - \kappa_{22}^2 R_0 P_{LO}) + \frac{1}{\kappa_{31} \kappa_{32}} (P_3 - (\frac{\kappa_{31}}{\kappa_{11}})^2 P_1 - \kappa_{32}^2 R_0 P_{LO})] \tag{15}$$

$$Q=\frac{1}{4R_0 P_{LO}\sin\theta}$$

$$[\frac{1}{\kappa_{21}\kappa_{22}}(P_2-(\frac{\kappa_{21}}{\kappa_{11}})^2 P_1-\kappa_{22}^2 R_0 P_{LO})-\frac{1}{\kappa_{31}\kappa_{32}}(P_3-(\frac{\kappa_{31}}{\kappa_{11}})^2 P_1-\kappa_{32}^2 R_0 P_{LO})] \qquad (16)$$

Next, the operation by the above configuration will be explained in detail.

In the five-port junction circuit 101, the received signal Sr is input to the input terminal $T_{INSr}$, and the local signal Slo generated at the local signal generation circuit 102 is input to the input terminal $T_{INSlo}$.

The received signal Sr is supplied to the input terminal I1 of the first branch circuit 1001 and branched to three signals. The branched first received signal is output from the first output terminal O1 to 'the first power detector 1007, the branched second received signal is output from the second output terminal O2 to the first coupler circuit 1005, and the branched third received signal is output from the third output terminal O3 to the second coupler circuit 1006.

On the other hand, the local signal Slo is supplied to the input terminal I1 of the second branch circuit 1002 and branched to two signals. The branched first local signal is output from the first output terminal O1 to the first phase shifter 1003, and the branched second local signal is output from the second output terminal O2 to the second phase shifter 1004.

The first phase shifter 1003 shifts the phase of the local signal output from the first output terminal O1 of the second branch circuit 1002 by exactly θ1 degrees and outputs the result to the first coupler circuit 1005. The second phase shifter 1004 shifts the phase of the local signal output from the second output terminal O2 of the second branch circuit 100 by exactly θ2 degrees and outputs the result to the second coupler circuit 1006.

Then, the first coupler circuit 1005 couples the received signal output from the second output terminal O2 of the first branch circuit 1001 and the local signal shifted in phase by exactly θ1 degrees by the first phase shifter 1003 and outputs the result to the second power detector 1008. The second coupler circuit 1006 couples the received signal output from the third output terminal O3 of the first branch circuit 1001 and the local signal shifted in phase by exactly θ2 degrees by the second phase shifter 1004 and outputs the same to the third power detector 1009.

The input of the first power detector 1007 is supplied with the received signal Sr. The first power detector 1007 outputs the amplitude component of the input received signal Sr as the power detection signal P1 to the first multiplier 103 and the second multiplier 104.

Further, the input of the second power detector 1008 is supplied with a vector sum signal of the received signal Sr and the local signal Slo given the phase shift θ1. The second power detector 1008 outputs the amplitude component of the input vector sum signal of the received signal Sr and the local signal Slo given the phase shift θ1 as the power detection signal P2 to the first subtractor 105.

Further, the input of the third power detector 1009 is supplied with a vector sum signal of the received signal Sr and the local signal Slo given the phase shift θ2. The third power detector 1009 outputs the amplitude component of the input vector sum signal of the received signal Sr and the local signal Slo given the phase shift θ2 as the power detection signal P3 to the second subtractor 106.

Note that the power detection signals (baseband signals) P1, P2, and P3 output from the first to third power detectors 1007 to 1009 include IM2 components (square components of the received signals, the interference signals, and the local signals).

The first multiplier 103 multiplies the power detection signal P1 output from the first power detector 1007 of the five-port junction circuit 101 by the coefficient A1 $(=(k_{21}/k_{11})^2)$ for canceling the square components of the interference signal and the local signal. Then, the multiplication result A1 x P1 $[(k_{21}/k_{11})^2 \cdot P1]$ is output from the first multiplier 103 to the first subtractor 105.

Similarly, the second multiplier 104 multiplies the power detection signal P1 output from the first power detector 1007 of the five-port junction circuit 101 by the coefficient A2 $(=(k_{31}/k_{11})^2)$ for canceling the square components of the interference signal and the local signal. Then, the multiplication result A2 x P1 $[(k_{31}/k_{11})^2 \cdot P1]$ is output from the second multiplier 104 to the second subtractor 106.

The first subtractor 105 subtracts the multiplication result of the first multiplier 103 from the power detection signal P2 output from the second power detector 1008 of the five-port junction circuit 101. Then, the subtraction result $[P2-(k_{21}/k_{11})^2 \cdot P1]$ is output from the first subtractor 105 to the LPF 107.

Further, the second subtractor 106 subtracts the multiplication result of the second multiplier 104 from the power detection signal P3 output from the third power detector 1009 of the five-port junction circuit 101. Then, the subtraction result $[P3-(k_{31}/k_{11})^2 \cdot P1]$ is output from the second subtractor 106 to the LPF 108.

The LPF 107 extracts only the desired channel signal from the output signal of the first subtractor 105 and outputs the same to the multi-port signal-to-IQ signal conversion circuit 109. Similarly, the LPF 108 extracts only the desired channel signal from the output signal of the second subtractor 106 and outputs the same to the multi-port signal-to-IQ signal conversion circuit 109.

The multi-port signal-to-IQ signal conversion circuit 109 receives the output signals $x_1$ and $x_2$ of the LPF 107 and the LPF 108, performs computations based on the following equation (17) and equation (18), and converts the same to an In-phase signal I and a quadrature signal Q as demodulated signals

$$I = \alpha_1 x_1 + \beta_1 x_2 + \gamma_1 \tag{17}$$

$$Q = \alpha_2 x_1 + \beta_2 x_2 + \gamma_2 \tag{18}$$

As explained above, using the circuit of the present invention, the square components of the interference signal and the local signal are removed from the received signal, and thus high performance demodulated signals I and Q can be obtained.

As explained above, according to the present embodiment, since provision is made of the five-port junction circuit 101 receiving the received signal Sr and the local signal Slo generated at the local signal generation circuit 102, generating three signals having a phase difference, and detecting the signal levels (amplitude components) of these signals to obtain three power detection signals (baseband signals) P1, P2, and P3; the first multiplier 103 for multiplying the power detection signal P1 output from the first power detector 107 of the five-port junction circuit 101 by the coefficient A1 ($=(k_{21}/k_{11})^2$) for canceling the square components of the interference signal and the local signal; the second multiplier 104 for multiplying the power detection signal P1 output from the first power detector 107 by the coefficient A2 ($=(k_{31}/k_{11})^2$) for canceling the square components of the interference signal and the local signal; the first subtracter 105 for subtracting the multiplication result of the first multiplier 103 from the power detection signal P2 output from the second power detector 1008 of the five-port junction circuit 101; and the second subtractor 106 for subtracting the multiplication result of the second multiplier 104 from the power detection signal P3 output from the third power detector 1009 of the five-port junction circuit 101, the present invention not only contributes to the wide band property and the reduction of the local signal power, which are characteristic features of a multi-port demodulator, but also has the following characteristic features in comparison with the conventional multi-port demodulator.

Namely, a demodulator having a low power consumption, a low distortion, a wide band property, and high performance demodulation performance in comparison with a conventional multi-port demodulator can be realized.

Further, it can be configured by three power detectors, one one-input three-output coupler circuit, one one-input two-output coupler circuit, and two phase shifters, therefore there are the advantages that the circuit configuration can be simplified more than the conventional circuit and the increase of the circuit size can be prevented.

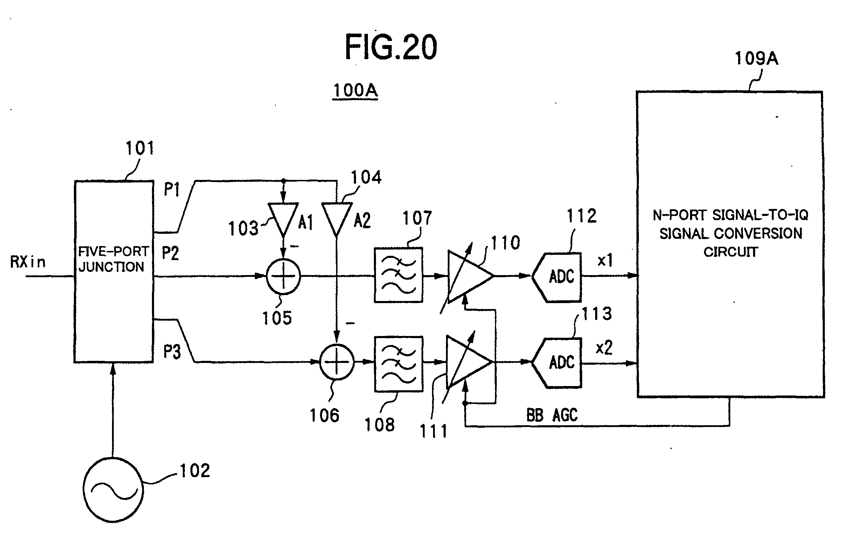

FIG. 20 is a block diagram of a demodulator of the direct conversion system according to a second embodiment of the present invention.

In FIG. 20, the same components as those of the multi-port demodulator of FIG. 3 are represented by the same reference numerals.

The difference of the demodulator 100A of FIG. 20 from the demodulator 100 of FIG. 3 resides in that the processing of a multi-port signal-to-IQ signal conversion circuit 109A is carried out not by analog processing, but by digital signal processing, and a control signal BBAGC for controlling the gain of the added variable gain amplifiers is generated.

Specifically, as shown in FIG. 20, the variable gain amplifiers 110 and 111 are connected to the outputs of the LPF 107 and the LPF 108, the ADC 112 is connected to the output of the variable gain amplifier 110, and the ADC 113 is connected to the output of the variable gain amplifier 111. Then, the digital signal X1 from the ADC 112 and the digital signal X2 from the ADC 113 are input to the multi-port signal-to-IQ signal conversion circuit 109A.

The demodulator 100A processes the power detection signals (baseband signals) P1, P2, and P3 output from the first to third power detectors 1007 to 1009 of the five-port junction circuit 101 including the IM2 components (square components of the received signals, the interference signals, and the local signals) in the same way as in the first embodiment by analog computations in the first and second multipliers 103 and 104 and the first and second subtractors 105 and 106, removes the square components of the interference signals and the local signals from the received signals, and inputs the results to the LPF 107 and the LPF 108.

The LPF 107 extracts only the desired channel signal from the output signal of the first subtractor 105 and outputs the same to the variable gain amplifier 110. Similarly, the LPF 108 extracts only the desired channel signal from the output signal of the second subtractor 106 and outputs the same to the variable gain amplifier 111.

The variable gain amplifier 110 adjusts the level of the output signal of the LPF 107 based on the control signal BBAGC generated at the digital processing system, that is, the multi-port signal-to-IQ signal conversion circuit 109A, so that the dynamic range of the ADC 112 of the following stage can be effectively used and outputs the result to the ADC 112.

Further, the variable gain amplifier 111 adjusts the level of the output signal of the LPF 108 based on the control signal BBAGC generated at the digital processing system, that is, the multi-port signal-to-IQ signal conversion circuit 109A, so that the dynamic range of the ADC 113 of the following stage can be effectively used and outputs the same to the ADC 113.

The ADC 112 converts the analog signal level adjusted at the variable gain amplifier 111 to the digital signal X1 and outputs the result to the multi-port signal-to-IQ signal conversion circuit 109A.

Similarly, the ADC 113 converts the analog signal level adjusted at the variable gain amplifier 111 to the digital signal X2 and outputs the result to the multi-port signal-to-IQ signal conversion circuit 109A.

The multi-port signal-to-IQ signal conversion circuit 109A receives the output digital signals $X_1$ and $X_2$ of the ADCs 112 and 113, performs computations based on the following equation (19) and equation (20) in the computation circuit, and converts the results to an In-phase signal I and a quadrature signal Q as demodulated signals:

$$I = \alpha_1 X_1 + \beta_1 X_2 + \gamma_1 \qquad (19)$$

$$Q = \alpha_2 X_1 + \beta_2 X_2 + \gamma_2 \qquad (20)$$

where, $\alpha_1$, $\beta_1$, $\gamma_1$, $\alpha_2$, $\beta_2$, and $\gamma_2$ are constants found from the circuit constants provided in the branch circuits 1001 and 1002, the phase shifters 1003 and 1004, the coupler circuits 1005 and 1006, and the power detectors 1007 to 1009 configuring the five-port junction circuit 101 and are given as follows:

$$\alpha_1 = 1/4 k_{21} k_{22} R_0 P_{LO} \cos\theta \qquad (21)$$

$$\beta_1 = 1/4 k_{31} k_{32} R_0 P_{LO} \cos\theta \qquad (22)$$

$$\gamma_1 = (-k_{22}/4 k_{21} \cos\theta) - (k_{32}/4 k_{31} \cos\theta) \qquad (23)$$

$$\alpha_2 = -1/4 k_{21} k_{22} R_0 P_{LO} \sin\theta \qquad (24)$$

$$\beta_2 = 1/4 k_{31} k_{32} R_0 P_{LO} \sin\theta \qquad (25)$$

$$\gamma_2 = (k_{22}/4 k_{21} \sin\theta) + (k_{32}/4 k_{31} \sin\theta) \qquad (26)$$

According to the present second embodiment, a demodulator having a low power consumption, a low distortion, a wide band characteristic, and a high demodulation performance in comparison with the conventional multi-port demodulator can be realized.

Note that, this digital part, that is, the multi-port signal-to-IQ signal conversion circuit 109A, can be realized by a DSP, an FPGA, a logic circuit, or the like.

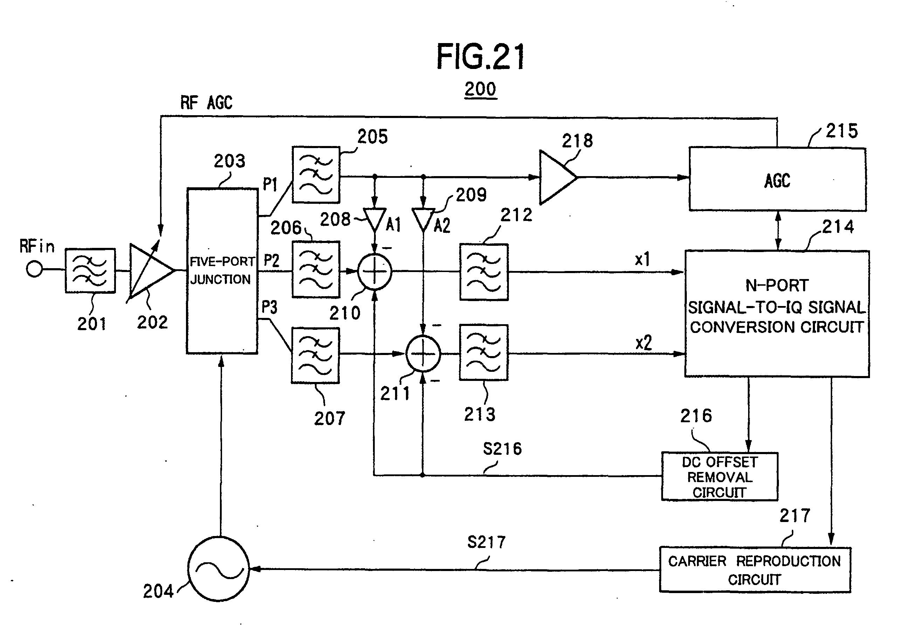

FIG. 21 is a block diagram of a receiver employing the demodulator of the direct conversion system according to a third embodiment of the present invention.

The present receiver 200 has, as shown in FIG. 21, a band pass filter (BPF) 201, a variable gain circuit (LNA) 202, a five-port junction circuit 203, a local signal generation circuit 204, LPFs 205 to 207, a first multiplier 208, a second multiplier 209, a first subtractor 210, a second subtractor 211, LPFs 212 and 213 for channel selection, a multi-port signal-to-IQ signal conversion circuit 214, a gain control signal generation circuit (AGC) 215, a DC offset removal circuit 216, a carrier reproduction circuit 217, and an amplifier 218.

The BPF 201 extracts the signal of the predetermined band from among the signals received at a not illustrated antenna element and outputs the same to the variable gain circuit 202.

The variable gain circuit 202 adjusts the level of the received signal via the BPF 201 to a level in accordance with the control signal RFAGC from the gain control signal generation circuit 215 and outputs the result to the five-port junction circuit 203.

The five-port junction circuit 203 receives the received signal Sr and the local signal Slo generated at the local signal generation circuit 204, generates three signals having a phase difference, detects the signal levels (amplitude components) of these signals to obtain three power detection signals (baseband signals) P1, P2, and P3, outputs the power detection signal P1 to the LPF 205, outputs the power detection signal P2 to the LPF 206, and outputs the power detection signal P3 to the LPF 207.

This five-port junction circuit 203 is configured by similar circuits to the circuits explained in relation to FIG. 4 in the first embodiment, but here, an explanation will be given of the five-port junction circuit 203 having another configuration.

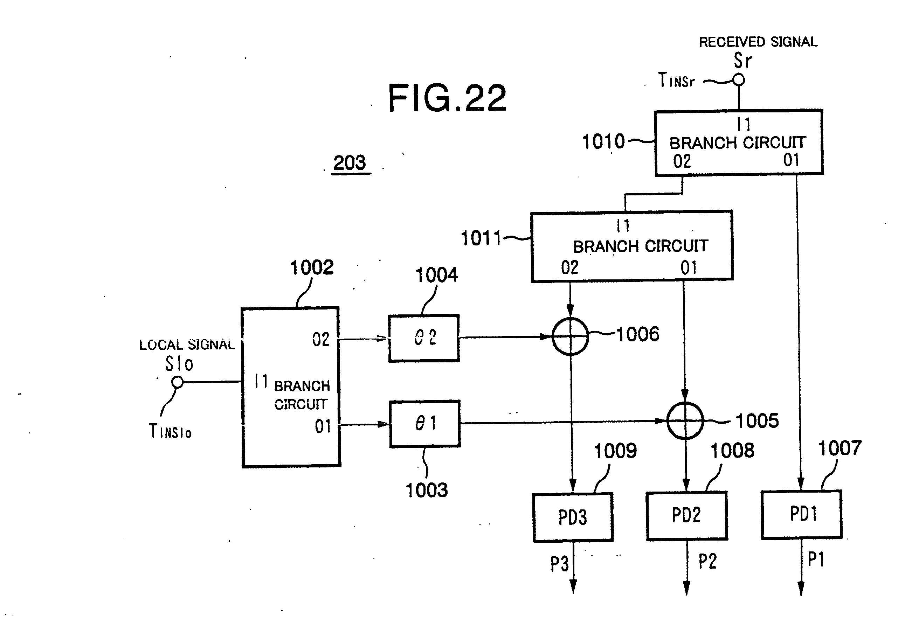

FIG. 22 is a block diagram of a concrete example of the configuration of the five-port junction circuit 203.

In FIG. 22, the same components as those of FIG. 4 are represented by the same reference numerals.

The difference of the five-port junction circuit 203 of FIG. 22 from the five-port junction circuit 101 of FIG. 4 resides in that a configuration of cascade connection of one-input two-output branch circuits 1010 and 1011 in place of one-input three-output branch circuits is employed for the first branch circuit 1001C.

Specifically, the input terminal I1 of the branch circuit (first branch circuit) 1010 is connected to the received signal use signal input terminal $T_{INSr}$, the branch circuit 1010 branches the received signal input via the input terminal I1 to two signals, and the branch circuit 1010 supplies the branched first received signal from the first output terminal O1 to the first power detector 1007. The branch circuit 1010 outputs the branched second received signal from the second output terminal O2 to the branch circuit 1011.

The branch circuit (second branch circuit) 1011 branches the second received signal input through the input terminal 11 to two signals. The branch circuit 1011 outputs the branched third received signal from the first output terminal O1 to the first coupler circuit 1005. The branch circuit 1011 outputs the branched fourth received signal from the second output terminal O2 to the second coupler circuit 1006.

In the five-port junction circuit 203 having such a configuration, the received signal Sr is input to the first signal input terminal $T_{INSr}$. The received signal Sr is supplied to the input terminal I1 of the branch circuit 1010 and branched to two signals. The branched first received signal is supplied from the first output terminal O1 to the first power detector 1007. The branched second received signal is output from the second output terminal O2 to the input terminal I1 of the branch circuit 1011.

The branch circuit 1011 branches the branched received signal input through the input terminal I1 to two signals. The branched third received signal is output from the first output terminal O1 to the first coupler circuit 1005. The branched fourth received signal is output from the second output terminal O2 to the second coupler circuit 1006.

On the other hand, the local signal Slo is input to the second signal input terminal $T_{INSlo}$. The local signal Slo is supplied to the input terminal I1 of the second branch circuit 1002 and branched to two signals. The branched first local signal is output from the first output terminal O1 to the first phase shifter 1003. The branched second local signal is output from the second output terminal O2 to the second phase shifter 1004.

The first phase shifter 1003 shifts the phase of the local signal output from the first output terminal O1 of the second branch circuit 1002 by exactly θ1 degrees and outputs the result to the first coupler circuit 1005. The second phase shifter 1004 shifts the phase of the local signal output from the second output terminal O2 of the second branch circuit 1002 by exactly θ2 degrees and outputs the result to the second coupler circuit 1006.

Then, the first coupler circuit 1005 couples the received signal output from the first output terminal O1 of the first branch circuit 1011 and the local signal shifted in phase by exactly θ1 degrees by the first phase shifter 1003 and outputs the result to the second power detector 1008. The second coupler circuit 1006 couples the received signal output from the second output terminal O2 of the first branch circuit 1011 and the local signal shifted in phase by exactly θ2 degrees by the second phase shifter 1004 and outputs the result to the third power detector 1009.

Accordingly, the input of the first power detector 1007 is supplied with the received signal Sr. The first power detector 1007 outputs the amplitude component of the input received signal Sr as the power detection signal P1 to the LPF 205.

Similarly, the input of the second power detector 1008 is supplied with the vector sum signal of the received signal Sr and the local signal Slo given the phase shift θ1. The second power detector 1008 outputs the amplitude component of the input vector sum signal of the received signal Sr and the local signal Slo given the phase shift θ1 as the power detection signal P2 to the LPF 206.

The input of the third power detector 1009 is supplied with the vector sum signal of the received signal Sr and the local signal Slo given the phase shift θ2. The third power detector 1009 outputs the amplitude component of the input vector sum signal of the received signal Sr and the local signal Slo given the phase shift 92 as the power detection signal P3 to the LPF 207.

Note that the first to third power detectors 1007 to 1009 are configured by similar circuits as those explained in relation to for example FIG. 17 in the first embodiment, so a detailed explanation thereof is omitted here.

The local signal generation circuit 204 generates the local signal Slo of the predetermined frequency and supplies the same to the five-port junction circuit 203. Further, the local signal generation circuit 204 receives the reproduction signal S217 by the carrier reproduction circuit 217 and adjusts the frequency and signal level of the local signal Slo. By this, the local signal generation circuit 204 generates the local signal S1o having an oscillation frequency substantially equal to the received signal frequency.

The LPF 205 removes the high frequency component of the power detection signal (baseband signal) P1 output from the first power detector 1007 of the five-port junction circuit 203 and outputs the result to the first multiplier 208, the second multiplier 209, and the amplifier 218.

The LPF 206 removes the high frequency component of the power detection signal (baseband signal) P2 output from the second power detector 1008 of the five-port junction circuit 203 and outputs the result to the first subtractor 210.

The LPF 207 removes the high frequency component of the power detection signal (baseband signal) P3 output from the third power detector 1009 of the five-port junction circuit 203 and outputs the result to the second subtractor 211.

The first multiplier 208 multiplies the power detection signal (baseband signal) P1 removed of its high frequency component by the LPF 205 by the coefficient A1 ($=(k_{21}/k_{11})^2$) for canceling the square components of the interference signal and the local signal and outputs the result A1 x P1 [$(k_{21}/k_{11})^2 \cdot P1$] to the first subtractor 210.

The second multiplier 209 multiplies the power detection signal (baseband signal) P1 removed of its high frequency component by the LPF 205 by the coefficient A2 ($=(k_{31}/k_{11})^2$) for canceling the square components of the interference signal and the local signal and outputs the result A2 x P1 [$(k_{31}/k_{11})^2 \cdot P1$] to the second subtractor 211.

The first subtractor 210 subtracts the multiplication result of the first multiplier 208 from the power detection signal (baseband signal) P2 removed of its high frequency component by the LPF 206, further subtracts or adds the DC offset amount which was generated at the DC offset removal circuit 216 and supplied as a signal S216 with respect to the subtraction result [$P2-(k_{21}/k_{11})^2 \cdot P1$], and outputs the result to the LPF 212.

The second subtractor 211 subtracts the multiplication result of the second multiplier 209 from the power detection signal (baseband signal) P3 removed of its high frequency component by the LPF 207, further subtracts or adds the DC offset amount which was generated at the DC offset removal circuit 216 and supplied as the signal S216 with respect to the subtraction result [$P3-(k_{31}/k_{11})^2 \cdot P1$], and outputs the result to the LPF 213.

Note that, here, $k_{ij}$ ($k_{11}$, $k_{21}$, $k_{31}$) are circuit constants of the five-port junction circuit 203 and are defined by the following equation:

$$\kappa_5 = \frac{\sqrt{V_{out,i}}}{V_{in,f}} \tag{27}$$

where, $V_{out}$ and $V_{in}$ indicate the baseband output voltages of the five-port junction circuit, i indicates the input port number, and i indicates the output port number.

Note that, the present embodiment is configured so that the addition or the subtraction for removing the DC offset amount is carried out in addition to the subtraction processing for removing the IM2 components at the first subtractor 210 and the second subtractor 211, but it is also possible to perform the subtraction processing for removing the IM2 components in the first subtractor 210 and the second subtractor 211 and provide a processor for removing the DC offset amount in the following stage.

Here, an explanation will be given of the DC offset amount to be removed.

**1)** Removal of DC Offset Amount Generated by Local Signal

As shown in the above equation (4), the output of a power detector includes a DC component due to the local signal. From the above equations (10) and (11), the DC component to be removed can be found from the following equation so far as the local signal level is a known value:

$$k_{22}{}^2 R_0 P_{LO} \text{ and } k_{32}{}^2 R_0 P_{LO} \tag{28}$$

2) Removal of DC Offset Amount Occurring due to Incompleteness of Circuit

The DC offset caused by incompleteness of the circuit such as mismatch of the characteristics of the three power detectors 1007 to 1009 and the reflection of the local leakage signal is removed.

The signal S216 is supplied to the first subtractor 210 and the second subtractor 211 so as to remove these DC offset amounts.

The IM2 components and the DC offset amounts included in the baseband signals P1, P2, and P3 are removed by the above analog operation.

The LPF 212 extracts only the desired channel signal from the output signal of the first subtractor 210 and outputs the same to the multi-port signal-to-IQ signal conversion circuit 214.

The LPF 213 extracts only the desired channel signal from the output signal of the second subtractor 211 and outputs the same to the multi-port signal-to-IQ signal conversion circuit 214.

The multi-port signal-to-IQ signal conversion circuit 214 receives the output signals $x_1$ and $x_2$ of the LPFs 212 and 213, performs computations based on the following equation (29) and equation (30) by the computation circuit, and converts the results to an In-phase signal I and a quadrature signal Q as demodulated signals:

$$I = \alpha_1 x_1 + \beta_1 x_2 + \gamma_1 \tag{29}$$

$$Q = \alpha_2 x_1 + \beta_2 x_2 + \gamma_2 \tag{30}$$

where, $\alpha_1$, $\beta_1$, $\gamma_1$, $\alpha_2$, $\beta_2$, and $\gamma_2$ are constants found from the circuit constants provided in the branch circuits 1002, 1010, and 1011, the phase shifters 1003 and 1004, the coupler circuits 1005 and 1006, and the power detectors 1007 to 1009 configuring the five-port junction circuit 203.

Note that equation (29) and equation (30) are equations when the removal of the DC offset amount generated due to the local signal mentioned above does not work. When removal of the DC offset works, $\gamma_1 = \gamma_2 = 0$ stands and the following equations are used:

$$I = \alpha_1 x_1 + \beta_1 x_2 \tag{31}$$

$$Q = \alpha_2 x_1 + \beta_2 x_2 \tag{32}$$

where, when $\theta_1 = -\theta_2 = \theta$, the coefficients $\alpha_1$, $\beta_1$, $\gamma_1$, $\alpha_2$, $\beta_2$, and $\gamma_2$ are given as follows:

$$\alpha_1 = 1/4 k_{21} k_{22} R_0 P_{LO} \cos\theta \tag{33}$$

$$\beta_1 = 1/4 k_{31} k_{32} R_0 P_{LO} \cos\theta \tag{34}$$

$$\gamma_1 = (-k_{22}/4 k_{21} \cos\theta) - (k_{32}/4 k_{31} \cos\theta) \tag{35}$$

$$\alpha_2 = -1/4 k_{21} k_{22} R_0 P_{LO} \sin\theta \tag{36}$$

$$\beta_2 = 1/4 k_{31} k_{32} R_0 P_{LO} \sin\theta \tag{37}$$

$$\gamma_2 = (k_{22}/4 k_{21} \sin\theta) + (k_{32}/4 k_{31} \sin\theta) \tag{38}$$

$R_0$ indicates the impedance of the local signal generation source, $P_{LO}$ indicates the local signal power, and $\theta$ indicates the phases of the phase shifters 1003 and 1004.

The gain control signal generation circuit 215 finds a mean signal power of the received signals based on the power detection signal P1 from the first power detector 1007 of the five-port junction circuit 203 removed of its high frequency component at the LPF 205 and adjusted in level at the amplifier 218 and outputs the control signal RFAGC to the variable gain circuit 202 so that the received signal levels input to the five-port junction circuit 203 become constant and the optimum operation is carried out based on the found mean power. Note that, here, the optimum operation means that the operation state of the circuit exists in a sufficiently linear region and at a level where also a sufficient SN ratio can be obtained.

The DC offset removal circuit 216 stores the signal level of the known local signal Slo in a memory, finds the average of the demodulated signals of the multi-port signal-to-IQ signal conversion circuit 214, calculates the DC offset amount to be removed based on this average result, the signal level stored in the memory, and the above equation (28), and outputs the signal S216 for removing the DC offset to the first subtractor 210 and the second subtractor 211.

The carrier reproduction circuit 217 reproduces the carrier signal based on the demodulated signals of the multi-port signal-to-IQ signal conversion circuit 214 and outputs the reproduction signal S217 for adjusting the frequency and the level of the local signal to the local signal generation circuit 204.

Next, the operation by the configuration of FIG. 21 described above will be explained in detail.

A signal of a predetermined band is extracted from the signal received at a not illustrated antenna element at the BPF 201. Further, a received signal Sr adjusted to a predetermined level at the variable gain circuit 202 is input to the input terminal $T_{INSr}$ of the five-port junction circuit 203. Further, the local signal Slo generated at the local signal generation circuit 204 is input to the input terminal $T_{INSlo}$ of the five-port junction circuit 203.

In the five-port junction circuit 203, the received signal Sr is supplied to the input terminal I1 of the branch circuit 1010 and branched to two signals. The branched first received signal is supplied from the first output terminal O1 to the first power detector 1007. The branched second received signal is output from the second output terminal O2 to the input terminal I1 of the branch circuit 1011.

The branch circuit 1011 branches the branched received signal input through the input terminal I1 to two signals. The branched third received signal is output from the first output terminal O1 to the first coupler circuit 1005. The branched fourth received signal is output from the second output terminal O2 to the second coupler circuit 1006.

On the other hand, the local signal Slo is input to the second signal input terminal $T_{INSlo}$. The local signal Slo is supplied to the input terminal I1 of the second branch circuit 1002 and branched to two signals. The branched first local signal is output from the first output terminal O1 to the first phase shifter 1003. The branched second local signal is output from the second output terminal O2 to the second phase shifter 1004.

The first phase shifter 1003 shifts the phase of the local signal output from the first output terminal O1 of the second branch circuit 1002 by exactly θ1 degrees and outputs the result to the first coupler circuit 1005. The second phase shifter 1004 shifts the phase of the local signal output from the second output terminal O2 of the second branch circuit 1002 by exactly θ2 degrees and outputs the result to the second coupler circuit 1006.

Then, the first coupler circuit 1005 couples the received signal output from the first output terminal O1 of the first branch circuit 1011 and the local signal shifted in phase by exactly θ1 degrees by the first phase shifter 1003 and outputs the result to the second power detector 1008. The second coupler circuit 1006 couples the received signal output from the second output terminal O2 of the first branch circuit 1011 and the local signal shifted in phase by exactly θ2 degrees by the second phase shifter 1004 and outputs the result to the third power detector 1009.

Accordingly, the input of the first power detector 1007 is supplied with the received signal Sr. The first power detector 1007 outputs the amplitude component of the input received signal Sr as the power detection signal P1 to the LPF 205.

Similarly, the input of the second power detector 1008 is supplied with the vector sum signal of the received signal Sr and the local signal Slo given the phase shift θ1. The second power detector 1008 outputs the amplitude component of the input vector sum signal of the received signal Sr and the local signal Slo given the phase shift θ1 as the power detection signal P2 to the LPF 206.

The input of the third power detector 1009 is supplied with the vector sum signal of the received signal Sr and the local signal Slo given the phase shift θ2. The third power detector 1009 outputs the amplitude component of the input vector sum signal of the received signal Sr and the local signal Slo given the phase shift θ2 as the power detection signal P3 to the LPF 207.

Note that the power detection signals (baseband signals) P1, P2, and P3 output from the first to third power detectors 1007 to 1009 include the IM2 components (square components of the received signals, the interference signals, and the local signals) and the DC offsets generated due to the local signals and the DC offsets derived from the incompleteness of the power detectors.

The LPF 205 removes the high frequency component of the power detection signal P1 output from the first power detector 1007 of the five-port junction circuit 203 and outputs the result to the first multiplier 208, the second multiplier 209, and via the amplifier 218 to the gain control signal generation circuit 215.

Further, the LPF 206 removes the high frequency component of the power detection signal P2 output from the second power detector 1008 of the five-port junction circuit 203 and outputs the result to the first subtractor 210, and the LPF 207 removes the high frequency component of the power detection signal P3 output from the third power detector 1009 of the five-port junction circuit 203 and outputs the result to the second subtractor 211.

The first multiplier 208 multiplies the power detection signal P1 removed of its high frequency component by the LPF 205 by the coefficient A1 $(=(k_{21}/k_{11})^2)$ for canceling the square components of the interference signal and the local signal. Then, the multiplication result A1 x P1 [$(k_{21}/k_{11})^2 \cdot P1$] is output to the first subtractor 210.

The second multiplier 209 multiplies the power detection signal P1 removed of its high frequency component by the LPF 205 by the coefficient A2 ($=(k_{31}/k_{11})^2$) for canceling the square components of the interference signal and the local signal. Then, the multiplication result A2 x P1 [$(k_{31}/k_{11})^2 \cdot P1$] is output to the second subtractor 211.

The first subtractor 210 subtracts the multiplication result of the first multiplier 208 from the power detection signal P2 removed of its high frequency component by the LPF 206. The first subtractor 210 further subtracts or adds the DC offset amount which was generated at the DC offset removal circuit 216 and supplied as the signal S216 with respect to the subtraction result [ P2-$(k_{21}/k_{11})^2 \cdot P1$]. By this, the first subtractor 210 outputs the signal removed of its IM2 components and the DC offset generated due to the local signal and the DC offset derived from the incompleteness of the power detectors to the LPF 212.

The second subtractor 211 subtracts the multiplication result of the second multiplier 209 from the power detection signal P3 removed of its high frequency component by the LPF 207. The second subtractor 211 further subtracts or adds the DC offset amount which was generated at the DC offset removal circuit 216 and supplied as the signal S216 with respect to the subtraction result [P3-$(k_{31}/k_{11})^2 \cdot P1$]. By this, the second subtractor 211 outputs the signal removed of its IM2 components and the DC offset generated due to the local signal and the DC offset derived from the incompleteness of the power detectors to the LPF 213.

The LPF 212 extracts only the desired channel signal from the output signal of the first subtractor 210 and outputs the same to the multi-port signal-to-IQ signal conversion circuit 214. Similarly, the LPF 213 extracts only the desired channel signal from the output signal of the second subtractor 211 and outputs the same to the multi-port signal-to-IQ signal conversion circuit 214.

The multi-port signal-to-IQ signal conversion circuit 214 receives the output signals $x_1$ and $x_2$ of the LPFs 212 and 213, performs computations based on the following equation (39) and equation (40) at the computation circuit, and converts the results to an In-phase signal I and a quadrature signal Q as demodulated signals:

$$I = \alpha_1 x_1 + \beta_1 x_2 \tag{39}$$

$$Q = \alpha_2 x_1 + \beta_2 x_2 \tag{40}$$

As explained above, using the circuit of the present embodiment, the square components of the interference signal and the local signal are removed from the received signal and thus high performance demodulated signals I and Q removed of their DC offsets can be obtained.

Further, the gain control signal generation circuit 215 receives the power detection signal P1 of the first power detector 1007 of the five-port junction circuit 203 to compute the mean signal power. Then, based on the found mean power, the control signal RFAGC is output to the variable gain circuit 202 so that the received signal levels input to the five-port junction circuit 203 become constant.

Then, the variable gain circuit 202 adjusts the level of the received signal received at the not illustrated antenna element and via the BPF 201 to a level in accordance with the control signal RFAGC by the gain control signal generation circuit 215 and supplies the result to the five-port junction circuit 203.

Further, the carrier reproduction circuit 217 receiving the output demodulated signals I and Q of the multi-port signal-to-IQ signal conversion circuit 214 reproduces the carrier signal, generates the reproduction signal S217 for adjusting the frequency and the level of the local signal, and outputs the same to the local signal generation circuit 204.

The local signal generation circuit 204 receives the reproduction signal S217 from the carrier reproduction circuit 217, adjusts the frequency and the signal level of the local signal Slo, and supplies the result to the five-port junction circuit 203.

As explained above, according to the present second embodiment, high performance demodulated signals I and Q comprised of the received signal removed of the square components of the interference signal and the local signal and stripped of the DC offset can be obtained.

Further, there is the advantage that a high performance receiver not only contributing to the wide band property, the low distortion characteristic, and the reduction of the local signal power, which are characteristic features of a multi-port demodulator, but also having a small fluctuation of characteristics with respect to temperature fluctuations and aging can be realized.

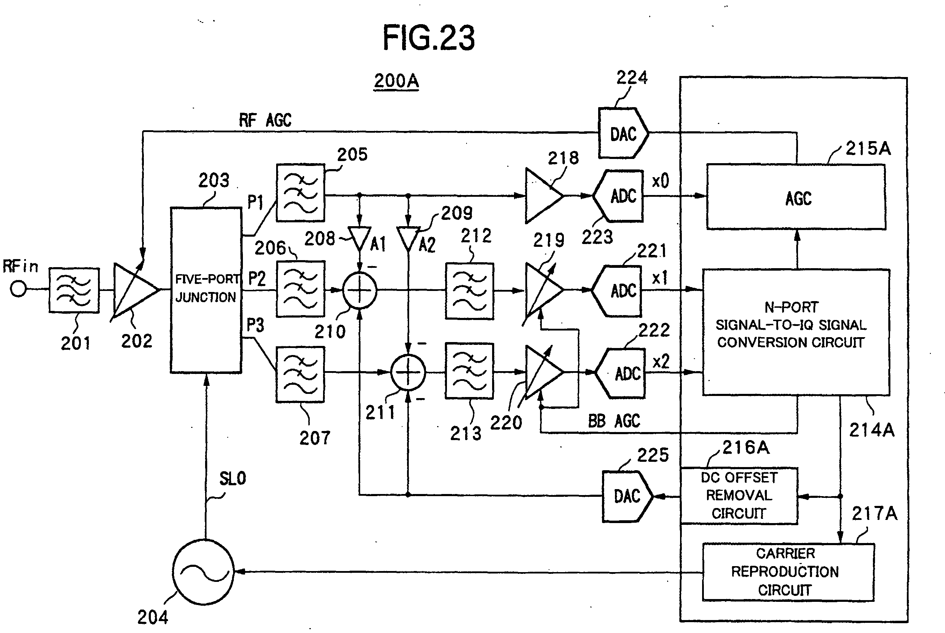

FIG. 23 is a block diagram of a receiver employing a demodulator of the direct conversion system according to a fourth embodiment of the present invention.

In FIG. 23, the same components as those of the receiver of FIG. 21 are represented by the same reference numerals.

The difference of the receiver 200A of FIG. 23 from the receiver 200 of FIG. 21 resides in that the processing of the multi-port signal-to-IQ signal conversion circuit 214A, a gain control signal generation circuit 215A, a DC offset removal circuit 216A, and a carrier reproduction circuit 217A is carried out not by analog processing, but by digital signal processing and in that a control signal BBAGC for controlling the gain of the added variable gain amplifier is generated.

Specifically, as shown in FIG. 23, the variable gain amplifiers 219 and 220 are connected to the outputs of the LPF 212 and the LPF 213, the ADC 221 is connected to the output of the variable gain amplifier 219, and the ADC 222 is connected to the output of the variable gain amplifier 220. Then, the digital signal X1 from the ADC 221 and the digital signal X2 from the ADC 222 are input to the multi-port signal-to-IQ signal conversion circuit 214A. Further, the ADC 223 is connected to the output of the amplifier 218, and a digital signal X0 of the power detection signal P1 from the ADC 223 is input to the gain control signal generation circuit 215A. Further, a digital/analog converter (DAC) 224 for converting a digital control signal to an analog control signal RFAGC is connected to the output of the gain control signal generation circuit 215A. In addition, a DAC 225 for converting a digital signal to an analog signal is connected to the output of the DC offset removal circuit 216A.

Note that, in the circuit of FIG. 23, the LPFs 205, 206, and 207 are used for easing the requirements on the dynamic range performance of the circuit of the following stage. It also becomes possible to omit them. In the case of the omission, an LPF for preventing aliasing occurring in the ADC is added between the second multiplier 209 and the amplifier 218.

The present receiver 200A processes the power detection signals (baseband signals) P1, P2, and P3 output from the first to third power detectors 1007 to 1009 of the five-port junction circuit 203 including the IM2 components (square components of the received signals, the interference signals, and the local signals), the DC offsets generated due to the local signals, and the DC offsets derived from the incompleteness of the power detectors in the same way as in the third embodiment by analog computations at the first and the second multipliers 208 and 209 and the first and the second subtractors 210 and 211, removes the square components of the interference signals and the local signals and removes the DC offsets from the received signals, and inputs the results to the LPF 212 and the LPF 213.

The LPF 212 extracts only the desired channel signal from the output signal of the first subtractor 210 and outputs the same to the variable gain amplifier 219. Similarly, the LPF 213 extracts only the desired channel signal from the output signal of the second subtractor 211 and outputs the same to the variable gain amplifier 220.

The variable gain amplifier 219 adjusts the level of the output signal of the LPF 212 based on the control signal BBAGC generated at the digital processing system, that is, the multi-port signal-to-IQ signal conversion circuit 214A, so that the dynamic range of the ADC 221 of the following stage can be effectively used and outputs the result to the ADC 221.

Further, the variable gain amplifier 220 adjusts the level of the output signal of the LPF 213 based on the control signal BBAGC generated at the digital processing system, that is, the multi-port signal-to-IQ signal conversion circuit 214A, so that the dynamic range of the ADC 222 of the following stage can be effectively used and outputs the results to the ADC 222.

The ADC 221 converts the analog signal level adjusted at the variable gain amplifier 219 to a digital signal X1 and outputs the same to the multi-port signal-to-IQ signal conversion circuit 214A.

Similarly, the ADC 222 converts the analog signal level adjusted at the variable gain amplifier 220 to a digital signal X2 and outputs the same to the multi-port signal-to-IQ signal conversion circuit 214A.

The multi-port signal-to-IQ signal conversion circuit 214A receives the output digital signals X1 and X2 of the ADCs 221 and 222, performs computations based on the following equation (41) and equation (42) at the computation circuit, and converts the same to an In-phase signal I and a quadrature signal Q as demodulated signals:

$$I = \alpha_1 X_1 + \beta_1 X_2 + \gamma_1 \tag{41}$$

$$Q = \alpha_2 X_1 + \beta_2 X_2 + \gamma_2 \tag{42}$$

where, $\alpha_1$, $\beta_1$, $\gamma_1$, $\alpha_2$, $\beta_2$, and $\gamma_2$ are constants found from the circuit constants provided in the branch circuits 1002, 1010, and 1011, the phase shifters 1003 and 1004, the coupler circuits 1005 and 1006, and the power detectors 1007 to 1009 configuring the five-port junction circuit 203.

Note that equation (41) and equation (42) are equations when removal of the DC offset amount generated due to the local signal mentioned above does not work. When removal of the DC offset works, $\gamma_1 = \gamma_2 = 0$ stands and the following equations are used:

$$I = \alpha_1 x_1 + \beta_1 x_2 \qquad (43)$$

$$Q = \alpha_2 x_1 + \beta_2 x_2 \qquad (44)$$

where, when $\theta_1 = -\theta_2 = \theta$, the coefficients $\alpha_1$, $\beta_1$, $\gamma_1$, $\alpha_2$, $\beta_2$, and $\gamma_2$ are given as follows:

$$\alpha_1 = 1/4 k_{21} k_{22} R_0 P_{L0} \cos\theta \qquad (45)$$

$$\beta_1 = 1/4 k_{31} k_{32} R_0 P_{L0} \cos\theta \qquad (46)$$

$$\gamma_1 = (-k_{22}/4 k_{21} \cos\theta) - (k_{32}/4 k_{31} \cos\theta) \qquad (47)$$

$$\alpha_2 = -1/4 k_{21} k_{22} R_0 P_{L0} \sin\theta \qquad (48)$$

$$\beta_2 = 1/4 k_{31} k_{32} R_0 P_{L0} \sin\theta \qquad (49)$$

$$\gamma_2 = (k_{22}/4 k_{21} \sin\theta) + (k_{32}/4 k_{31} \sin\theta) \qquad (50)$$

$R_0$ indicates the impedance of the local signal generation source, $P_{LO}$ indicates the local signal power, and $\theta$ indicates the phases of the phase shifters 1003 and 1004.

According to the present fourth embodiment, the square components of the interference signal and the local signal are removed from the received signal, and thus high performance demodulated signals I and Q removed of their DC offsets can be obtained.

Further, there is the advantage that a high performance receiver not only contributing to the wide band property and the reduction of the local signal power, which are the characteristic features of a multi-port demodulator, but also having small fluctuation of characteristics with respect to temperature fluctuations and aging can be realized.

Further, since the DC offset is removed, there is the advantage that the signal levels input to the ADCs 220 and 221 can be reduced and the dynamic range of the ADC can be reduced by this.

Further, the ADC 223 for inputting the digital signal X0 to the gain control signal generation circuit 215A for generating the control signal RFAGC for controlling the variable gain circuit 202 may be one of a lower speed and lower bits in comparison with the other ADCs 221 and 222. Further, the function for generating the control signal RFAGC can be configured by an analog system circuit too in the same way as the third embodiment. In this case, the number of the ADCs may be reduced to two and simplification of the circuit and the lower power consumption can be achieved.

Note that this digital part, that is, the multi-port signal-to-IQ signal conversion circuit 214A, can be realized by a DSP, FPGA, logic circuit, or the like.

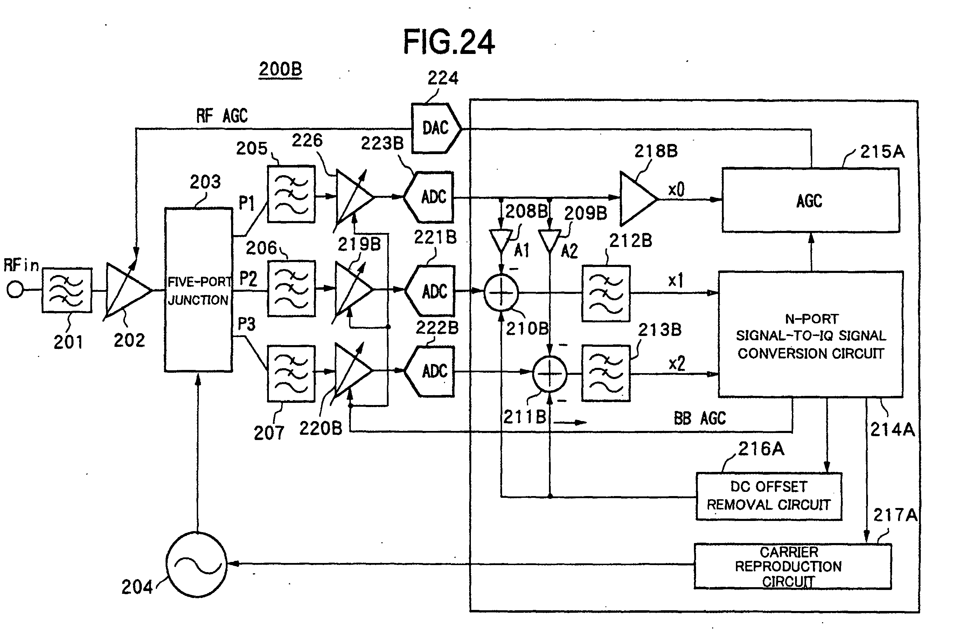

FIG. 24 is a block diagram of a receiver employing a demodulator of the direct conversion system according to a fifth embodiment of the present invention.

In FIG. 24, the same components as those of the receiver of FIG. 23 are represented by the same reference numerals.

The difference of a receiver 200B of FIG. 24 from the receiver 200A of FIG. 23 resides in that the processing of a first multiplier 208B, a second multiplier 209B, a first subtractor 210B, a second subtractor 211B, and LPFs 212B and 213B is carried out not by analog processing, but by digital signal processing in addition to the processing of the multi-port signal-to-IQ signal conversion circuit 214A, the gain control signal generation circuit 215A, and the carrier reproduction circuit 217A.

Specifically, as shown in FIG. 24, the variable gain amplifiers 219B and 220B are connected to the outputs of the LPF 206 and the LPF 207, the ADC 221B is connected to the output of the variable gain amplifier 219B, and the ADC 222B is connected to the output of the variable gain amplifier 220B. Then, the digital signal from the ADC 221B is input to the first subtractor 210B, and the digital signal from the ADC 222B is input to the second subtractor 211B. Further, the variable gain amplifier 226 is connected to the output of the LPF 205, the ADC 223B is connected to the output of the variable gain amplifier 226, and the digital signal of the power detection signal P1 from the ADC 223B is input to the first multiplier 208B, the second multiplier 209B, and the amplifier 218B.

In the present receiver 200B, the power detection signals (baseband signals) P1, P2, and P3 output from the first to third power detectors 1007 to 1009 of the five-port junction circuit 203 including the IM2 components (the square components of the received signals, the interference signals, and the local signals), the DC offsets generated due to the local signals, and the DC offsets derived from incompleteness of the power detectors are removed of their high frequency components at the LPF 205, the LPF 206, and the LPF 207, and then input to the variable gain amplifiers 226, 219B, and 220B. The desired channels are extracted at the LPFs 205, 206 and 207.

The variable gain amplifier 226 adjusts the level of the output signal of the LPF 205 based on the control signal BBAGC generated at the digital processing system, that is, the multi-port signal-to-IQ signal conversion circuit 214A, so that the dynamic range of the ADC 223B of the following stage can be effectively used and outputs the result to the ADC 223B.

The variable gain amplifier 219B adjusts the level of the output signal of the LPF 206 based on the control signal BBAGC generated at the digital processing system, that is, the multi-port signal-to-IQ signal conversion circuit 214A, so that the dynamic range of the ADC 221B of the following stage can be effectively used and outputs the result to the ADC 221B.

Further, the variable gain amplifier 220B adjusts the level of the output signal of the LPF 207 based on the control signal BBAGC generated at the digital processing system, that is, the multi-port signal-to-IQ signal conversion circuit 214A, so that the dynamic range of the ADC 222B of the following stage can be effectively used and outputs the result to the ADC 222B.

The ADC 223B converts the analog signal level adjusted at the variable gain amplifier 226 to a digital signal and outputs the result to the first multiplier 208B, the second multiplier 209B, and the amplifier 218B.

The ADC 221B converts the analog signal level adjusted at the variable gain amplifier 219B to a digital signal and outputs the result to the first subtractor 210B. Similarly, the ADC 222B converts the analog signal level adjusted at the variable gain amplifier 220B to a digital signal and outputs the result to the second subtractor 211B.

Then, the digital operation processing at the first and second multipliers 208B and 209B and the first and second subtractors 210B and 211B is carried out, and the square components of the interference signals and the local signals and the DC offsets are removed from the received signals and output to the n-port signal-to-IQ signal conversion circuit multi-port signal-to-IQ signal conversion circuit 214A.

The multi-port signal-to-IQ signal conversion circuit 214A receives the input digital signals X1 and X2 and performs the computations based on the above equation (41) and equation (42) at the computation circuit to convert them to an In-phase signal I and a quadrature signal Q as demodulated signals.

According to the present fifth embodiment, similar effects to the effects of the fourth embodiment mentioned above can be obtained.

Note that, in this example, three ADCs having a higher number of bits in comparison with the fourth embodiment become necessary, so this is disadvantageous in the points of the circuit size, costs, and current consumption. In the present fifth embodiment, however, the IM2 cancellation is performed digitally, so there is the advantage that a high precision, stable IM2 cancellation (having small variation and temperature fluctuation) is possible.

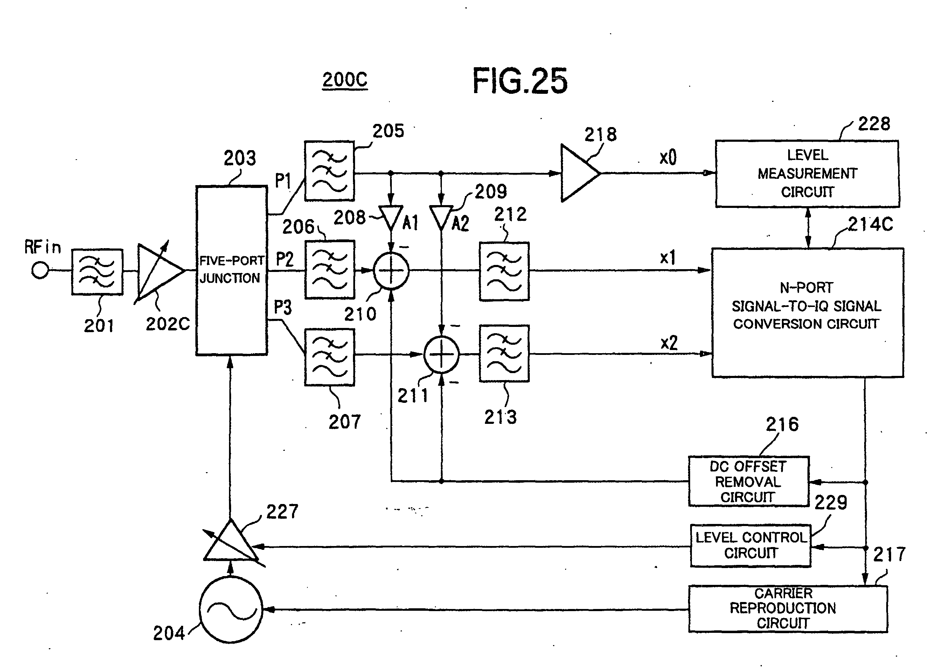

FIG. 25 is a block diagram of a receiver employing a demodulator of the direct conversion system according to a sixth embodiment of the present invention.

In FIG. 25, the same components as those of the receiver of FIG. 21 are represented by the same reference numerals.

The difference of a receiver 200C of FIG. 25 from the receiver 200 of FIG. 21 resides in that a function for measuring the local signal level and enabling change of the local signal level based on this measurement result is provided, the local signal level is changed in accordance with the received signal level, and the In-phase signal I and the quadrature signal Q are demodulated in accordance with the measured local signal level.

In the present sixth embodiment, the local signal level is controlled so that the five-port junction circuit 203 operates stably at the optimum operation level.

Specifically, a variable gain circuit 227 is provided on the output side of a local signal generation circuit 204, a local signal level measurement circuit 228 is provided in place of the gain control signal generation circuit, and a local signal level control circuit 229 for controlling the gain of the variable gain circuit 227 in accordance with the received signal level is provided.

The local signal level measurement circuit 228 measures the level of the local signal based on the signal x0 from the amplifier 218 and the demodulated signals of a multi-port signal-to-IQ signal conversion circuit 214C, calculates a local signal level $P_{LO}$, and stores it in the memory.

The multi-port signal-to-IQ signal conversion circuit 214C according to the present sixth embodiment receives the output signals $x_1$ and $x_2$ of the LPFs 212 and 213 in accordance with the local signal level $P_{LO}$ stored in the memory of the local signal level measurement circuit 228, performs the computations based on the following equation (51) and equation (52) in the computation circuit, and converts the results to an In-phase signal I and a quadrature signal Q as demodulated signals:

$$I = a_1 x_1/P_{LO} + b_1 x_2/P_{LO} + \gamma_1 \tag{51}$$

$$I = a_2 x_1/P_{LO} + b_2 x_2/P_{LO} + \gamma_2 \tag{52}$$

where, $\alpha_1$, $\beta_1$, $\gamma_1$, $\alpha_2$, $\beta_2$, and $\gamma_2$ are constants found from the circuit constants provided in the branch circuits 1001 and 1002, the phase shifters 1003 and 1004, the coupler circuits 1005 and 1006, and the power detectors 1007 to 1009 configuring the five-port junction circuit 203 and are given as follows:

$$a_1 = 1/4 k_{21} k_{22} R_0 \cos\theta \tag{53}$$

$$b_1 = 1/4 k_{31} k_{32} R_0 \cos\theta \tag{54}$$

$$\gamma_1 = (-k_{22}/4 k_{21} \cos\theta) - (k_{32}/4 k_{31} \cos\theta) \tag{55}$$

$$a_2 = -1/4 k_{21} k_{22} R_0 \sin\theta \tag{56}$$

$$b_2 = 1/4 k_{31} k_{32} R_0 \sin\theta \tag{57}$$

$$\gamma_2 = (k_{22}/4 k_{21} \sin\theta) + (k_{32}/4 k_{31} \sin\theta) \tag{58}$$

According to the present sixth embodiment, there are the advantages that an automatic gain control (AGC) function can be made unnecessary, the'control range can be reduced in the variable gain circuit 202C of the previous stage of the five-port junction circuit 203, and stable noise characteristics and distortion characteristics are obtained regardless of the received signal level.

Further, in the multi-port signal-to-IQ signal conversion circuit 214C according to the present sixth embodiment, at the time of no reception of signal (when the received signal is 0), the local signal level $P_{LO}$ is found from the value of the signal x0, and this is stored in the memory storage circuit.

Then, the IQ demodulated signals are obtained from the following equations:

$$I = a_1 X_1/P_{LO} + b_1 X_2/P_{LO} + \gamma_1 \tag{59}$$

$$I = a_2 X_1/P_{LO} + b_2 X_2/P_{LO} + \gamma_2 \tag{60}$$

By this, it is possible to compensate for fluctuation of the local signal due to the temperature characteristic, aging, etc.

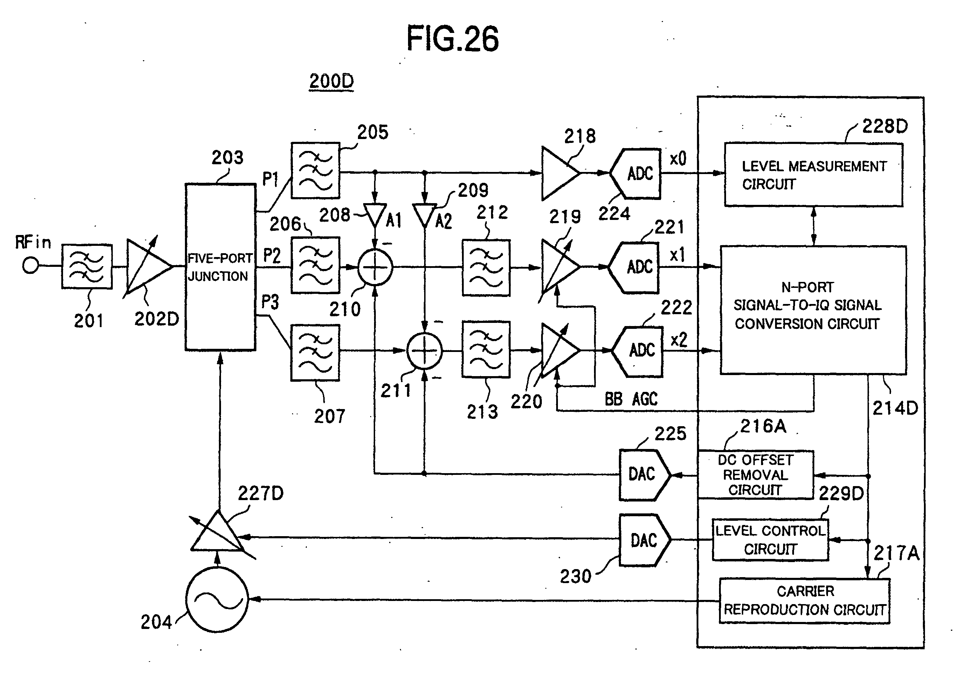

FIG. 26 is a block diagram of a receiver employing a demodulator of the direct conversion system according to a seventh embodiment of the present invention.

In FIG. 26, the same components as those of the receiver of FIG. 23 are represented by the same reference numerals.

The difference of a receiver 200D of FIG. 26 from the receiver 200A of FIG. 23 resides in that a function of measuring the local signal level and making the local signal level variable based on this measurement result is provided, the local signal level is changed in accordance with the received signal level, and the In-phase signal I and the quadrature signal Q are demodulated in accordance with the measured local signal level.

In the present seventh embodiment, the local signal level is controlled so that the five-port junction circuit 203 operates stably at the optimum operation level.

Specifically, a variable gain circuit 227D is provided on the output side of a local signal generation circuit 204, a local signal level measurement circuit 228D is provided in place of the gain control signal generation circuit, and a local signal level control circuit 229D for controlling the gain of the variable gain circuit 227D in accordance with the received signal level is provided. Note that, a DAC 230 is connected to the output side of the local signal level control circuit 229D.

The local signal level measurement circuit 228D measures the level of the local signal based on the digital signal X0 by the ADC 224 and the demodulated signals of the multi-port signal-to-IQ signal conversion circuit 214D, calculates the local signal level $P_{LO}$, and stores it in the memory.

The multi-port signal-to-IQ signal conversion circuit 214D according to the present seventh embodiment receives the output digital signals $X_1$ and $X_2$ of the ADCs 221 and 222 in accordance with the local signal level $P_{LO}$ stored in the memory of the local signal level measurement circuit 228D, performs the computations based on the following equation (61) and equation (62) in the computation circuit, and converts the results to an In-phase signal I and a quadrature signal Q as demodulated signals:

$$I = a_1 X_1/P_{LO} + b_1 X_2/P_{LO} + \gamma_1 \qquad (61)$$

$$I = a_2 X_1/P_{LO} + b_2 X_2/P_{LO} + \gamma_2 \qquad (62)$$

Here, $\alpha_1$, $\beta_1$, $\gamma_1$, $\alpha_2$, $\beta_2$ , and $\gamma_2$ are constants found from the circuit constants provided in the branch circuits 1001 and 1002, the phase shifters 1003 and 1004, the coupler circuits 1005 and 1006, and the power detectors 1007 to 1009 configuring the five-port junction circuit 203, and are given as follows:

$$a_1 = 1/4 k_{21} k_{22} R_0 \cos\theta$$

$$b_1 = 1/4 k_{31} k_{32} R_0 \cos\theta \qquad (64)$$

$$\gamma_1 = (-k_{22}/4 k_{21} \cos\theta) - (k_{32}/4 k_{31} \cos\theta) \qquad (35)$$

$$a_2 = -1/4 k_{21} k_{22} R_0 \sin\theta \qquad (66)$$

$$b_2 = 1/4 k_{31} k_{32} R_0 \sin\theta \qquad (67)$$

$$\gamma_2 = (k_{22}/4 k_{21} \sin\theta) + (k_{32}/4 k_{31} \sin\theta) \qquad (68)$$

According to the present seventh embodiment, there are the advantages that an automatic gain control (AGC) function can be made unnecessary, the control range can be reduced in the variable gain circuit 202D of the previous stage of the five-port junction circuit 203, and stable noise characteristics and distortion characteristics are obtained regardless of the received signal level.

Further, in the multi-port signal-to-IQ signal conversion circuit 214D according to the present seventh embodiment, at the time of no reception of signal (when the received signal is 0), the local signal level $P_{LO}$ is found from the value of the signal X0, and this is stored in the memory storage circuit.

Then, from the following equations, the IQ demodulated signals are obtained:

$$I = a_1 X_1/P_{LO} + b_1 X_2/P_{LO} + \gamma_1 \qquad (69)$$

$$I = a_2 X_1/P_{LO} + b_2 X_2/P_{LO} + \gamma_2 \qquad (70)$$

By this, it is possible to compensate for fluctuation of the local signal due to the temperature characteristics, aging, etc.

Note that when the received signal is 0, by adjusting the gains of the first multiplier 208 and the second multiplier 209 and the gains of the variable gain amplifiers 219 and 220 so that the output signals X1 and X2 of the ADC 221 and the ADC 222 become values found by the following equations, a more correct IM2 cancellation can be carried out. In this calibration method, when $\gamma_1 = \gamma_2$, $X_1 = X_2 = O$ stands.

$$X_1 = (-\gamma_1\beta_2 + \beta_2\gamma_2) / (\alpha_1\beta_2 - \alpha_2\beta_1) \tag{71}$$

$$X_2 = (\gamma_1\alpha_2 - \alpha_1\gamma_2) / (\alpha_1\beta_2 - \alpha_2\beta_1) \tag{72}$$

Note that, in the present seventh embodiment, the local signal level can be measured based on only the signal X0.

For example, by providing a means for measuring X0 in the output portion of the LPF 107 of FIG. 3 and performing signal processing given by the following equation when there is no received signal, the local signal level is measured:

$$P_{LO} = \frac{P_2}{K_{22}^2}$$

($K_{22}$ is a constant obtained from the circuit constants)

INDUSTRIAL APPLICABILITY

As described above, according to the demodulator according to the present invention and the receiver using the same, a high performance demodulator and receiver not only contributing to the wide band property and the reduction of the local signal power, which are characteristic features of a multi-port demodulator, but also able to realize a further wide band property, low distortion characteristics, and low power consumption in comparison with a conventional multi-port demodulator and having small fluctuation in characteristics with respect to temperature fluctuations and aging can be realized.

LIST OF REFERENCES

| | |
|---|---|
| 100, 100A... | demodulator |
| 101... | five-port junction circuit |
| 102... | local signal generation circuit |
| 103... | first multiplier |
| 104... | second multiplier |
| 105... | first subtractor |
| 106... | second subtractor |
| 107, 108... | low pass filter (LPF) |
| 109, 109A... | multi-port signal-to-IQ signal conversion circuit |
| 110, 111... | variable gain amplifier |
| 112, 113... | analog/digital convertor (ADC) |
| 200, 200A to 200D... | receiver |
| 201... | band pass filter (BPF) |
| 202... | variable gain circuit |
| 203... | five-port junction circuit |
| 204... | local signal generation circuit |
| 205 to 207... | LPF |
| 208, 208B... | first multiplier |
| 209, 209B... | second multiplier |

| 210, 210B... | first subtractor |
| 211, 211B... | second subtractor |
| 212, 212b, 213, | 213B... LPF |
| 214, 214A, 214C, 214D... | multi-port signal-to-IQ signal conversion circuit |
| 215, 215A... | gain control signal generation circuit |
| 216, 216A... | DC offset removing circuit |
| 217, 217A... | carrier reproduction circuit |
| 219, 219B, 220, 220B, 226... | variable gain amplifier |
| 221 to 223... | analog/digital convertor (ADC) |
| 227, 227D.... | variable gain circuit |
| 228, 228D... | level measurement circuit |
| 229, 229D... | level control circuit |

**Claims**

**1.** A demodulator comprising:

a multi-port junction circuit including a generating means receiving as input a received signal and a local signal and based on at least one signal, generating at least two signals having a phase difference, and a plurality of power detectors for detecting signal levels of signals generated by said generating means;
at least one multiplier for multiplying an output signal of one power detector among said plurality of power detectors by a coefficient for canceling an unnecessary component included in the output signal of other power detector;
at least one subtractor for subtracting the output signal of said one power detector multiplied by a coefficient at said multiplier from the output signal of said other power detector; and
a conversion circuit for converting the result to a plurality of signal components included in the received signal based on the output signal of said subtractor.

**2.** A demodulator as set forth in claim 1, comprising a removing means for removing a DC offset from the output of said subtractor.

**3.** A demodulator as set forth in claim 2, wherein said removing means includes an offset removal subtractor connected to the latter stage of said subtractor and a circuit for measuring a DC offset amount from the output of said offset removal subtractor and feeding back a signal for canceling the DC offset amount to the offset removal subtractor.

**4.** A demodulator as set forth in claim 2, wherein said removing means includes an offset removal subtractor connected to the latter stage of said subtractor and a circuit for taking an average of outputs of said offset removal subtractor and feeding back the average result as a signal for canceling the DC offset amount to the offset removal subtractor.

**5.** A demodulator as set forth in claim 1, comprising a channel selecting means for selecting a desired channel from the output signal of said subtractor and inputting the same to said conversion circuit, and
said conversion circuit demodulating an In-phase component signal I and a quadrature component signal Q based on the output signal of said channel selecting means and predetermined circuit constants.

**6.** A demodulator as set forth in claim 3, comprising a channel selecting means for selecting a desired channel from the output signal of said offset removal subtractor and inputting the same to said conversion circuit, and
said conversion circuit demodulating an In-phase component signal I and a quadrature component signal Q based on the output signal of said channel selecting means and predetermined circuit constants.

**7.** A demodulator as set forth in claim 4, comprising a channel selecting means for selecting a desired channel from the output signal of said offset removal subtractor and inputting the same to said conversion circuit, and
said conversion circuit demodulating an In-phase component signal I and a quadrature component signal Q based on the output signal of said channel selecting means and predetermined circuit constants.

**8.** A demodulator as set forth in claim 5, wherein said channel selecting means includes a low-pass filter.

**9.** A demodulator as set forth in claim 6, wherein said channel selecting means includes a low-pass filter.

**10.** A demodulator as set forth in claim 7, wherein said channel selecting means includes a low-pass filter.

**11.** A demodulator comprising:

a multi-port junction circuit including a generating means receiving as input a received signal and a local signal and based on at least one signal, generating at least two signals having a phase difference, and a plurality of power detectors for detecting signal levels of signals generated by said generating means;
at least one multiplier for multiplying an output signal of one power detector among said plurality of power detectors by a coefficient for canceling an unnecessary component included in the output signal of other power detector;
at least one subtractor for subtracting the output signal of said one power detector multiplied by a coefficient at said multiplier from the output signal of said other power detector;
at least one variable gain amplifier for adjusting the level of the output signal of said subtractor with a gain in accordance with a control signal;
an analog/digital converter for converting the output signal of said variable gain amplifier from an analog signal to a digital signal; and
a conversion circuit for converting the result to a plurality of signal components included in the received signal based on the digital signal from said analog/digital converter, then outputting said control signal to said variable gain amplifier so as to adjust the level of the output signal of said subtractor to a level suitable for a dynamic range of the analog/digital converter.

**12.** A demodulator as set forth in claim 11, comprising a removing means for removing a DC offset from the output of said subtractor.

**13.** A demodulator as set forth in claim 12, wherein said removing means includes an offset removal subtractor connected to the latter stage of said subtractor and a circuit for measuring a DC offset amount from the output of said offset removal subtractor and feeding back a signal for canceling the DC offset amount to the offset removal subtractor.

**14.** A demodulator as set forth in claim 12, wherein said removing means includes an offset removal subtractor connected to the latter stage of said subtractor and a circuit for taking an average of outputs of said offset removal subtractor and feeding back the average result as a signal for canceling the DC offset amount to the offset removal subtractor.

**15.** A demodulator as set forth in claim 11, comprising a channel selecting means for selecting a desired channel from the output signal of said subtractor and inputting the same to said variable gain amplifier, and
said conversion circuit demodulating an In-phase component signal I and a quadrature component signal Q based on the digital signal from said analog/digital converter and predetermined circuit constants.

**16.** A demodulator as set forth in claim 13, comprising a channel selecting means for selecting a desired channel from the output signal of said offset removal subtractor and inputting the same to said variable gain amplifier, and
said conversion circuit demodulating an In-phase component signal I and a quadrature component signal Q based on the digital signal from said analog/digital converter and predetermined circuit constants.

**17.** A demodulator as set forth in claim 14, comprising a channel selecting means for selecting a desired channel from the output signal of said offset removal subtractor and inputting the same to said variable gain amplifier, and
said conversion circuit demodulating an In-phase component signal I and a quadrature component signal Q based on the digital signal from said analog/digital converter and predetermined circuit constants.

**18.** A demodulator as set forth in claim 15, wherein said channel selecting means includes a low-pass filter.

**19.** A demodulator as set forth in claim 16, wherein said channel selecting means includes a low-pass filter.

**20.** A demodulator as set forth in claim 17, wherein said channel selecting means includes a low-pass filter.

**21.** A demodulator as set forth in claim 15, wherein said conversion circuit outputs a control signal to said variable gain amplifier and calibrates the gain of the variable gain amplifier so that the digital signal from said analog/digital converter becomes a desired level at the time of no reception of a signal.

**22.** A demodulator as set forth in claim 16, wherein said conversion circuit outputs a control signal to said variable gain amplifier and calibrates the gain of the variable gain amplifier so that the digital signal from said analog/digital converter becomes a desired level at the time of no reception of a signal.

**23.** A demodulator as set forth in claim 17, wherein said conversion circuit outputs a control signal to said variable gain amplifier and calibrates the gain of the variable gain amplifier so that the digital signal from said analog/digital converter becomes a desired level at the time of no reception of a signal.

**24.** A demodulator comprising:

a multi-port junction circuit including a generating means receiving as input a received signal and a local signal and based on at least one signal, generating at least two signals having a phase difference, and a plurality of power detectors for detecting signal levels of signals generated by said generating means;
a plurality of variable gain amplifiers for adjusting levels of the output signals of said plurality of power detectors with a gain in accordance with a control signal;
a plurality of analog/digital converters for converting the output signals of said plurality of variable gain amplifiers from analog signals to digital signals;
at least one multiplier for multiplying the output signal of one power detector among said plurality of power detectors converted to a digital signal by said analog/digital converter by a coefficient for canceling unnecessary components included in the output signal of the other power detector;
at least one subtractor for subtracting the output signal of said one power detector multiplied by a coefficient at said multiplier from the output signal of said other power detector converted to a digital signal by said analog/digital converter; and
a conversion circuit for converting the result to a plurality of signal components included in the received signal based on the digital signal from said subtractor, then outputting said control signal to said variable gain amplifier so as to adjust the level of the output signal of said power detector to a level suitable for a dynamic range of said analog/digital converter.

**25.** A demodulator as set forth in claim 24, comprising a removing means for removing a DC offset from the output of said subtractor.

**26.** A demodulator as set forth in claim 25, wherein said removing means includes an offset removal subtractor connected to the latter stage of said subtractor and a circuit for measuring a DC offset amount from the output of said offset removal subtractor and feeding back a signal for canceling the DC offset amount to the offset removal subtractor.

**27.** A demodulator as set forth in claim 25, wherein said removing means includes an offset removal subtractor connected to the latter stage of said subtractor and a circuit for taking an average of outputs of said offset removal subtractor and feeding back the average result as a signal for canceling the DC offset amount to the offset removal subtractor.

**28.** A demodulator as set forth in claim 24, wherein:

the demodulator has a channel selecting means for selecting a desired channel from the output signal of said subtractor and inputting the same to said variable gain amplifier, and
said conversion circuit demodulates an In-phase component signal I and a quadrature component signal Q based on the digital signal from said channel selecting means and predetermined circuit constants.

**29.** A demodulator as set forth in claim 26, comprising a channel selecting means for selecting a desired channel from the output signal of said offset removal subtractor and inputting the same to said conversion circuit, and
said conversion circuit demodulating an In-phase component signal I and a quadrature component signal Q based on the digital signal from said channel selecting means and predetermined circuit constants.

**30.** A demodulator as set forth in claim 27, comprising a channel selecting means for selecting a desired channel from the output signal of said offset removal subtractor and inputting the same to said conversion circuit, and

said conversion circuit demodulating an In-phase component signal I and a quadrature component signal Q based on the digital signal from said channel selecting means and predetermined circuit constants.

**31.** A demodulator as set forth in claim 28, wherein said channel selecting means includes a low-pass filter.

**32.** A demodulator as set forth in claim 29, wherein said channel selecting means includes a low-pass filter.

**33.** A demodulator as set forth in claim 30, wherein said channel selecting means includes a low-pass filter.

**34.** A demodulator as set forth in claim 28, wherein said conversion circuit outputs a control signal to said variable gain amplifier and calibrates the gain of the variable gain amplifier so that the digital signal from said channel selecting means becomes a desired level at the time of no reception of signal.

**35.** A demodulator as set forth in claim 29, wherein said conversion circuit outputs a control signal to said variable gain amplifier and calibrates the gain of the variable gain amplifier so that the digital signal from said channel selecting means becomes a desired level at the time of no reception of signal.

**36.** A demodulator as set forth in claim 30, wherein said conversion circuit outputs a control signal to said variable gain amplifier and calibrates the gain of the variable gain amplifier so that the digital signal from said channel selecting means becomes a desired level at the time of no reception of signal.

**37.** A demodulator comprising:

a multi-port junction circuit including a generating means receiving as input a received signal and a local signal and based on at least one signal, generating a first signal, a second signal, and a third signal having a phase difference, and a first power detector for detecting a signal level of the first signal generated by said generating means and outputting a first power detection signal, a second power detector for detecting the signal level of said second signal and outputting a second power detection signal, and a third power detector for detecting the signal level of said third signal and outputting a third power detection signal;
a first multiplier for multiplying the first power detection signal from said first power detector by a coefficient for canceling an unnecessary component included in the second power detection signal from said second power detector;
a second multiplier for multiplying the first power detection signal from said first power detector by a coefficient for canceling an unnecessary component included in the third power detection signal from said third power detector;
a first subtractor for subtracting the first power detection signal from said first power detector multiplied by a coefficient at said first multiplier from the second power detection signal from said second power detector;
a second subtractor for subtracting the first power detection signal from said first power detector multiplied by a coefficient at said second multiplier from the third power detection signal from said third power detector; and
a conversion circuit for converting the result to a plurality of signal components included in the received signal based on the output signals of said first and second subtractors.

**38.** A demodulator as set forth in claim 37, comprising a removing means for removing a DC offset from the output of said subtractor.

**39.** A demodulator as set forth in claim 38, wherein said removing means includes first and second offset removal subtractors connected to the latter stage of said first and second subtractors and a circuit for measuring the DC offset amount from the outputs of said offset removal subtractors and feeding back a signal for canceling the DC offset amount to the offset removal subtractors.

**40.** A demodulator as set forth in claim 38, wherein said removing means includes first and second offset removal subtractors connected to the latter stage of said first and second subtractors and a circuit for taking averages of outputs of said offset removal subtractors and feeding back the average results as a signal for canceling the DC offset amount to the offset removal subtractors.

**41.** A demodulator as set forth in claim 37, comprising:

a first channel selecting means for selecting a desired channel from the output signal of said first subtractor and inputting the same to said conversion circuit and

a second channel selecting means for selecting a desired channel from the output signal of said second subtractor and inputting the same to said conversion circuit, and

said conversion circuit demodulating an In-phase component signal I and a quadrature component signal Q based on the output signals of said first and second channel selecting means and predetermined circuit constants.

**42.** A demodulator as set forth in claim 41, wherein said conversion circuit obtains an In-phase component signal I and a quadrature component signal Q by computations based on the following equations:

$$I = \alpha_1 x_1 + \beta_1 x_2 + \gamma_1$$

$$Q = \alpha_2 x_1 + \beta_2 x_2 + \gamma_2$$

where, $x_1$ is the output signal of the first channel selecting means, $x_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**43.** A demodulator as set forth in claim 39, comprising:

a first channel selecting means for selecting a desired channel from the output signal of said first offset removal subtractor and inputting the same to said conversion circuit and

a second channel selecting means for selecting a desired channel from the output signal of said second offset removal subtractor and inputting the same to said conversion circuit, and

said conversion circuit demodulating an In-phase component signal I and a quadrature component signal Q based on the output signals of said first and second channel selecting means and predetermined circuit constants.

**44.** A demodulator as set forth in claim 43, wherein said conversion circuit obtains an In-phase component signal I and a quadrature component signal Q by computations based on the following equations:

$$I = \alpha_1 x_1 + \beta_1 x_2 + \gamma_1$$

$$Q = \alpha_2 x_1 + \beta_2 x_2 + \gamma_2$$

where, $x_1$ is the output signal of the first channel selecting means, $x_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**45.** A demodulator as set forth in claim 40, comprising:

a first channel selecting means for selecting a desired channel from the output signal of said first offset removal subtractor and inputting the same to said conversion circuit and

a second channel selecting means for selecting a desired channel from the output signal of said second offset removal subtractor and inputting the same to said conversion circuit, and

said conversion circuit demodulating an In-phase component signal I and a quadrature component signal Q based on the output signals of said first and second channel selecting means and predetermined circuit constants.

**46.** A demodulator as set forth in claim 45, wherein said conversion circuit obtains an In-phase component signal I and a quadrature component signal Q by computations based on the following equations:

$$I = \alpha_1 x_1 + \beta_1 x_2 + \gamma_1$$

$$Q = \alpha_2 x_1 + \beta_2 x_2 + \gamma_2$$

where, $x_1$ is the output signal of the first channel selecting means, $x_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**47.** A demodulator as set forth in claim 41, wherein at least one of said first and second channel selecting means includes a low-pass filter.

**48.** A demodulator as set forth in claim 43. wherein at least one of said first and second channel selecting means includes a low-pass filter.

**49.** A demodulator as set forth in claim 45, wherein at least one of said first and second channel selecting means includes a low-pass filter.

**50.** A demodulator comprising:

a multi-port junction circuit including a generating means receiving as input a received signal and a local signal and based on at least one signal, generating a first signal, a second signal, and a third signal having a phase difference, a first power detector for detecting a signal level of the first signal generated by said generating means and outputting a first power detection signal, a second power detector for detecting the signal level of said second signal and outputting a second power detection signal, and a third power detector for detecting the signal level of said third signal and outputting a third power detection signal;

a first multiplier for multiplying the first power detection signal from said first power detector by a coefficient for canceling an unnecessary component included in the second power detection signal from said second power detector;

a second multiplier for multiplying the first power detection signal from said first power detector by a coefficient for canceling an unnecessary component included in the third power detection signal from said third power detector;

a first subtractor for subtracting the first power detection signal from said first power detector multiplied by a coefficient at said first multiplier from the second power detection signal from said second power detector;

a second subtractor for subtracting the first power detection signal from said first power detector multiplied by a coefficient at said second multiplier from the third power detection signal from said third power detector;

a first variable gain amplifier for adjusting the level of the output signal of said first subtractor with a gain in accordance with a control signal;

a second variable gain amplifier for adjusting the level of the output signal of said second subtractor with a gain in accordance with a control signal;

a first analog/digital converter for converting the output signal of said first variable gain amplifier from an analog signal to a digital signal;

a second analog/digital converter for converting the output signal of said second variable gain amplifier from an analog signal to a digital signal; and

a conversion circuit for converting the result to a plurality of signal components included in the received signal based on the digital signals from said first and second analog/digital converters, then outputting said control signal to said first and second variable gain amplifiers so as to adjust the levels of the output signals of said first and second subtractors to levels suitable for the dynamic range of said first and second analog/digital converters.

**51.** A demodulator as set forth in claim 50, comprising a removing means for removing a DC offset from the output of said subtractor.

**52.** A demodulator as set forth in claim 51, wherein said removing means includes first and second offset removal subtractors connected to the latter stage of said first and second subtractors and a circuit for measuring the DC offset amount from the outputs of said offset removal subtractors and feeding back a signal for canceling the DC offset amount to the offset removal subtractors.

**53.** A demodulator as set forth in claim 51, wherein said removing means includes first and second offset removal subtractors connected to the latter stage of said first and second subtractors and a circuit for taking averages of outputs of said offset removal subtractors and feeding back the average results as a signal for canceling the DC offset amount to the offset removal subtractors.

**54.** A demodulator as set forth in claim 50, comprising:

a first channel selecting means for selecting a desired channel from the output signal of said first subtractor and inputting the same to said first variable gain amplifier and

a second channel selecting means for selecting a desired channel from the output signal of said second subtractor and inputting the same to said second variable gain amplifier, and

said conversion circuit demodulating an In-phase component signal I and a quadrature component signal Q based on the output signals of said first and second analog/digital converters and predetermined circuit constants.

**55.** A demodulator as set forth in claim 54, wherein said conversion circuit obtains an In-phase component signal I and a quadrature component signal Q by computations based on the following equations:

$$I = \alpha_1 X_1 + \beta_1 x_2 + \gamma_1$$

$$Q = \alpha_2 X_1 + \beta_2 X_2 + \gamma_2$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**56.** A demodulator as set forth in claim 52, comprising:

a first channel selecting means for selecting a desired channel from the output signal of said first offset removal subtractor and inputting the same to said first variable gain amplifier and

a second channel selecting means for selecting a desired channel from the output signal of said second offset removal subtractor and inputting the same to said second variable gain amplifier, and

said conversion circuit demodulating an In-phase component signal I and a quadrature component signal Q based on the output signals of said first and second analog/digital converters and predetermined circuit constants.

**57.** A demodulator as set forth in claim 56, wherein said conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**58.** A demodulator as set forth in claim 53, comprising:

a first channel selecting means for selecting a desired channel from the output signal of said first offset removal subtractor and inputting the same to said first variable gain amplifier and

a second channel selecting means for selecting a desired channel from the output signal of said second offset removal subtractor and inputting the same to said second variable gain amplifier, and

said conversion circuit demodulating an In-phase component signal I and a quadrature component signal Q based on the output signals of said first and second analog/digital converters and predetermined circuit constants.

**59.** A demodulator as set forth in claim 58, wherein said conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**60.** A demodulator as set forth in claim 54, wherein at least one of said first and second channel selecting means includes a low-pass filter.

**61.** A demodulator as set forth in claim 56, wherein at least one of said first and second channel selecting means includes a low-pass filter.

**62.** A demodulator as set forth in claim 58, wherein at least one of said first and second channel selecting means includes a low-pass filter.

**63.** A demodulator as set forth in claim 55, wherein said conversion circuit outputs the control signal to said variable gain amplifiers and calibrates the gains of the variable gain amplifiers so that the digital signals from said first and second analog/digital converters become levels obtained from the following equations at the time of no reception of signal.

$$X_1 = (-\gamma_1 \beta_1 + \beta_2 \gamma_2) / (\alpha_1 \beta_2 - \alpha_2 \beta_1)$$

$$X_2 = (\gamma_1 \alpha_2 - \alpha_1 \gamma_2) / (\alpha_1 \beta_2 - \alpha_2 \beta_1)$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**64.** A demodulator as set forth in claim 57, wherein said conversion circuit outputs the control signal to said variable gain amplifiers and calibrates the gains of the variable gain amplifiers so that the digital signals from said first and second analog/digital converters become levels obtained from the following equations at the time of no reception of signal.

$$X_1 = (-\gamma_1 \beta_1 + \beta_2 \gamma_2) / (\alpha_1 \beta_2 - \alpha_2 \beta_1)$$

$$X_2 = (\gamma_1 \alpha_2 - \alpha_1 \gamma_2) / (\alpha_1 \beta_2 - \alpha_2 \beta_1)$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**65.** A demodulator as set forth in claim 59, wherein said conversion circuit outputs the control signal to said variable gain amplifiers and calibrates the gains of the variable gain amplifiers so that the digital signals from said first and second analog/digital converters become levels obtained from the following equations at the time of no reception of signal.

$$X_1 = (-\gamma_1 \beta_1 + \beta_2 \gamma_2) / (\alpha_1 \beta_2 - \alpha_2 \beta_1)$$

$$X_2 = (\gamma_1 \alpha_2 - \alpha_1 \gamma_2) / (\alpha_1 \beta_2 - \alpha_2 \beta_1)$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**66.** A demodulator comprising:

a multi-port junction circuit including a generating means receiving as input a received signal and a local signal and based on at least one signal, generating a first signal, a second signal, and a third signal having a phase difference, a first power detector for detecting a signal level of the first signal generated by said generating means and outputting a first power detection signal, a second power detector for detecting the signal level of said second signal and outputting a second power detection signal, and a third power detector for detecting the signal level of said third signal and outputting a third power detection signal;

a first variable gain amplifier for adjusting the level of the first power detection signal from said first power detector with a gain in accordance with a control signal;

a second variable gain amplifier for adjusting the level of the second power detection signal from said second power detector with a gain in accordance with a control signal;

a third variable gain amplifier for adjusting the level of the third power detection signal from said third power detector with a gain in accordance with a control signal;

a first analog/digital converter for converting the output signal of said first variable gain amplifier from an analog signal to a digital signal;

a second analog/digital converter for converting the output signal of said second variable gain amplifier from an analog signal to a digital signal;

a third analog/digital converter for converting the output signal of said third variable gain amplifier from an analog signal to a digital signal;

a first multiplier for multiplying the first power detection signal from said first power detector converted to a digital signal at said first analog/digital converter by a coefficient for canceling an unnecessary component included in the second power detection signal from said second power detector;

a second multiplier for multiplying the first power detection signal from said first power detector converted to a digital signal at said first analog/digital converter by a coefficient for canceling an unnecessary component included in the third power detection signal from said third power detector;

a first subtractor for subtracting the first power detection signal from said first power detector multiplied by a coefficient at said first multiplier from the second power detection signal from said second power detector converted to a digital signal at said second analog/digital converter;

a second subtractor for subtracting the first power detection signal from said first power detector multiplied by a coefficient at said second multiplier from the third power detection signal from said third power detector converted to a digital signal at said third analog/digital converter; and

a conversion circuit for converting the result to a plurality of signal components included in the received signal based on the digital signals from said first and second subtractors, and then outputting said control signal to said second and third variable gain amplifiers so as to adjust the levels of the output signals of said second and third power detectors to levels suitable for the dynamic range of at least said second and third analog/digital converters.

**67.** A demodulator as set forth in claim 66, comprising a removing means for removing a DC offset from the output of said first and second subtractors.

**68.** A demodulator as set forth in claim 67, wherein said removing means includes first and second offset removal subtractors connected to the latter stage of said first and second subtractors and a circuit for measuring a DC offset amount from the outputs of said offset removal subtractors and feeding back a signal for canceling the DC offset amount to the offset removal subtractors.

**69.** A demodulator as set forth in claim 67, wherein said removing means includes first and second offset removal subtractors connected to the latter stage of said first and second subtractors and a circuit for taking averages of outputs of said offset removal subtractors and feeding back the average results as a signal for canceling the DC offset amount to the offset removal subtractors.

**70.** A demodulator as set forth in claim 66, comprising:

a first channel selecting means for selecting a desired channel from the output signal of said first subtractor and inputting the same to said conversion circuit and

46

a second channel selecting means for selecting a desired channel from the output signal of said subtractor and inputting the same to said second conversion circuit, and

said conversion circuit demodulating an In-phase component signal I and a quadrature component signal Q based on the output signals of said first and second channel selecting means and predetermined circuit constants.

**71.** A demodulator as set forth in claim 70, wherein said conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**72.** A demodulator as set forth in claim 68, comprising:

a first channel selecting means for selecting a desired channel from the output signal of said first offset removal subtractor and inputting the same to said conversion circuit and

a second channel selecting means for selecting a desired channel from the output signal of said second offset removal subtractor and inputting the same to said conversion circuit, and

said conversion circuit demodulating an In-phase component signal I and a quadrature component signal Q based on the output signals of said first and second channel selecting means and predetermined circuit constants.

**73.** A demodulator as set forth in claim 72, wherein said conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**74.** A demodulator as set forth in claim 69, comprising:

a first channel selecting means for selecting a desired channel from the output signal of said first offset removal subtractor and inputting the same to said conversion circuit and

a second channel selecting means for selecting a desired channel from the output signal of said second offset removal subtractor and inputting the same to said conversion circuit, and

said conversion circuit demodulating an In-phase component signal I and a quadrature component signal Q based on the output signals of said first and second channel selecting means and predetermined circuit constants.

**75.** A demodulator as set forth in claim 74, wherein said conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**76.** A demodulator as set forth in claim 70, wherein at least one of said first and second channel selecting means includes a low-pass filter.

**77.** A demodulator as set forth in claim 72, wherein at least one of said first and second channel selecting means includes a low-pass filter.

**78.** A demodulator as set forth in claim 74, wherein at least one of said first and second channel selecting means includes a low-pass filter.

**79.** A demodulator as set forth in claim 71, wherein said conversion circuit outputs the control signal to said variable gain amplifiers and calibrates the gains of the variable gain amplifiers so that the digital signals from said first and second channel selecting means become levels obtained from the following equations at the time of no reception of signal.

$$X_1 = (-\gamma_1\beta_1+\beta_2\gamma_2) / (\alpha_1\beta_2-\alpha_2\beta_1)$$

$$X_2 = (\gamma_1\alpha_2-\alpha_1\gamma_2) / (\alpha_1\beta_2-\alpha_2\beta_1)$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**80.** A demodulator as set forth in claim 73, wherein said conversion circuit outputs the control signal to said variable gain amplifiers and calibrates the gains of the variable gain amplifiers so that the digital signals from said first and second channel selecting means become levels obtained from the following equations at the time of no reception of signal.

$$X_1 = (-\gamma_1\beta_1+\beta_2\gamma_2) / (\alpha_1\beta_2-\alpha_2\beta_1)$$

$$X_2 = (\gamma_1\alpha_2-\alpha_1\gamma_2) / (\alpha_1\beta_2-\alpha_2\beta_1)$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**81.** A demodulator as set forth in claim 75, wherein said conversion circuit outputs the control signal to said variable gain amplifiers and calibrates the gains of the variable gain amplifiers so that the digital signals from said first and second channel selecting means become levels obtained from the following equations at the time of no reception of signal.

$$X_1 = (-\gamma_1\beta_1+\beta_2\gamma_2) / (\alpha_1\beta_2-\alpha_2\beta_1)$$

$$X_2 = (\gamma_1\alpha_2-\alpha_1\gamma_2) / (\alpha_1\beta_2-\alpha_2\beta_1)$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**82.** A receiver comprising:

a demodulator having a multi-port junction circuit including a generating means receiving as input a received signal and a local signal and based on at least one signal, generating at least two signals having a phase difference, and a plurality of power detectors for detecting signal levels of signals generated by said generating means, at least one multiplier for multiplying an output signal of one power detector among said plurality of power detectors by a coefficient for canceling an unnecessary component included in the output signal of the other power detector, at least one subtractor for subtracting the output signal of said one power detector multiplied by a coefficient at said multiplier from the output signal of said other power detector, and a conversion circuit for converting the result to a plurality of signal components included in the received signal based on the output signal of said subtractor;

a gain control circuit for adjusting the level of the received signal to a desired level and supplying the result to the generating means of said multi-port junction circuit; and

a local signal generation circuit for generating a local signal of a desired level at a desired oscillation frequency and supplying the same to the generating means of said multi-port junction circuit.

**83.** A receiver as set forth in claim 82, wherein said gain control circuit:

receives a gain control signal to be controlled in gain and

includes a gain control signal generation circuit for outputting said gain control signal to said gain control circuit so that the received signal level becomes constant based on the output signal of one power detector among said plurality of power detectors.

**84.** A receiver as set forth in claim 82, comprising:

a carrier reproduction circuit for reproducing a carrier based on a plurality of signal components obtained at said conversion circuit and outputting a reproduced signal, and

said local signal generation circuit receiving said reproduced signal and setting an oscillation frequency of the local signal so as to become a frequency substantially equal to the carrier frequency of the received signal.

**85.** A receiver as set forth in claim 83, comprising:

a carrier reproduction circuit for reproducing a carrier based on a plurality of signal components obtained at said conversion circuit and outputting a reproduced signal, and

said local signal generation circuit receiving said reproduced signal and setting an oscillation frequency of the local signal so as to become a frequency substantially equal to the carrier frequency of the received signal.

**86.** A receiver as set forth in claim 85, comprising a channel selecting means for selecting a desired channel from the output signal of said subtractor and inputting the same to said conversion circuit, and

said conversion circuit demodulating an In-phase component signal I and a quadrature component signal Q based on the output signal of said channel selecting means and predetermined circuit constants.

**87.** A receiver as set forth in claim 82, comprising:

a variable circuit for adjusting the level of the local signal by said local signal generation circuit to a level in accordance with a level control signal and

a level control circuit for outputting said level control signal to said variable circuit so that said multi-port junction circuit becomes a level enabling operation at an optimum level in accordance with the received signal level obtained at said conversion circuit.

**88.** A receiver as set forth in claim 87, comprising a channel selecting means for selecting a desired channel from the output signal of said subtractor and inputting the same to said conversion circuit, and

said conversion circuit being given the local signal level and demodulating an In-phase component signal I and a quadrature component signal Q based on the given local signal level, the output signal of said channel selecting means, and predetermined circuit constants.

**89.** A receiver as set forth in claim 87, comprising:

a channel selecting means for selecting a desired channel from the output signal of said subtractor and inputting the same to said conversion circuit and

a level measurement circuit for measuring and calculating the local signal level from the output signal of one power detector among said plurality of power detectors at the time of no reception of signal and holding the calculated local signal level, and

said conversion circuit demodulating an In-phase component signal I and a quadrature component signal Q based on the held local signal level, the output signal of said channel selecting means, and predetermined circuit constants.

**90.** A receiver as set forth in claim 86, comprising a removing means for removing the DC offset from the output of said subtractor.

**91.** A receiver as set forth in claim 90, wherein said removing means includes an offset removal subtractor connected to the latter stage of said subtractor and a circuit for measuring the DC offset amount from the output of said offset removal subtractor and feeding back a signal for canceling the DC offset amount to the offset removal subtractor.

**92.** A receiver as set forth in claim 90, wherein said removing means includes an offset removal subtractor connected to the latter stage of said subtractor and a circuit for taking an average of outputs of said offset removal subtractor and feeding back the average result to the offset removal subtractor as a signal for canceling the DC offset amount.

**93.** A receiver as set forth in claim 88, comprising a removing means for removing the DC offset from the output of said subtractor.

**94.** A receiver as set forth in claim 93, wherein said removing means includes an offset removal subtractor connected to the latter stage of said subtractor and a circuit for measuring the DC offset amount from the output of said offset removal subtractor and feeding back a signal for canceling the DC offset amount to the offset removal subtractor.

**95.** A receiver as set forth in claim 93, wherein said removing means includes an offset removal subtractor connected to the latter stage of said subtractor and a circuit for taking an average of outputs of said offset removal subtractor and feeding back the average result to the offset removal subtractor as a signal for canceling the DC offset amount.

**96.** A receiver comprising:

a demodulator having a multi-port junction circuit including a generating means receiving as input a received signal and a local signal and based on at least one signal, generating at least two signals having a phase difference, and a plurality of power detectors for detecting signal levels of signals generated by said generating means, at least one multiplier for multiplying an output signal of one power detector among said plurality of power detectors by a coefficient for canceling an unnecessary component included in the output signal of the other power detector, at least one subtractor for subtracting the output signal of said one power detector multiplied by a coefficient at said multiplier from the output signal of said other power detector, at least one variable gain amplifier for adjusting the level of the output signal of said subtractor with a gain in accordance with a control signal, an analog/digital converter for converting the output signal of said variable gain amplifier from an analog signal to a digital signal, and a conversion circuit for converting the result to a plurality of signal components included in the received signal based on the digital signal from said analog/digital converter and then outputting said control signal to said variable gain amplifier so as to adjust the level of the output signal of said subtractor to a level suitable for a dynamic range of the analog/digital converter;

a gain control circuit for adjusting the level of the received signal to a desired level and supplying the result to the generating means of said multi-port junction circuit; and

a local signal generation circuit for generating a local signal of the desired level at a desired oscillation frequency and supplying the same to the generating means of said multi-port junction circuit.

**97.** A receiver as set forth in claim 96, wherein said gain control circuit:

receives a gain control signal to be controlled in gain and
includes a gain control signal generation circuit for outputting said gain control signal to said gain control circuit so that the received signal level becomes a constant level based on the output signal of one power detector among said plurality of power detectors.

**98.** A receiver as set forth in claim 96, comprising a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**99.** A receiver as set forth in claim 97, comprising a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**100.** A receiver as set forth in claim 99, comprising a channel selecting means for selecting a desired channel from the output signal of said subtractor and inputting the same to said variable gain amplifier, and
said conversion circuit demodulating an In-phase component signal I and a quadrature component signal Q based on the output signal of said analog/digital converter and predetermined circuit constants.

**101.** A receiver as set forth in claim 96, comprising:

a variable circuit for adjusting the level of the local signal from said local signal generation circuit to a level in accordance with a level control signal and

a level control circuit for outputting said level control signal to said variable circuit so that said multi-port junction circuit becomes a level enabling operation at the optimum level in accordance with the received signal level obtained at said conversion circuit.

**102.** A receiver as set forth in claim 101, comprising:

a channel selecting means for selecting a desired channel from the output signal of said subtractor and inputting the same to said variable gain amplifier, and
said conversion circuit being given the local signal level and demodulating an In-phase component signal I and a quadrature component signal Q based on the given local signal level, the output signal of said analog/digital converter, and predetermined circuit constants.

**103.** A receiver as set forth in claim 101, comprising:

a channel selecting means for selecting a desired channel from the output signal of said subtractor and inputting the same to said conversion circuit and
a level measurement circuit for measuring and calculating the local signal level from the output signal of one power detector among said plurality of power detectors at the time of no reception of signal and holding the calculated local signal level, and
said conversion circuit demodulating an In-phase component signal I and a quadrature component signal Q based on the held local signal level, the output signal of said analog/digital converter, and predetermined circuit constants.

**104.** A receiver as set forth in claim 100, comprising a removing means for removing the DC offset from the output of said subtractor.

**105.** A receiver as set forth in claim 104, wherein said removing means includes an offset removal subtractor connected to the latter stage of said subtractor and a circuit for measuring the DC offset amount from the output of said offset removal subtractor and feeding back a signal for canceling the DC offset amount to the offset removal subtractor.

**106.** A receiver as set forth in claim 104, wherein said removing means includes an offset removal subtractor connected to the latter stage of said subtractor and a circuit for taking an average of outputs of said offset removal subtractor and feeding back the average result to the offset removal subtractor as a signal for canceling the DC offset amount.

**107.** A receiver as set forth in claim 102, comprising a removing means for removing the DC offset from the output of said subtractor.

**108.** A receiver as set forth in claim 107, wherein said removing means includes an offset removal subtractor connected to the latter stage of said subtractor and a circuit for measuring the DC offset amount from the output of said offset removal subtractor and feeding back a signal for canceling the DC offset amount to the offset removal subtractor.

**109.** A receiver as set forth in claim 107, wherein said removing means includes an offset removal subtractor connected to the latter stage of said subtractor and a circuit for taking an average of outputs of said offset removal subtractor and feeding back the average result to the offset removal subtractor as a signal for canceling the DC offset amount.

**110.** A receiver as set forth in claim 100, wherein said conversion circuit outputs the control signal to said variable gain amplifier and calibrates the gain of the variable gain amplifier so that the digital signal from said analog/digital converter becomes the desired level at the time of no reception of signal.

**111.** A receiver as set forth in claim 102, wherein said conversion circuit outputs the control signal to said variable gain amplifier and calibrates the gain of the variable gain amplifier so that the digital signal from said analog/digital converter becomes the desired level at the time of no reception of signal.

**112.** A receiver as set forth in claim 103, wherein said conversion circuit outputs the control signal to said variable gain amplifier and calibrates the gain of the variable gain amplifier so that the digital signal from said analog/digital converter becomes the desired level at the time of no reception of signal.

**113.** A receiver comprising:

a demodulator having a multi-port junction circuit including a generating means receiving as input a received signal and a local signal and based on at least one signal, generating at least two signals having a phase difference, and a plurality of power detectors for detecting signal levels of signals generated by said generating means, a plurality of variable gain amplifiers for adjusting levels of the output signals of said plurality of power detectors with a gain in accordance with a control signal, a plurality of analog/digital converters for converting the output signals of said plurality of variable gain amplifiers from analog signals to digital signals, at least one multiplier for multiplying the output signal of one power detector among said plurality of power detectors converted to a digital signal by said analog/digital converter by a coefficient for canceling an unnecessary component included in the output signal of the other power detector, at least one subtractor for subtracting the output signal of said one power detector multiplied by a coefficient at said multiplier from the output signal of said other power detector converted to a digital signal by said analog/digital converter, and a conversion circuit for converting the result to a plurality of signal components included in the received signal based on the digital signal from said subtractor and then outputting said control signal to said variable gain amplifier so as to adjust the level of the output signal of said power detector to a level suitable for the dynamic range of said analog/digital converter;
a gain control circuit for adjusting the level of the received signal to a desired level and supplying the same to the generating means of said multi-port junction circuit; and
a local signal generation circuit for generating a local signal of a desired level at a desired oscillation frequency and supplying the same to the generating means of said multi-port junction circuit.

**114.** A receiver as set forth in claim 113, wherein said gain control circuit:

receives a gain control signal to be controlled in gain and
includes a gain control signal generation circuit for outputting said gain control signal to said gain control circuit so that the received signal level becomes constant based on the output signal of one power detector among said plurality of power detectors.

**115.** A receiver as set forth in claim 113, comprising:

a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**116.** A receiver as set forth in claim 114, comprising:

a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**117.** A receiver as set forth in claim 116, comprising:

a channel selecting means for selecting a desired channel from the output signal of said subtractor and inputting the same to said conversion circuit, and
said conversion circuit demodulating an In-phase component signal I and a quadrature component signal Q based on the output signal of said channel selecting means and predetermined circuit constants.

**118.** A receiver as set forth in claim 113, comprising:

a variable circuit for adjusting the level of the local signal by said local signal generation circuit to a level in accordance with a level control signal and
a level control circuit for outputting said level control signal to said variable circuit so that said multi-port junction circuit becomes a level enabling operation at the optimum level in accordance with the received signal level obtained at said conversion circuit.

**119.** A receiver as set forth in claim 118, comprising:

a channel selecting means for selecting a desired channel from the output signal of said subtractor and inputting the same to said conversion circuit, and
said conversion circuit being given the local signal level and demodulating an In-phase component signal I and a quadrature component signal Q based on the given local signal level, the output signal of said channel selecting means, and predetermined circuit constants.

**120.** A receiver as set forth in claim 118, comprising:

a channel selecting means for selecting a desired channel from the output signal of said subtractor and inputting the same to said conversion circuit and
a level measurement circuit for measuring and calculating the local signal level from the output signal of one power detector among said plurality of power detectors at the time of no reception of signal and holding the calculated local signal level, and
said conversion circuit demodulating an In-phase component signal I and a quadrature component signal Q based on the held local signal level, the output signal of said channel selecting means, and predetermined circuit constants.

**121.** A receiver as set forth in claim 117, comprising a removing means for removing the DC offset from the output of said subtractor.

**122.** A receiver as set forth in claim 121, wherein said removing means includes an offset removal subtractor connected to the latter stage of said subtractor and a circuit for measuring the DC offset amount from the output of said offset removal subtractor and feeding back a signal for canceling the DC offset amount to the offset removal subtractor.

**123.** A receiver as set forth in claim 121, wherein said removing means includes an offset removal subtractor connected to the latter stage of said subtractor and a circuit for taking an average of outputs of said offset removal subtractor and feeding back the average result to the offset removal subtractor as a signal for canceling the DC offset amount.

**124.** A receiver as set forth in claim 119, comprising a removing means for removing the DC offset from the output of said subtractor.

**125.** A receiver as set forth in claim 124, wherein said removing means includes an offset removal subtractor connected to the latter stage of said subtractor and a circuit for measuring the DC offset amount from the output of said offset removal subtractor and feeding back a signal for canceling the DC offset amount to the offset removal subtractor.

**126.** A receiver as set forth in claim 124, wherein said removing means includes an offset removal subtractor connected to the latter stage of said subtractor and a circuit for taking an average of outputs of said offset removal subtractor and feeding back the average result to the offset removal subtractor as a signal for canceling the DC offset amount.

**127.** A receiver as set forth in claim 117, wherein said conversion circuit outputs the control signal to said variable gain amplifiers and calibrates the gains of the variable gain amplifiers so that the digital signal from said analog/ digital converter become a desired level at the time of no reception of signal.

**128.** A receiver as set forth in claim 119, wherein said conversion circuit outputs the control signal to said variable gain amplifiers and calibrates the gains of the variable gain amplifiers so that the digital signal from said analog/ digital converter become a desired level at the time of no reception of signal.

**129.** A receiver as set forth in claim 120, wherein said conversion circuit outputs the control signal to said variable gain amplifier and calibrates the gain of the variable gain amplifier so that the digital signal from said analog/digital converter become a desired level at the time of not receiving a signal.

**130.** A receiver comprising:

a demodulator having a multi-port junction circuit including a generating means receiving as input a received signal and a local signal and based on at least one signal, generating a first signal, a second signal, and a third signal having a phase difference, a first power detector for detecting a signal level of the first signal generated by said generating means and outputting a first power detection signal, a second power detector for detecting the signal level of said second signal and outputting a second power detection signal, and a third power detector for detecting the signal level of said third signal and outputting a third power detection signal, a first multiplier for multiplying the first power detection signal from said first power detector by a coefficient for canceling an unnecessary component included in the second power detection signal from said second power detector, a second multiplier for multiplying the first power detection signal from said first power detector by a coefficient for canceling an unnecessary component included in the third power detection signal from said third power detector, a first subtractor for subtracting the first power detection signal from said first power detector multiplied by a coefficient at said first multiplier from the second power detection signal from said second power detector, a second subtractor for subtracting the first power detection signal from said first power detector multiplied by a coefficient at said second multiplier from the third power detection signal from said third power detector, and a conversion circuit for converting the result to a plurality of signal components included in the received signal based on the output signals of said first and second subtractors;
a gain control circuit for adjusting the level of the received signal to a desired level and supplying the same to the generating means of said multi-port junction circuit; and
a local signal generation circuit for generating a local signal of a desired level at a desired oscillation frequency and supplying the same to the generating means of said multi-port junction circuit.

**131.** A receiver as set forth in claim 130, wherein said gain control circuit:

receives a gain control signal to be controlled in gain and
includes a gain control signal generation circuit for outputting said gain control signal to said gain control circuit so that the received signal level becomes constant based on the output signal of one power detector among said plurality of power detectors.

**132.** A receiver as set forth in claim 130, comprising:

a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**133.** A receiver as set forth in claim 131, comprising:

a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**134.** A receiver as set forth in claim 133, comprising:

a first channel selecting means for selecting a desired channel from the output signal of said first subtractor and inputting the same to said conversion circuit and
a second channel selecting means for selecting a desired channel from the output signal of said second subtractor and inputting the same to said conversion circuit, and
said conversion circuit demodulating an In-phase component signal I and a quadrature component signal Q based on the output signals of said first and second channel selecting means and predetermined circuit constants.

**135.** A receiver as set forth in claim 134, wherein said conversion circuit obtains an In-phase component signal I and a quadrature component signal Q by computations based on the following equations:

$$I = \alpha_1 x_1 + \beta_1 x_2 + \gamma_1$$

$$Q = \alpha_2 x_1 + \beta_2 x_2 + \gamma_2$$

where, $x_1$ is the output signal of the first channel selecting means, $x_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**136.** A receiver as set forth in claim 130, comprising:

a variable circuit for adjusting the level of the local signal by said local signal generation circuit to a level in accordance with a level control signal and
a level control circuit for outputting said level control signal to said variable circuit so that said multi-port junction circuit becomes a level enabling operation at the optimum level in accordance with the received signal level obtained at said conversion circuit.

**137.** A receiver as set forth in claim 136, comprising:

a first channel selecting means for selecting the desired channel from the output signal of said first subtractor and inputting the same to said conversion circuit and
a second channel selecting means for selecting the desired channel from the output signal of said second subtractor and inputting the same to said conversion circuit, and

said conversion circuit being given the local signal level and demodulating an In-phase component signal I and a quadrature component signal Q based on the given local signal level, the output signals of said first and second channel selecting means, and predetermined circuit constants.

**138.** A receiver as set forth in claim 137, wherein said conversion circuit obtains an In-phase component signal I and a quadrature component signal Q by computations based on the following equations:

$$I = a_1 x_1 / P_{LO} + b_1 x_2 / P_{LO} + \gamma_1$$

$$Q = a_2x_1/P_{LO}+b_2x_2/P_{LO}+\gamma_2$$

where, $x_1$ is the output signal of the first channel selecting means, $x_2$ is the output signal of the second channel selecting means, $P_{LO}$ is the local signal level, and $a_1$, $a_2$, $b_1$, $b_2$, $\gamma_1$, and $\gamma_2$ are circuit constants found from circuit elements of the demodulator.

**139.** A receiver as set forth in claim 136, comprising:

a first channel selecting means for selecting the desired channel from the output signal of said first subtractor and inputting the same to said conversion circuit,
a second channel selecting means for selecting the desired channel from the output signal of said second subtractor and inputting the same to said conversion circuit, and
a level measurement circuit for measuring and calculating the local signal level from the output signal of one power detector among said plurality of power detectors at the time of no reception of signal and holding the calculated local signal level, and

said conversion circuit demodulating an In-phase component signal I and a quadrature component signal Q based on the held local signal level, the output signals of said first and second channel selecting means, and predetermined circuit constants.

**140.** A receiver as set forth in claim 139, wherein said conversion circuit obtains an In-phase component signal I and a quadrature component signal Q by computations based on the following equations:

$$I = a_1x_1/P_{LO}+b_1x_2/P_{LO}+\gamma_1$$

$$Q = a_2x_1/P_{LO}+b_2x_2/P_{LO}+\gamma_2$$

where, $x_1$ is the output signal of the first channel selecting means, $x_2$ is the output signal of the second channel selecting means, $P_{LO}$ is the local signal level, and $a_1$, $a_2$, $b_1$, $b_2$, $\gamma_1$, and $\gamma_2$ are circuit constants found from circuit elements of the demodulator.

**141.** A receiver as set forth in claim 134, comprising a removing means for removing the DC offset from the output of said subtractor.

**142.** A receiver as set forth in claim 141, wherein said removing means includes offset removal subtractors connected to the latter stage of said subtractors and a circuit for measuring the DC offset amount from the outputs of said offset removal subtractors and feeding back a signal for canceling the DC offset amount to the offset removal subtractors.

**143.** A receiver as set forth in claim 141, wherein said removing means includes offset removal subtractors connected to the latter stage of said subtractors and a circuit for taking averages of outputs of said offset removal subtractors and feeding back the average results to the offset removal subtractors as a signal for canceling the DC offset amount.

**144.** A receiver as set forth in claim 137, comprising a removing means for removing the DC offset from the output of said subtractor.

**145.** A receiver as set forth in claim 144, wherein said removing means includes offset removal subtractors connected to the latter stage of said subtractors and a circuit for measuring the DC offset amount from the outputs of said offset removal subtractors and feeding back a signal for canceling the DC offset amount to the offset removal subtractors.

**146.** A receiver as set forth in claim 144, wherein said removing means includes offset removal subtractors connected to the latter stage of said subtractors and a circuit for taking averages of outputs of said offset removal subtractors and feeding back the average results to the offset removal subtractors as a signal for canceling the DC offset amount.

**147.** A receiver comprising:

a demodulator having a multi-port junction circuit including a generating means receiving as input a received signal and a local signal and based on at least one signal, generating a first signal, a second signal, and a third signal having a phase difference, a first power detector for detecting a signal level of the first signal generated by said generating means and outputting a first power detection signal, a second power detector for detecting the signal level of said second signal and outputting a second power detection signal, and a third power detector for detecting the signal level of said third signal and outputting a third power detection signal, a first multiplier for multiplying the first power detection signal from said first power detector by a coefficient for canceling an unnecessary component included in the second power detection signal from said second power detector, a second multiplier for multiplying the first power detection signal from said first power detector by a coefficient for canceling an unnecessary component included in the third power detection signal from said third power detector, a first subtractor for subtracting the first power detection signal from said first power detector multiplied by a coefficient at said first multiplier from the second power detection signal from said second power detector, a second subtractor for subtracting the first power detection signal from said first power detector multiplied by a coefficient at said second multiplier from the third power detection signal from said third power detector, a first variable gain amplifier for adjusting the level of the output signal of said first subtractor with a gain in accordance with a control signal, a second variable gain amplifier for adjusting the level of the output signal of said second subtractor with a gain in accordance with a control signal, a first analog/digital converter for converting the output signal of said first variable gain amplifier from an analog signal to a digital signal, a second analog/digital converter for converting the output signal of said second variable gain amplifier from an analog signal to a digital signal, and a conversion circuit for converting the result to a plurality of signal components included in the received signal based on the digital signals from said first and second analog/digital converters and then outputting said control signal to said first and second variable gain amplifiers so as to adjust the levels of the output signals of said first and second subtractors to levels suitable for the dynamic range of said first and second analog/digital converters;
a gain control circuit for adjusting the level of the received signal to a desired level and supplying the result to the generating means of said multi-port junction circuit; and
a local signal generation circuit for generating a local signal of a desired level at a desired oscillation frequency and supplying the same to the generating means of said multi-port junction circuit.

**148.** A receiver as set forth in claim 147, wherein said gain control circuit:

receives a gain control signal to be controlled in gain and
includes a gain control signal generation circuit for outputting said gain control signal to said gain control circuit so that the received signal level becomes constant based on the output signal of one power detector among said plurality of power detectors.

**149.** A receiver as set forth in claim 147, comprising:

a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**150.** A receiver as set forth in claim 148, comprising:

a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**151.** A receiver as set forth in claim 150, comprising:

a first channel selecting means for selecting a desired channel from the output signal of said first subtractor and inputting the same to said first variable gain amplifier and

a second channel selecting means for selecting a desired channel from the output signal of said second subtractor and inputting the same to said second variable gain amplifier, and
said conversion circuit demodulating an In-phase component signal I and a quadrature component signal Q based on the output signals of said first and second analog/digital converters and predetermined circuit constants.

**152.** A receiver as set forth in claim 151, wherein said conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**153.** A receiver as set forth in claim 147, comprising:

a variable circuit for adjusting the level of the local signal by said local signal generation circuit to a level in accordance with a level control signal and
a level control circuit for outputting said level control signal to said variable circuit so that said multi-port junction circuit becomes a level enabling operation at the optimum level in accordance with the received signal level obtained at said conversion circuit.

**153.** A receiver as set forth in claim 152, comprising:

a first channel selecting means for selecting the desired channel from the output signal of said first subtractor and inputting the same to said first variable gain amplifier and
a second channel selecting means for selecting the desired channel from the output signal of said second subtractor and inputting the same to said second variable gain amplifier, and

said conversion circuit being given the local signal level and demodulating an In-phase component signal I and a quadrature component signal Q based on the given local signal level, the output signals of said first and second analog/digital converters, and predetermined circuit constants.

**154.** A receiver as set forth in claim 153, wherein said conversion circuit obtains an In-phase component signal I and a quadrature component signal Q by computations based on the following equations:

$$I = a_1 X_1 / P_{LO} + b_1 X_2 / P_{LO} + \gamma_1$$

$$Q = a_2 X_1 / P_{LO} + b_2 X_2 / P_{LO} + \gamma_2$$

where, $X_1$ is the output signal of the first analog/digital converter, $X_2$ is the output signal of the second analog/digital converter, $P_{LO}$ is the local signal level, and $a_1$, $a_2$, $b_1$, $b_2$, $\gamma_1$, and $\gamma_2$ are circuit constants found from circuit elements of the demodulator.

**155.** A receiver as set forth in claim 152; comprising:

a first channel selecting means for selecting the desired channel from the output signal of said first subtractor and inputting the same to said first variable gain amplifier,
a second channel selecting means for selecting the desired channel from the output signal of said second subtractor and inputting the same to said second variable gain amplifier, and
a level measurement circuit for measuring and calculating the local signal level from the output signal of one power detector among said plurality of power detectors at the time of no reception of signal and holding the calculated local signal level, and

said conversion circuit demodulating an In-phase component signal I and a quadrature component signal Q based on the held local signal level, the output signals of said first and second analog/digital converters, and predetermined circuit constants.

**156.** A receiver as set forth in claim 155, wherein said conversion circuit obtains an In-phase component signal I and a quadrature component signal Q by computation based on the following equations:

$$I = a_1X_1/P_{LO} + b_1X_2/P_{LO} + \gamma_1$$

$$Q = a_2X_1/P_{LO} + b_2X_2/P_{LO} + \gamma_2$$

where, $X_1$ is the output signal of the first analog/digital converter, $X_2$ is the output signal of the second analog/digital converter, $P_{LO}$ is the local signal level, and $a_1$, $a_2$, $b_1$, $b_2$, $\gamma_1$, and $\gamma_2$ are circuit constants found from circuit elements of the demodulator.

**157.** A receiver as set forth in claim 151, comprising a removing means for removing the DC offset from the output of said subtractor.

**158.** A receiver as set forth in claim 157, wherein said removing means includes offset removal subtractors connected to the latter stage of said subtractors and a circuit for measuring the DC offset amount from the outputs of said offset removal subtractors and feeding back a signal for canceling the DC offset amount to the offset removal subtractors.

**159.** A receiver as set forth in claim 157, wherein said removing means includes offset removal subtractors connected to the latter stage of said subtractors and a circuit for taking averages of outputs of said offset removal subtractors and feeding back the average results to the offset removal subtractor as a signal for canceling the DC offset amount.

**160.** A receiver as set forth in claim 153, comprising a removing means for removing the DC offset from the output of said subtractor.

**161.** A receiver as set forth in claim 160, wherein said removing means includes offset removal subtractors connected to the latter stage of said subtractors and a circuit for measuring the DC offset amount from the outputs of said offset removal subtractors and feeding back a signal for canceling the DC offset amount to the offset removal subtractors.

**162.** A receiver as set forth in claim 160, wherein said removing means includes offset removal subtractors connected to the latter stage of said subtractors and a circuit for taking averages of outputs of said offset removal subtractors and feeding back the average results to the offset removal subtractors as a signal for canceling the DC offset amount.

**163.** A receiver as set forth in claim 152, wherein said conversion circuit outputs a control signal to said variable gain amplifiers and calibrates the gains of the variable gain amplifiers so that the digital signals from said first and second analog/digital converters become levels obtained from the following equations:

$$X_1 = (-\gamma_1\beta_1 + \beta_2\gamma_2) / (\alpha_1\beta_2 - \alpha_2\beta_1)$$

$$X_2 = (\gamma_1\alpha_2 - \alpha_1\gamma_2) / (\alpha_1\beta_2 - \alpha_2\beta_1)$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**164.** A receiver as set forth in claim 154, wherein said conversion circuit outputs a control signal to said variable gain amplifiers and calibrates the gains of the variable gain amplifiers so that the digital signals from said first and second analog/digital converters become levels obtained from the following equations:

$$X_1 = (-\gamma_1\beta_1+\beta_2\gamma_2) / (\alpha_1\beta_2-\alpha_2\beta_1)$$

$$X_2 = (\gamma_1\alpha_2-\alpha_1 \gamma_2) / (\alpha_1\beta_2-\alpha_2\beta_1)$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**165.** A receiver as set forth in claim 156, wherein said conversion circuit outputs a control signal to said variable gain amplifiers and calibrates the gains of the variable gain amplifiers so that the digital signals from said first and second analog/digital converters become levels obtained from the following equations:

$$X_1 = (-\gamma_1\beta_1+\beta_2\gamma_2) / (\alpha_1\beta_2-\alpha_2\beta_1)$$

$$X_2 = (\gamma_1\alpha_2-\alpha_1\gamma_2) / (\alpha_1\beta_2-\alpha_2\beta_1)$$

where, $X_1$ is the output signal of the first analog/digital converter, $X_2$ is the output signal of the second analog/digital converter, and $\alpha_1$, $\alpha_2$, $\beta_1$, $\beta_2$, $\gamma_1$, and $\gamma_2$ are circuit constants found from circuit elements of the demodulator.

**166.** A receiver comprising:

a demodulator having a multi-port junction circuit including a generating means receiving as input a received signal and a local signal and based on at least one signal, generating a first signal, a second signal, and a third signal having a phase difference, a first power detector for detecting a signal level of the first signal generated by said generating means and outputting a first power detection signal, a second power detector for detecting the signal level of said second signal and outputting a second power detection signal, and a third power detector for detecting the signal level of said third signal and outputting a third power detection signal, a first variable gain amplifier for adjusting the level of the first power detection signal from said first power detector with a gain in accordance with a control signal, a second variable gain amplifier for adjusting the level of the second power detection signal from said second power detector with a gain in accordance with a control signal, a third variable gain amplifier for adjusting the level of the third power detection signal from said third power detector with a gain in accordance with a control signal, a first analog/digital converter for converting the output signal of said first variable gain amplifier from an analog signal to a digital signal, a second analog/digital converter for converting the output signal of said second variable gain amplifier from an analog signal to a digital signal, a third analog/digital converter for converting the output signal of said third variable gain amplifier from an analog signal to a digital signal, a first multiplier for multiplying the first power detection signal from said first power detector converted to a digital signal at said first analog/digital converter by a coefficient for canceling an unnecessary component included in the second power detection signal from said second power detector, a second multiplier for multiplying the first power detection signal from said first power detector converted to a digital signal at said first analog/digital converter by a coefficient for canceling an unnecessary component included in the third power detection signal from said third power detector, a first subtractor for subtracting the first power detection signal from said first power detector multiplied by a coefficient at said first multiplier from the second power detection signal from said second power detector converted to a digital signal at said second analog/digital converter, a second subtractor for subtracting the first power detection signal from said first power detector multiplied by a coefficient at said second multiplier from the third power detection signal from said third power detector converted to a digital signal at said third analog/digital converter, and a conversion circuit for converting the result to a plurality of signal components included in the received signal based on the digital signals from said first and second subtractors and then outputting said control signal to said second and third variable gain amplifiers so as to adjust the levels of the output signals of said second and third power detectors to levels suitable for the dynamic range of at least said second and third analog/digital converters;

a gain control circuit for adjusting the level of the received signal to a desired level and supplying the result to the generating means of said multi-port junction circuit; and
a local signal generation circuit for generating a local signal of a desired level at a desired oscillation frequency and supplying the same to the generating means of said multi-port junction circuit.

**167.** A receiver as set forth in claim 166, wherein said gain control circuit:

receives a gain control signal to be controlled in gain and
includes a gain control signal generation circuit for outputting said gain control signal to said gain control circuit so that the received signal level becomes constant based on the output signal of one power detector among said plurality of power detectors.

**168.** A receiver as set forth in claim 166, comprising:

a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**169.** A receiver as set forth in claim 167, comprising:

a carrier reproduction circuit for reproducing a carrier based on a plurality of signal components obtained at said conversion circuit and outputting a reproduced signal, and
said local signal generation circuit receiving said reproduced signal and setting an oscillation frequency of the local signal so as to become a frequency substantially equal to the carrier frequency of the received signal.

**170.** A receiver as set forth in claim 169, comprising:

a first channel selecting means for selecting a desired channel from the output signal of said first subtractor and inputting the same to said conversion circuit and
a second channel selecting means for selecting a desired channel from the output signal of said second subtractor and inputting the same to said conversion circuit, and

said conversion circuit demodulating an In-phase component signal I and a quadrature component signal Q based on the output signals of said first and second channel selecting means and predetermined circuit constants.

**171.** A receiver as set forth in claim 170, wherein said conversion circuit obtains an In-phase component signal I and a quadrature component signal Q by computations based on the following equations:

$$I = \alpha_1 X_1 + \beta_1 X_2 + \gamma_1$$

$$Q = \alpha_2 X_1 + \beta_2 X_2 + \gamma_2$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**172.** A receiver as set forth in claim 166, comprising:

a variable circuit for adjusting the level of the local signal by said local signal generation circuit to a level in accordance with a level control signal and
a level control circuit for outputting said level control signal to said variable circuit so that said multi-port junction circuit becomes a level enabling operation at the optimum level in accordance with the received signal level obtained at said conversion circuit.

**173.** A receiver as set forth in claim 172, comprising:

a first channel selecting means for selecting the desired channel from the output signal of said first subtractor and inputting the same to said conversion circuit and

a second channel selecting means for selecting the desired channel from the output signal of said second subtractor and inputting the same to said conversion circuit, and

said conversion circuit being given the local signal level and demodulating an In-phase component signal I and a quadrature component signal Q based on the given local signal level, the output signals of said first and second channel selecting means, and predetermined circuit constants.

**174.** A receiver as set forth in claim 173, wherein said conversion circuit obtains an In-phase component signal I and a quadrature component signal Q by computations based on the following equations:

$$I = a_1 X_1/P_{LO} + b_1 X_2/P_{LO} + \gamma_1$$

$$Q = a_2 X_1/P_{LO} + b_2 X_2/P_{LO} + \gamma_2$$

where, $X_1$ is the output signal of the first channel selecting means, $X_2$ is the output signal of the second channel selecting means, $P_{LO}$ is the local signal level, and $a_1$, $a_2$, $b_1$, $b_2$, $\gamma_1$, and $\gamma_2$ are circuit constants found from circuit elements of the demodulator.

**175.** A receiver as set forth in claim 172, comprising:

a first channel selecting means for selecting the desired channel from the output signal of said first subtracter and inputting the same to said conversion circuit,

a second channel selecting means for selecting the desired channel from the output signal of said second subtractor and inputting the same to said conversion circuit, and

a level measurement circuit for measuring and calculating the local signal level from the output signal of one power detector among said plurality of power detectors at the time of no reception of signal and holding the calculated local signal level, and

said conversion circuit demodulating an In-phase component signal I and a quadrature component signal Q based on the held local signal level, the output signals of said first and second channel selecting means, and predetermined circuit constants.

**176.** A receiver as set forth in claim 175, wherein said conversion circuit obtains an In-phase component signal I and a quadrature component signal Q by computations based on the following equations:

$$I = a_1 X_1/P_{LO} + b_1 X_2/P_{LO} + \gamma_1$$

$$Q = a_2 X_1/P_{LO} + b_2 X_2/P_{LO} + \gamma_2$$

where, $X_1$ is the output signal of the first channel selecting means, $X_2$ is the output signal of the second channel selecting means, $P_{LO}$ is the local signal level, and $a_1$, $a_2$, $b_1$, $b_2$, $\gamma_1$, and $\gamma_2$ are circuit constants found from circuit elements of the demodulator.

**177.** A receiver as set forth in claim 170, comprising a removing means for removing the DC offset from the output of said subtractor.

**178.** A receiver as set forth in claim 177, wherein said removing means includes offset removal subtractors connected to the latter stage of said subtractors and a circuit for measuring the DC offset amount from the outputs of said offset removal subtractors and feeding back a signal for canceling the DC offset amount to the offset removal subtractors.

**179.** A receiver as set forth in claim 177, wherein said removing means includes offset removal subtractors connected to the latter stage of said subtractors and a circuit for taking averages of outputs of said offset removal subtractors and feeding back the average results to the offset removal subtractors as a signal for canceling the DC offset amount.

**180.** A receiver as set forth in claim 173, comprising a removing means for removing the DC offset from the output of said subtractor.

**181.** A receiver as set forth in claim 180, wherein said removing means includes offset removal subtractors connected to the latter stage of said subtractors and a circuit for measuring the DC offset amount from the outputs of said offset removal subtractors and feeding back a signal for canceling the DC offset amount to the offset removal subtractors.

**182.** A receiver as set forth in claim 180, wherein said removing means includes offset removal subtractors connected to the latter stage of said subtractors and a circuit for taking averages of outputs of said offset removal subtractors and feeding back the average results to the offset removal subtractors as a signal for canceling the DC offset amount.

**183.** A receiver as set forth in claim 171, wherein said conversion circuit outputs the control signal to said variable gain amplifiers and calibrates the gains of the variable gain amplifiers so that the digital signals from said first and second channel selecting means become levels obtained from the following equations:

$$X_1 = (-\gamma_1\beta_1 + \beta_2\gamma_2) / (\alpha_1\beta_2 - \alpha_2\beta_1)$$

$$X_2 = (\gamma_1\alpha_2 - \alpha_1\gamma_2) / (\alpha_1\beta_2 - \alpha_2\beta_1)$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**184.** A receiver as set forth in claim 174, wherein said conversion circuit outputs the control signal to said variable gain amplifiers and calibrates the gains of the variable gain amplifiers so that the digital signals from said first and second channel selecting means become levels obtained from the following equations:

$$X_1 = (-\gamma_1\beta_1 + \beta_2\gamma_2) / (\alpha_1\beta_2 - \alpha_2\beta_1)$$

$$X_2 = (\gamma_1\alpha_2 - \alpha_1\gamma_2) / (\alpha_1\beta_2 - \alpha_2\beta_1)$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

**185.** A receiver as set forth in claim 176, wherein said conversion circuit outputs the control signal to said variable gain amplifiers and calibrates the gains of the variable gain amplifiers so that the digital signals from said first and second channel selecting means become levels obtained from the following equations:

$$X_1 = (-\gamma_1\beta_1 + \beta_2\gamma_2) / (\alpha_1\beta_2 - \alpha_2\beta_1)$$

$$X_2 = (\gamma_1\alpha_2 - \alpha_1\gamma_2) / (\alpha_1\beta_2 - \alpha_2\beta_1)$$

where, $X_1$ is the output signal of the first channel selecting means, $X_2$ is the output signal of the second channel selecting means, and $\alpha_1$, $\alpha_2$, $\beta_1$, $\beta_2$, $\gamma_1$, and $\gamma_2$ are circuit constants found from circuit elements of the demodulator.

# FIG.1

# FIG.2

EP 1 450 481 A1

# FIG.3

100

# FIG.4

RECEIVED SIGNAL
Sr
$T_{INSr}$

101

1001 — BRANCH CIRCUIT |1
01    02    03

1002    1004

LOCAL SIGNAL
Slo
$T_{INSlo}$

|1 BRANCH CIRCUIT
02    01

1003

θ2    1006

θ1    1005

1008    1009

1007 — PD1    PD2    PD3

P1    P2    P3

EP 1 450 481 A1

# FIG.5

# FIG.6

# FIG.7

# FIG.8

# FIG.9

# FIG.10

# FIG.11

# FIG.12

# FIG.13

1003a
(1004a)

L106

a —○—————————〜〜〜—————————○— b

C108 〜 ⊣⊢        ⊣⊢ 〜 C109

GND        GND

# FIG.14

1003b
(1004b)        10031

a ○—[ TRANSMISSION LINE ]—○ b

# FIG.15

1003c (1004c)

a —○———〜〜〜———●———○— b

R111        ⊣⊢ 〜 C110

GND

# FIG.16

1005a (1006a)

# FIG.17

## 200

EP 1 450 481 A1

# FIG.18

# FIG.19

## FIG.20

EP 1 450 481 A1

## FIG.21

200

# FIG.22

RECEIVED SIGNAL
Sr
TINSr

203

1010 — BRANCH CIRCUIT I1
02    01

1011 — BRANCH CIRCUIT I1
02    01

1002    1004

LOCAL SIGNAL
Slo

I1 BRANCH CIRCUIT
02    01

TINSlo

θ2    1006

θ1    1005

1003

1009    1008    1007

PD3    PD2    PD1

P3    P2    P1

EP 1 450 481 A1

# FIG.23

200A

RF AGC

RFin

201  202  203 FIVE-PORT JUNCTION

P1  205
P2  206
P3  207

208 A1  209 A2

210

211

212

213

218  223 ADC x0

219  221 ADC x1

220  222 ADC x2

BB AGC

224 DAC

215A AGC

214A N-PORT SIGNAL-TO-IQ SIGNAL CONVERSION CIRCUIT

225 DAC  216A DC OFFSET REMOVAL CIRCUIT  217A

CARRIER REPRODUCTION CIRCUIT

SLO

204

EP 1 450 481 A1

FIG.24

**FIG.25**

200C

EP 1 450 481 A1

82

# FIG.26

| INTERNATIONAL SEARCH REPORT | International application No. |
|---|---|
| | PCT/JP01/10471 |

**A. CLASSIFICATION OF SUBJECT MATTER**

Int.Cl$^7$   H03D 9/00
Int.Cl$^7$   H03D 5/00
Int.Cl$^7$   H04B 1/30

According to International Patent Classification (IPC) or to both national classification and IPC

**B. FIELDS SEARCHED**

Minimum documentation searched (classification system followed by classification symbols)

Int.Cl$^7$   H03D 9/00
Int.Cl$^7$   H03D 5/00
Int.Cl$^7$   H04L 27/38

Documentation searched other than minimum documentation to the extent that such documents are included in the fields searched

| Jitsuyo Shinan Koho | 1922-1996 | Toroku Jitsuyo Shinan Koho | 1994-2001 |
| Kokai Jitsuyo Shinan Koho | 1971-2001 | Jitsuyo Shinan Toroku Koho | 1996-2001 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2000-183994 A (Sony Corporation), 30 June, 2000 (30.06.2000), Full text; all drawings & EP 926812 A1   & AU 2274899 A & EP 957614 A1 | 1-185 |
| A | JP 2000-196693 A (Sony Corporation), 14 July, 2000 (14.07.2000), Full text; all drawings & EP 1011204 | 1-185 |
| A | JP 2001-16288 A (Sony International (Europe) GmbH), 19 January, 2001 (19.01.2001), Full text; all drawings & EP 1056193 A1   & CA 2306072 A1 & CN 1275833 A | 1-185 |
| A | JP 2001-60982 A (Sony Corporation), 06 March, 2001 (06.03.2001), Full text; all drawings   (Family: none) | 1-185 |

☒ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 February, 2002 (14.02.02) | 26 February, 2002 (26.02.02) |

| Name and mailing address of the ISA/ | Authorized officer |
|---|---|
| Japanese Patent Office | |
| Facsimile No. | Telephone No. |

Form PCT/ISA/210 (second sheet) (July 1992)

**EP 1 450 481 A1**

## INTERNATIONAL SEARCH REPORT

International application No.

PCT/JP01/10471

C (Continuation).　DOCUMENTS CONSIDERED TO BE RELEVANT

| Category* | Citation of document, with indication, where appropriate, of the relevant passages | Relevant to claim No. |
|---|---|---|
| A | JP 10-247953 A (Mitsubishi Electric Corporation), 14 September, 1998 (14.09.1998), Full text; all drawings　(Family: none) | 1-185 |
| A | JP 10-56394 A (Nokia Mobile Phones Ltd.), 24 February, 1998 (24.02.1998), Full text; all drawings & EP 806841 A1　　　& US 6115593 A1 | 1-185 |

Form PCT/ISA/210 (continuation of second sheet) (July 1992)